# EUROPEAN PATENT APPLICATION

(11) **EP 4 769 827 A1**
(43) Date of publication of application: **01.07.2026**
(21) Application number: 25804567.3
(22) Date of filing: 17.10.2025
(51) Int. Cl.: H01Q 1/24, H01Q 1/38, H01Q 5/335, H05K 1/02, H05K 1/14

(54) **ELECTRONIC DEVICE COMPRISING ANTENNA**

(30) Priority: 20.10.2024 KR 20240143526; 07.01.2025 KR 20250002502
(71) Applicant: Samsung Electronics Co., Ltd, Suwon-si, Gyeonggi-do 16677 (KR)
(72) Inventor: KIM, Jiho, Suwon-si Gyeonggi-do 16677 (KR); KIM, Sewoong, Suwon-si Gyeonggi-do 16677 (KR); HWANG, Soonho, Suwon-si Gyeonggi-do 16677 (KR); LEE, Woosung, Suwon-si Gyeonggi-do 16677 (KR); PARK, Sungkoo, Suwon-si Gyeonggi-do 16677 (KR); KANG, Hyeonuk, Suwon-si Gyeonggi-do 16677 (KR)
(74) Representative: Gulde & Partner
(86) International application number: PCT/KR2025/016535
(87) International publication number: WO 2026/084535

(57) **Abstract**

In embodiments of the present disclosure, an electronic device may be provided. The electronic device may comprise a conductive portion forming at least a portion of a side of the electronic device; wireless communication circuitry; a printed circuit board (PCB) including a plurality of layers, on which the wireless communication circuitry is disposed; a radio frequency (RF) line structure disposed in the PCB and electrically connected to the wireless communication circuitry; and a contact member disposed on the PCB to electrically connect the RF line structure and the conductive portion. The RF line structure may include a first conductive line disposed on a first layer of the plurality of layers of the PCB, a second conductive line disposed on a second layer of the plurality of layers of the PCB, a first conductive via penetrating between the first layer and the second layer and coupled to a first portion of the first conductive line and a second portion of the second conductive line, and a second conductive via penetrating between the first layer and the second layer and coupled to a third portion of the first conductive line and a fourth portion of the second conductive line.

## Description

### [Technical Field]

The present disclosure relates to an electronic device including an antenna.

### [Background Art]

The electronic device may transmit a signal through an antenna or receive a signal through an antenna. For example, the electronic device may include a conductive portion. The conductive portion may operate as a radiator of an antenna for transmitting and/or receiving a signal.

The above-described information may be provided as a related art for the purpose of helping understanding of the present disclosure. No argument or decision is made as to whether any of the above description may be applied as a prior art related to the present disclosure.

### [Disclosure]

### [Technical Solution]

In embodiments of the present disclosure, an electronic device may be provided. The electronic device may comprise a conductive portion forming at least a portion of a side of the electronic device; wireless communication circuitry; a printed circuit board (PCB) including a plurality of layers, on which the wireless communication circuitry is disposed; a radio frequency (RF) line structure disposed in the PCB and electrically connected to the wireless communication circuitry; and a contact member disposed on the PCB to electrically connect the RF line structure and the conductive portion. The RF line structure may include a first conductive line disposed on a first layer of the plurality of layers of the PCB, a second conductive line disposed on a second layer of the plurality of layers of the PCB, a first conductive via penetrating between the first layer and the second layer and coupled to a first portion of the first conductive line and a second portion of the second conductive line, and a second conductive via penetrating between the first layer and the second layer and coupled to a third portion of the first conductive line and a fourth portion of the second conductive line.

In embodiments of the present disclosure, an electronic device is provided. The electronic device may include: a conductive portion used as an antenna radiator for multiple frequency bands; a printed circuit board (PCB) including at least one insulating layer and a plurality of metal layers, wherein the PCB includes an RF line structure for transmitting an RF (radio frequency) signal to the conductive portion ; wireless communication circuitry disposed in a ground area where at least a portion of the plurality of metal layers of the PCB overlaps the at least one insulating layer; impedance matching circuitry disposed on the PCB and connected to the RF line structure ; and a contact member disposed on the PCB and electrically connecting the impedance matching circuitry and the conductive portion. The RF line structure may be disposed in an area of the PCB where only the RF line structure among the plurality of metal layers overlaps with the at least one insulating layer between the ground area and the conductive portion. The RF line structure may include a plurality of conductive lines disposed on the plurality of metal layers of the PCB ; and a plurality of conductive vias for connecting each of the conductive lines.

In embodiments of the present disclosure, an electronic device is provided. The electronic device may comprise a conductive portion, wireless communication circuitry, a printed circuit board (PCB) including a ground area for the wireless communication circuitry and a fill-cut area formed between the ground area and the conductive portion, a radio frequency (RF) line structure formed in the fill-cut area of the PCB and electrically connected to the wireless communication circuitry, and a contact member to electrically connect the RF line structure and the conductive portion. The RF line structure may include conductive lines including a conductive line disposed on each layer of at least two of multiple layers of the PCB, a first conductive via coupled to each of the conductive lines, and a second conductive via coupled to each of the conductive lines.

In embodiments of the present disclosure, an electronic device is provided. The electronic device may comprise a conductive portion used as an antenna radiator for multiple frequency bands, wireless communication circuitry, a printed circuit board (PCB) including a first area having ground for the wireless communication circuitry and a second area in which at least a portion of a metal layer is fill-cut between the first area and the conductive portion - the PCB including a radio frequency (RF) line structure formed in the second area to transmit an RF signal to the conductive portion - impedance matching circuitry disposed on the PCB and connected to the RF line structure, and a contact member disposed on the PCB to electrically connect the impedance matching circuitry and the conductive portion. The RF line structure may include conductive lines including conductive lines disposed in each layer of multiple layers of the PCB, and conductive vias to connect each of the conductive lines.

### [Description of the Drawings]

FIG. 1 is a block diagram of an electronic device in a network environment.
FIG. 2 illustrates an example of an electronic device including a conductive portion.
FIG. 3A illustrates an example of an electronic device including conductive lines disposed in multiple layers of a printed circuit board (PCB).
FIG. 3B illustrates an example of an electronic device including conductive lines disposed on multiple layers of a PCB.
FIGS. 4A and 4B illustrate an example of an antenna using a multilayer radio frequency (RF) line structure.
FIG. 4C illustrates an example of a multilayer RF line structure.
FIG. 4D illustrates an example of inductance of a multilayer RF line structure.
FIG. 4E illustrates an example of performance of an antenna using a multilayer RF line structure.
FIG. 4F illustrates an example of a Smith chart for an antenna using a multilayer RF line structure.
FIGS. 5A and 5B illustrate an example of an antenna using a multilayer RF line structure.
FIGS. 6A, 6B, 6C, 6D, and 6E illustrate an example of an antenna using a multilayer RF line structure.
FIG. 7A illustrates an example of a conductive pattern of a multilayer RF line structure.
FIG. 7B illustrates an example of impedance of a multilayer RF line structure.
FIGS. 8A and 8B illustrate an example of performance of a multilayer RF line structure.
FIGS. 9A, 9B, and 9C illustrate an example of performance of a multilayer RF line structure.
FIGS. 10A, 10B, and 10C illustrate an example of a contact member having multiple contact points.
FIG. 11 illustrates an example of a contact member having multiple contact points.
FIG. 12 illustrates an example of performance of a contact member having multiple contact points.
FIGS. 13A, 13B, 14A, and 14B illustrate an example of performance of a contact member having multiple contact points.
FIGS. 15A, 15B, and 15C illustrate an example of performance of an antenna using a multilayer RF line structure and a metal-insulator-metal stacked structure.
FIG. 16 illustrates an example of a flexible printed circuit board (FPCB) using a multilayer RF line structure.
FIG. 17 illustrates an example of an FPCB using a multilayer RF line structure.
FIGS. 18A, 18B, and 18C illustrate examples of a foldable-type electronic device.
FIGS 19A, 19B, 19C, 20A, and 20B illustrate examples of a foldable-type electronic device
FIGS 21A and 21B illustrate examples of a foldable-type electronic device.
FIGS 22A, 22B, 22C, 23A, and 23B illustrate examples of a foldable-type electronic device.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

A term referring to a component of an electronic device (e.g., a substrate, a printed circuit board (PCB), a flexible PCB (FPCB), a printed board assembly (PBA), a module, an antenna component, circuitry, a processor, a chip, a component, or a device), a term referring to components of an antenna (e.g., an antenna radiator, a radiator, a conductive portion, a conductive pattern, a coil, a conductive member, a radiation member, a radiation material, a radiation component, an antenna structure, an antenna structural object, a feeding portion, a feeding member, a radio frequency (RF) line, an RF line structure, a connecting member, a connecting portion, or a contact member), a term referring to a position of a component (e.g., a portion, a position, an area, or a point), a term referring to a shape of a component (e.g., a structure, a structural object, a support unit, a contact unit, flange, or a protruding unit), a term referring to a connecting unit between structures (e.g., a connecting unit, a connecting portion, a contact unit, a contact portion, a support unit, a support portion, a connecting structure, a support structure, a contact structure, a conductive member, a conductive pad, a conductive pattern, or an assembly), a term referring to an open structure (e.g., a slot, a slit, or an opening), a term referring to circuitry (e.g., a PCB, an FPCB, a signal line, a ground line, a feeding line, a data line, an RF signal line, an antenna line, an RF path, an RF module, RF circuitry, a splitter, a divider, a coupler, or a combiner), and the like used in the following description are exemplified for convenience of explanation. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

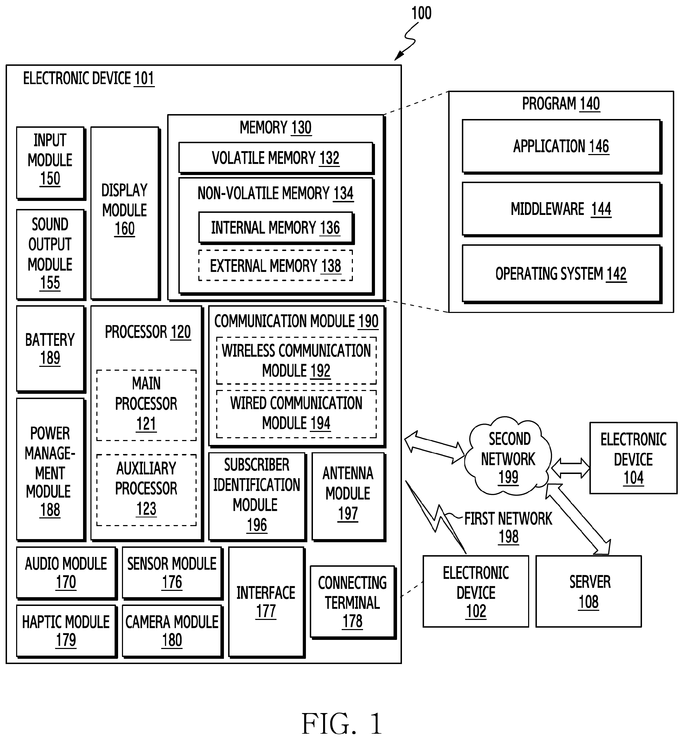

FIG. 1 is a block diagram of an electronic device in a network environment.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

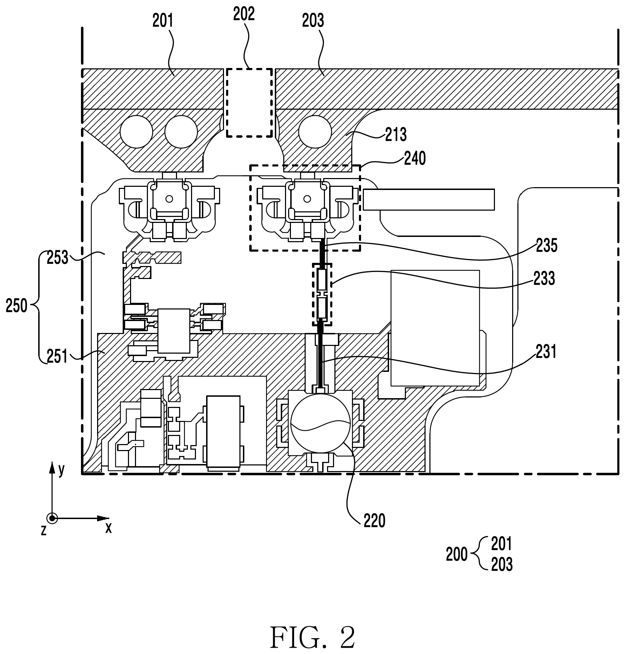

FIG. 2 illustrates an example of an electronic device (e.g., an electronic device 101) including a conductive portion.

Referring to FIG. 2, according to an embodiment, the electronic device 101 may include a metal frame 200. For example, the metal frame 200 may include multiple conductive portions. For example, the metal frame 200 may include a conductive portion 201 and a conductive portion 203. A non-conductive portion may be disposed between each conductive portion (e.g., the conductive portion 201 or the conductive portion 203). The non-conductive portion may be visible to the outside. As an example, a non-conductive portion 202 may be formed in a space between the conductive portion 201 and the conductive portion 203. The non-conductive portion 202 may be referred to as a segmentation portion for distinguishing the two conductive portions. The non-conductive portion 202 may be visible to the outside. According to an embodiment, the conductive portion 203 may be used as a radiator for an antenna. The electronic device 101 may transmit a signal or receive a signal through the conductive portion 203. In order to use the conductive portion 203 as a radiator, a structure for feeding an RF signal to the conductive portion 203 (hereinafter, a feeding structure) may be disposed.

The electronic device 101 may include a PCB 250. The PCB 250 may include multiple layers. The PCB 250 may include a ground area 251. When the PCB 250 is viewed in a direction (e.g., a (-)z-axis direction), the ground area 251 may indicate an area in which a conductor portion (e.g., a copper portion) is formed to transmit ground of one or more electronic components (e.g., wireless communication circuitry 220) of the electronic device 101. For example, the conductor portion may be configured to provide ground by being connected to the wireless communication circuitry 220. For example, in the ground area 251, at least some of the multiple layers of the PCB 250 may include a copper layer for providing ground and/or transmitting a signal. An insulating layer (e.g., pre-impregnated (PPG)) may be disposed between copper layers. In the ground area 251, a copper layer and an insulating layer may be stacked together. Circuitry corresponding to the copper portion may be formed in the ground area 251 of the PCB 250. For example, a chip, a device, and/or a component for the electronic device 101 may be disposed on the ground area 251. For example, the wireless communication circuitry 220 (e.g., a communication module 190) may be disposed on the ground area 251. At least a portion of the wireless communication circuitry 220 may be disposed in the ground area 251 of the PCB 250. The wireless communication circuitry 220 may include, for example, an RF transceiver and/or a radio frequency front end (RFFE) module. A portion of the wireless communication circuitry 220 may be referred to as a feeding circuit in terms of providing antenna feeding. As an example, the feeding circuit may be referred to as a feeding unit as a source for antenna feeding. As a non-limiting example, the wireless communication circuitry 220 may include an RF switching circuit connected to the RFFE module. As an example, an output port of the RF switching circuit may be referred to as a feeding unit as a source of an RF signal. The feeding unit may provide a signal to the conductive portion 203 through a feeding structure.

The PCB 250 may include a signal area 253 to transfer signals to a radiator (e.g., the conductive portion 203) from the feeding unit. When the PCB 250 is viewed in a direction (e.g., the (-)z-axis direction), the signal area 253 may not overlap the ground area 251. For example, the signal area 253 may be positioned outside the ground area 251 overlapping with the at least one insulating layer and the at least one ground layer. According to an embodiment, the signal area 253 may be an area used to transmit a signal to the metal frame (200) (e.g., the conductive portion 203). The PCB 250 may include a plurality of layers. The PCB 250 may include at least one insulating layer and a plurality of metal layers (e.g., copper layers). The metal layers may include a layer used to transmit a signal (hereinafter, referred to as a signal transmission layer) and a layer in which a ground plane is formed (hereinafter, referred to as a ground layer). The metal layers may include one or more signal transmission layers and/or one or more ground layers. In the PCB 250, the ground area 251 may refer to a portion of the signal transmission layer overlapping with the at least one insulating layer and the at least one ground layer. In other words, when the circuit board 250 is viewed in one direction (e.g., the (-) z-axis direction), the ground area 251 may represent an area where a conductive portion (e.g., a copper portion) for transmitting the ground of one or more electronic components (e.g., a wireless communication circuit 220) of the electronic device (101) is formed. On the other hand, the signal area 253 in the circuit board 250 may represent an area where only the at least one insulating layer and a layer for signal transmission (e.g., an RF line structure) overlap. In other words, in the signal area 253, the at least one insulating layer may not overlap with the ground layer. In the signal area 253, the at least one insulating layer may not overlap with other portions of the metal layers except for the RF line structure. The signal area 253 may be referred to by various terms. The signal area 253 may be referred to as a non-copper area, a non-ground area, a clearance area, a ground clearance area, a ground keep-out area, a ground void area, an RF clearance area, a ground relief area, and/or equivalent technical terms, in terms of overlapping only with the insulating layer. The signal area 253 may indicate an area in which a conductor portion (e.g., the copper portion for providing the ground) of the ground area 251 is removed between the metal frame 200 (e.g., the conductive portion 203) and the ground area 251 of the PCB 250. In aspects of being removed, the signal area (253) may be referred to as a fill-cut area, a copper removal area, a keep-out area, a cut-out area, and/or equivalent technical terms. However, the use of such terms is not to be construed as limiting the manufacturing process or implementation method of the circuit board (250). The signal area 253 may not include the copper portion for the ground. In the signal area 253, the PCB 250 may include insulating layers (e.g., dielectric layers) without the copper portions.

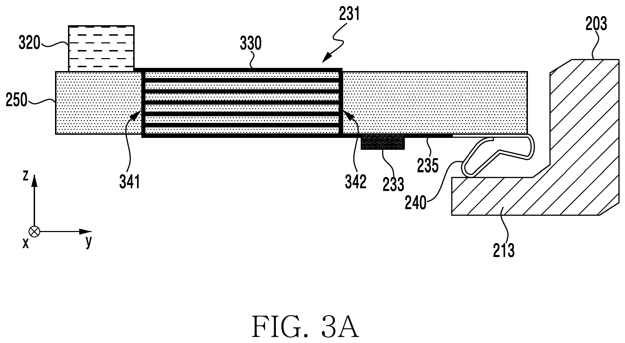

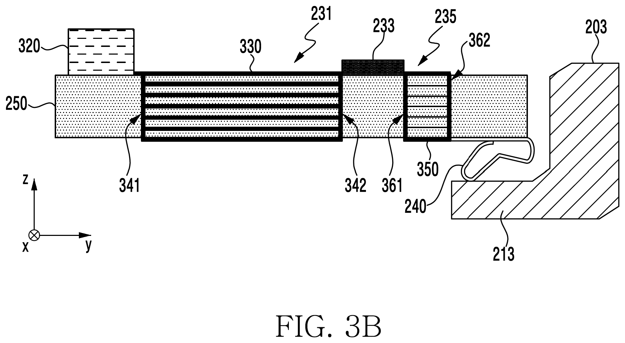

According to embodiments of the present disclosure, in the signal area 253 of the PCB 250, a feeding structure for feeding an RF signal from the wireless communication circuitry 220 on the ground area 251 to the conductive portion 203 functioning as an antenna radiator may be disposed. In order to efficiently transmit the RF signal to the conductive portion 203 (e.g., impedance matching, signal induction reduction of a signal line, or loss reduction), the feeding structure in the signal area 253 may be used. According to embodiments of the present disclosure, the electronic device 101 may include an RF line structure (e.g., an RF line structure 231 or an RF line structure 235) as a component of the feeding structure. The RF line structure may include conductive lines. For example, when the PCB 250 is viewed in a direction (e.g., the (-)z-axis direction), the signal area 253 may not include metal portion (e.g., the copper portion) other than the RF line structure (e.g., the RF line structure 231 or the RF line structure 235). In other words, the signal area 253 may be substantially free of copper portions other than the RF line structure. For signal transmission in the signal area 253, the conductive lines may be used. The conductive lines may be stacked in a direction (e.g., a z-axis direction) in which the layers of the PCB 250 are stacked. For example, a plurality of insulating layers may be stacked in the signal area 253, and conductive lines may be disposed in a partial area of the plurality of insulating layers. The above RF line structure (e.g., RF line structure 231 and RF line structure 235) can be structurally disposed within a PCB (250). A description of a disposition of the conductive lines will be described through FIGS. 3A and 3B.

According to an embodiment, the electronic device 101 may include impedance matching circuitry 233. The RF line structure 231, the impedance matching circuitry 233, and/or the RF line structure 235 may be formed in the signal area 253. The impedance matching circuitry 233 may connect the RF line structure 231 to the RF line structure 235. A feeding path including the RF line structure 231, the impedance matching circuitry 233, and the RF line structure 235 may be used for signal transmission. The impedance matching circuitry 233 may include one or more lumped components. For example, the impedance matching circuitry 233 may include at least one of an inductor, a capacitor, and/or a register. The RF line structure (e.g., the RF line structure 231 and/or the RF line structure 235) may provide inductance in a signal path. Each component of the impedance matching circuitry 233 may be used for impedance matching together with the RF line structure (e.g., the RF line structure 231 and/or the RF line structure 235).

According to an embodiment, the electronic device 101 may include a contact member 240 (e.g., a C-clip). The contact member 240 may be electrically connected to the RF line structure 235. For example, the contact member 240 may be disposed on one side of the PCB 250. The contact member 240 may include a portion having elasticity. While pressure is provided to the contact member 240, the contact member 240 may be disposed to contact a protruding portion 213 of the conductive portion 203 or a component connected to the protruding portion 213. Due to the contact, an RF signal may be provided to the conductive portion 203 through the RF line structure 231, the impedance matching circuitry 233, and/or the RF line structure 235. The conductive portion 203 may radiate the RF signal.

As various types of services increase, antenna performance in relatively high frequency bands (e.g., a WiFi band of about 5.925 gigahertz (GHz) to 7.125 GHz, an ultra-wideband (UWB) band of about 6.5 GHz to 8.25 GHz, an ultra-high band (UHB) band of about 3 GHz or above (e.g., n77, n78, n79 bands)) is required as an important factor. A high frequency characteristic may degrade RF performance, such as causing antenna mismatch and/or increased loss in a transmission line. In order to secure sufficient antenna performance, there is a method of providing a separate antenna for the corresponding frequency band, but it may not be easy to dispose a separate antenna in the electronic device due to a spatial limitation of the electronic device. An RF line used as a feeding path of an RF signal may be understood as an inductor. As a length of the RF line increases, inductance (e.g., series inductance) of the RF line may increase. This increase in inductance may significantly reduce antenna efficiency and cause mismatch in a high frequency band. As an example, as the length of the RF line increases in the high frequency band, a resonance point close to 50 ohms on a Smith chart may rotate greatly and move close to an open point. As an example, even if very small inductance less than 1 nH is applied on a feeding path, a matching characteristic may be significantly degraded at a frequency of about 3 GHz or above.

In order to solve the above-described problem, embodiments of the present disclosure describe technology for a feeding structure for securing antenna performance in a high frequency band by reducing influence due to impedance mismatch in the high frequency band. In various embodiments of the present invention, a feeding structure of an antenna to reduce influence of inductance of an RF line (e.g., the RF line structure 231 or the RF line structure 235) used as a feeding path is described.

In FIG. 2, the conductive portion 203 of the metal frame 200 as a radiator of an antenna is described as an example, but embodiments of the present disclosure are not limited thereto. The conductive portion 203 may be a different type of radiator. If it is a radiator connected to the RF line structure (e.g., the RF line structure 231 and/or the RF line structure 235), it may be referred to as the conductive portion 203. According to an embodiment, a patch radiator connected to the RF line structure may be understood as a type of the conductive portion 203. For another example, a coil radiator connected to the RF line structure may be understood as a type of the conductive portion 203.

In FIG. 2, when the PCB 250 is viewed in a direction (e.g., the (-)z-axis direction), it is illustrated that there is no ground layer in the signal area 253 of the PCB 250, but as a non-limiting example, a ground layer of the PCB 250 may be disposed sufficiently spaced apart from the RF line structure on a z-axis.

FIG. 3A illustrates an example of an electronic device (e.g., an electronic device 101) including conductive lines disposed in multiple layers of a printed circuit board (PCB). The same reference number may be used to indicate the same component and/or the same description.

Referring to FIG. 3A, the electronic device 101 may include a feeding circuit 320. The feeding circuit 320 is a component of wireless communication circuitry 220 and may correspond to a source for outputting an RF signal. An RF signal of a communication frequency band may be outputted through the feeding circuit 320. As an example, the feeding circuit 320, which is a source for antenna feeding, may be referred to as a feeding unit. For example, the feeding circuit 320 may be a switching circuit for selecting a signal path. An output of the feeding circuit 320 may correspond to an output port of the switching circuit. As a non-limiting example, the feeding circuit 320 is an RFFE module (e.g., a front end module (FEM), a power amplifier module (PAM), a FEM including duplexer (FEMid), a power amplifier module including duplexer (PAMid), or a Low noise amplifier PAM including duplexer (LPAMid)), and an output of the feeding circuit 320 may correspond to an output port of the RFFE module. For example, at least a portion of the feeding circuit 320 may be disposed on a first side (e.g., a side facing a (+)z-axis) of a PCB 250 in a ground area (e.g., a ground area 251).

The electronic device 101 may include an RF line structure 231 electrically connected to the feeding circuit 320. The electronic device 101 may feed an RF signal of the feeding circuit 320 to a conductive portion 203 through an RF line structure 231, impedance matching circuitry 233, an RF line structure 235, and a contact member 240. The contact member 240 may be disposed to contact a protruding portion 213 (or a component connected to the protruding portion 213) of the conductive portion 203 while pressure in a direction (e.g., a (-)z-axis direction) is provided to the contact member 240. Due to the contact, the RF signal may be provided to the conductive portion 203 through a path of the RF line structure 231, the impedance matching circuitry 233, and/or the RF line structure 235. The conductive portion 203 may be configured to radiate the RF signal. The RF line structure 231 and the RF line structure 235 may be disposed in a fill-cut area (e.g., a signal area 253) of the PCB 250. The impedance matching circuitry 233 may include at least one component (e.g., an inductor, a capacitor, or a register) for impedance matching. For example, the at least one component may be disposed on a second side (e.g., a side facing a (-)z-axis) of the PCB 250. For example, the impedance matching circuitry 233 may be included in the PCB 250 and implemented as components of the PCB 250. The impedance matching circuitry 233 may be electrically connected to the contact member 240. For example, the contact member 240 may be disposed on the second side (e.g., the side facing the (-)z-axis) of the PCB 250.

According to an embodiment, in order to reduce influence of an inductor as a length of an RF line increases, an RF line structure according to embodiments of the present disclosure may include a parallel disposition of inductors. According to an embodiment, the RF line structure may include a conductive line disposed on at least two layers of the PCB 250 and at least two or more conductive vias for connecting the conductive lines in parallel. The RF line structure 231 includes conductive lines 330 including a conductive line formed in a plurality of layers of multiple layers of the PCB 250, a first conductive via 341 coupled to the conductive lines 330, and a second conductive via 342 coupled to the conductive lines 330. In an embodiment, the conductive lines 330 may include conductive lines formed in each of the at least two or more layers of the PCB 250. The conductive lines 330 may be stacked in a direction (e.g., a (+)z-axis direction). For example, the conductive lines 330 may overlap when the PCB 250 is viewed in a direction (e.g., the (-)z-axis direction or the (+)z-axis direction). A conductive line connected to the first conductive via 341 and/or the second conductive via 342 may be understood as a signal path through which an RF signal from the wireless communication circuitry 220 is transmitted. The conductive line connected to the first conductive via 341 and/or the second conductive via 342 may function as an inductor for the RF signal. The conductive lines stacked in a direction (e.g., the (+)z-axis direction) may be referred to as inductors connected in parallel. Each conductive line of the conductive lines 330 may include a first end portion close to the ground area 251 and a second end portion close to the conductive portion 203, among the ground area 251 (e.g., the wireless communication circuitry 220 or the feeding circuit 320) and the conductive portion 203. First end portions of the conductive lines 330 may be connected to the first conductive via 341. Second end portions of the conductive lines 330 may be connected to the second conductive via 342. According to an embodiment, the RF line structure (e.g., RF line structure 231 and RF line structure 235 may be structurally disposed within a PCB 250. The conductive lines 330 may correspond to a portion of the metal layers within the PCB 250. The first conductive via 341 and the second conductive via 342 may be structurally disposed within the PCB 250.

A single conductive line may be understood as an inductor. Since inductors are arranged in a direction (e.g., a z-axis direction), the inductors are connected on a side through the first conductive via 341, and the inductors are connected on another side through the second conductive via 342, the RF line structure 231 may be referred to as circuitry in which inductors are disposed in parallel. Due to the parallel disposition of inductors, a size of composite inductance may be smaller than inductance of the single inductor. Even if it has the same length on a plane (e.g., an xy plane), inductance of a structure in which the conductive lines 330 are stacked on an axis (e.g., a z-axis) may be smaller than inductance of one conductive line. Due to an RF line structure (hereinafter, a multilayer RF line structure) using conductive lines of multiple layers, influence due to an inductor may be reduced. Even if a length (e.g., a length when the RF line structure 231 is viewed in a direction (e.g., the (-)z-axis direction)) of an RF line between the feeding circuit 320 and the contact member 240 increases, impedance influence due to the length increase of the RF line may be reduced. A relatively small impedance change may facilitate impedance matching for the conductive portion 203 for multiple frequency bands. Antenna performance may be improved by the impedance matching.

FIG. 3B illustrates an example of an electronic device (e.g., an electronic device 101) including conductive lines disposed on multiple layers of a PCB. The same reference number may be used to indicate the same component and/or the same description.

Referring to FIG. 3B, the electronic device 101 may include a feeding circuit 320. The feeding circuit 320, which is a component of wireless communication circuitry 220, may correspond to a source for outputting an RF signal. For the feeding circuit 320, the descriptions of FIG. 3A may be referenced. The electronic device 101 may include an RF line structure 231 electrically connected to the feeding circuit 320. The electronic device 101 may feed an RF signal of the feeding circuit 320 to a conductive portion 203 through an RF line structure 231, impedance matching circuitry 233, an RF line structure 235, and a contact member 240. For the RF line structure 231, the impedance matching circuitry 233, the RF line structure 235, and/or the contact member 240, the descriptions of FIG. 3A may be referenced. According to an embodiment, the RF line structure 231 and the RF line structure 235 may be disposed in a fill-cut area (e.g., a signal area 253) of a PCB 250. According to an embodiment, the impedance matching circuitry 233 may include at least one component (e.g., an inductor, a capacitor, or a register) for impedance matching. For example, the at least one element may be disposed on a first side (e.g., a side facing a (+)z-axis) of the PCB 250. For example, the contact member 240 may be disposed on a second side (e.g., a side facing a (-)z-axis) of the PCB 250.

In order to reduce influence of an inductor as a length of an RF line increases, an RF line structure according to embodiments of the present disclosure may include a parallel disposition of inductors. For example, the RF line structure 231 may include conductive lines 330 including a conductive line formed in a plurality of layers among multiple layers of the PCB 250, a first conductive via 341 coupled to the conductive lines 330, and a second conductive via 342 coupled to the conductive lines 330. For the conductive lines 330, the first conductive via 341, and the second conductive via 342, the descriptions of FIG. 3A may be referenced. In an embodiment, in FIG. 3B, in order to further reduce inductance influence due to an RF line, the RF line structure 235 may also have a multilayer RF line structure. For example, the RF line structure 235 may include conductive lines 350 including a conductive line formed in a plurality of layers among multiple layers of the PCB 250, a third conductive via 361 coupled to the conductive lines 350, and a fourth conductive via 362 coupled to the conductive lines 350. The conductive lines 350 may include a conductive line formed in each of the at least two or more layers of the PCB 250. The conductive lines may be stacked in a direction (e.g., the (+)z-axis direction). A conductive line connected to the third conductive via 361 and/or the fourth conductive via 362 may be understood as a signal path through which an RF signal passing through the impedance matching circuitry 233 is transmitted. The RF signal passing through the impedance matching circuitry 233 may pass through the signal path of the conductive line connected to the third conductive via 361 and/or the fourth conductive via 362. The conductive line connected to the third conductive via 361 and/or the fourth conductive via 362 may function as an inductor for the RF signal. The conductive lines stacked in a direction (e.g., the (+)z-axis direction) may be referred to as inductors connected in parallel. Each conductive line of the conductive lines 350 may include a first end portion close to a ground area 251 and a second end portion close to the conductive portion 203, among the ground area 251 (e.g., the wireless communication circuitry 220 or the feeding circuit 320) and the conductive portion 203. The first end portions of the conductive lines 350 may be coupled to the third conductive via 361. The second end portions of the conductive lines 350 may be coupled to the fourth conductive via 362.

In the RF line structure 231 as well as the RF line structure 235, inductance due to parallel disposition of the conductive lines 350 may be reduced. Each conductive line of the conductive lines 350 may be understood as an inductor. Since inductors are arranged in a direction (e.g., a z-axis direction), the inductors are connected on a side through the third conductive via 361, and the inductors are connected on another side through the fourth conductive via 362, the RF line structure may be referred to as circuitry in which inductors are arranged in parallel. Due to the parallel disposition of inductors, a size of composite inductance may be smaller than inductance of a single inductor. Even if a length (e.g., a length when the RF line structure 235 is viewed in a direction (e.g., the (-)z-axis direction)) of an RF line for connecting the feeding circuit 320 and the contact member 240 increases, impedance influence due to the length increase of the RF line may be reduced. A relatively small impedance change may facilitate impedance matching for the conductive portion 203 for multiple frequency bands. Antenna performance may be improved by the impedance matching.

In FIGS. 3A and 3B, an RF line structure in which a conductive line is disposed in each layer of multiple layers of the PCB 250 is exemplified, but embodiments of the present disclosure are not limited thereto. A structure in which a conductive line corresponding to an inductor is disposed in parallel may be understood as an embodiment of the present disclosure. For example, a conductive line may be formed in each layer of at least two of the multiple layers of the PCB 250. Conductive lines of at least two or more layers may be coupled to the first conductive via 341 and the second conductive via 342. The first conductive via 341 may be disposed vertically from the first side (e.g., the side facing the (+)z-axis) of the PCB. The first conductive via 341 may be vertically disposed to be connected to all of the at least two or more layers. The second conductive via 342 may be disposed vertically from the second side (e.g., the side facing the (-)z-axis) of the PCB. The second conductive via 342 may be vertically disposed to be connected to all of the at least two or more layers. The conductive lines of the at least two or more layers may be referred to as an inductor disposed in parallel through conductive vias (e.g., the first conductive via 341 and the second conductive via 342). Series inductance of an RF signal line may be reduced due to composite impedance.

In FIGS. 3A and 3B, two conductive vias that couple conductive lines in a direction (e.g., a z-axis direction) for parallel disposition of inductors in each RF line structure are illustrated, but embodiments of the present disclosure are not limited thereto. For example, the electronic device 101 may include three or more conductive vias for coupling the conductive lines of the RF line structure in a vertical direction.

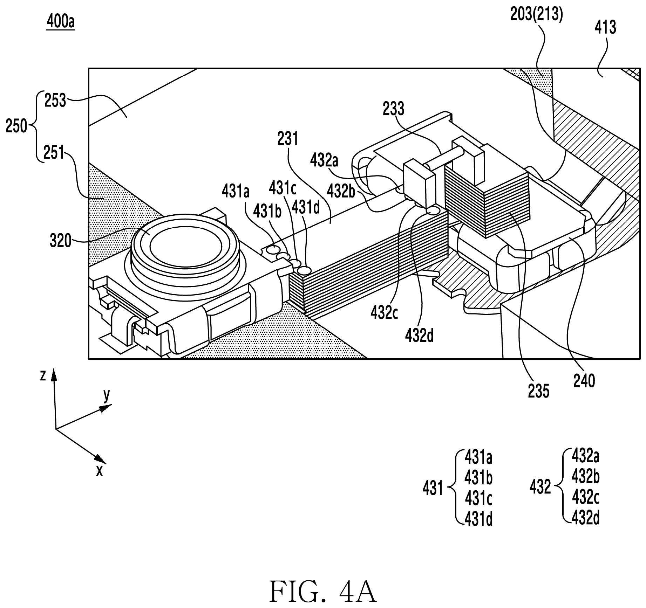

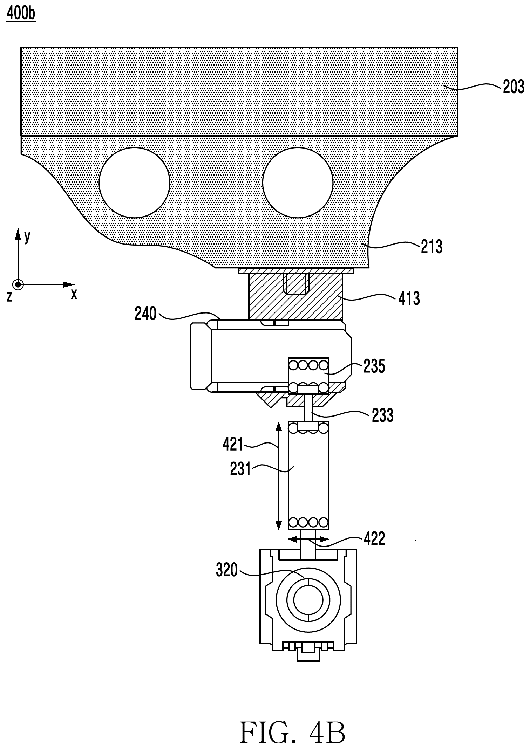

In FIGS. 3A and 3B, an example in which the contact member 240 contacts a portion (e.g., the protruding portion 213) of the conductive portion 203 is illustrated, but embodiments of the present disclosure are not limited thereto. The contact member 240 may contact a separate component (e.g., a conductive pad or a conductive pattern) connected to the conductive portion 203. Through the contact, an RF signal fed through the contact member 240 may be provided to the conductive portion 203. A contact structure using the component is described through FIGS. 4A and 4B.

In FIGS. 3A and 3B, in order to reduce influence of an inductor as a length of an RF line increases, a parallel disposition of inductors of an RF line structure according to embodiments of the present disclosure has been described. In FIGS. 3A and 3B, a structure in which conductive lines are stacked in the z-axis direction has been described, but embodiments of the present disclosure are not limited thereto. In an embodiment, conductive lines may be arranged in a direction (e.g., an x-axis direction) on a layer (e.g., an xy-plane) of the PCB. For the parallel disposition of the conductive lines, first end portions of each conductive line may be connected to each other and second end portions of each conductive line may be connected to each other. In the structure, unlike in FIGS. 3A and 3B, a conductive via (e.g., the first conductive via 341 or the third conductive via 361) for the parallel disposition may be omitted.

FIGS. 4A and 4B illustrate an example of an antenna using a multilayer radio frequency (RF) line structure. The same reference number may be used to indicate the same component and/or the same description.

Referring to FIG. 4A, an example 400a indicates a feeding structure of an antenna. An electronic device 101 may include a PCB 250. The PCB 250 may include a ground area 251 and a signal area 253. The electronic device 101 may include a feeding circuit 320. At least a portion of the feeding circuit 320 may be disposed on the ground area 251 of the PCB 250. The feeding circuit 320 may be electrically connected to a processor (e.g., a processor 120). For example, the feeding circuit 320 may include an RF switching circuit connected to a communication module (e.g., a communication module 190 or an RFFE module). The feeding circuit 320 may be connected to an RF line structure 231 formed in the signal area 253 of the PCB 250. According to an embodiment, the electronic device 101 may include an RF line structure (e.g., the RF line structure 231) as a component of the feeding structure. A feeding path including the RF line structure 231, impedance matching circuitry 233, and an RF line structure 235 may be used for signal transmission. The RF line structure 235 may be connected to a contact member 240. In an embodiment, the electronic device 101 may include a conductive pad 413 coupled to a conductive portion 203 (or a protruding portion 213 of the conductive portion 203). For example, the conductive pad 413 may have an 'L'-shape. A first portion of the conductive pad 413 may have a side parallel to an xz plane. A second portion of the conductive pad 413 may have a side parallel to an xy plane. The first portion of the conductive pad 413 may be coupled to the conductive portion 203. The second portion of the conductive pad 413 may contact the contact member 240. An RF signal transmitted through the feeding path may be provided to the conductive portion 203 through the contact member 240 and the conductive pad 413.

According to an embodiment, the RF line structure 231 may include conductive lines. In the signal area 253, the conductive lines may be used for signal transmission. The conductive lines may be stacked in a direction (e.g., a z-axis direction) in which layers of the PCB 250 are stacked. For example, a plurality of insulating layers may be stacked in the signal area 253, and conductive lines may be disposed in a partial area of the plurality of insulating layers. Each of the conductive lines may correspond to an inductor. The RF line structure 231 may include a plurality of conductive vias for parallel connection of inductors corresponding to the conductive lines. The plurality of conductive vias (e.g., a first conductive via 341) may include a first set 431 of conductive vias and a second set 432 of conductive vias, which are distinguished according to an input and an output of an RF line structure. The first set 431 of conductive vias may be disposed close to the ground area 251 among the ground area 251 and the conductive portion 203. The second set 432 of conductive vias may be disposed close to the conductive portion 203 among the ground area 251 and the conductive portion 203. For example, the RF line structure 231 may include the first set 431 of conductive vias. The first set 431 of conductive vias may include a first conductive via 431a, a second conductive via 431b, a third conductive via 431c, and/or a fourth conductive via 431d. For example, the RF line structure 231 may include the second set 432 of conductive vias. The second set 432 of the conductive vias may include a fifth conductive via 432a, a sixth conductive via 432b, a seventh conductive via 432c, and/or an eighth conductive via 432d.

Referring to FIG. 4B, an example 400b indicates a diagram in which the feeding structure of the antenna of FIG. 4A is viewed in a direction (e.g., a (-)z-axis direction). The electronic device 101 may include the RF line structure 231 electrically connected to the feeding circuit 320. An RF signal of the feeding circuit 320 may be provided to the conductive portion 203 through the RF line structure 231, the impedance matching circuitry 233, the RF line structure 235, the contact member 240, and/or the conductive pad 413. In an embodiment, when the PCB 250 is viewed in a direction (e.g., the (-)z-axis direction), the RF line structure 231 may have a length 421 and a width 422. For example, inductance of a single conductive line having the length 421 and the width 422 may be L₁. Inductance of a structure in which single conductive lines having the length 421 and the width 422 are stacked in a direction (e.g., the z-axis direction) may be L₂. L₂ may be less than L₁. By efficiently stacking conductive lines in a limited space of the PCB 250, influence of inductance due to a length (e.g., the length 421) of an RF line may be reduced. A description of the RF line structure 231 may be applied to the RF line structure 235 in the same or similar manner.

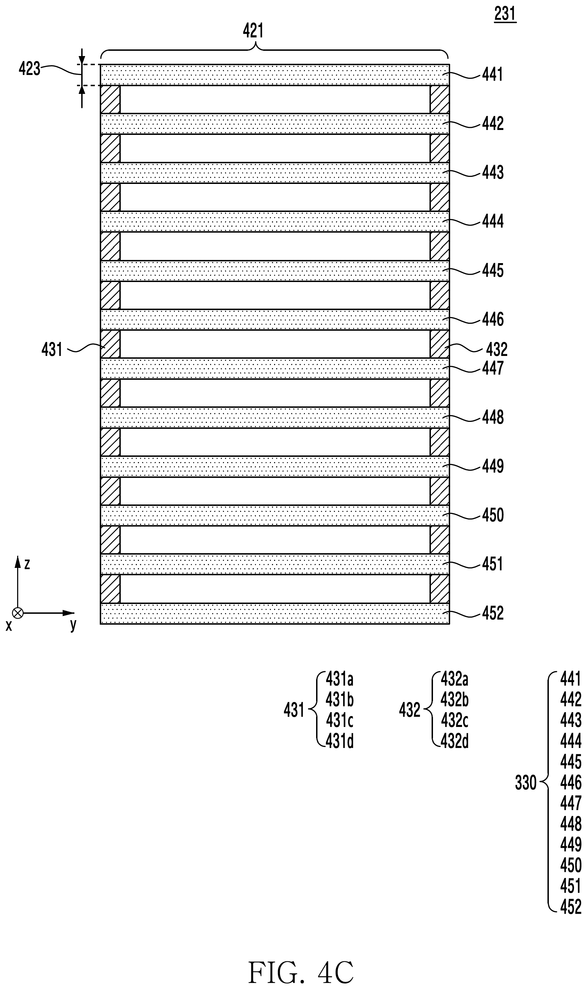

FIG. 4C illustrates an example of a multilayer RF line structure (e.g., an RF line structure 231). The same reference number may be used to indicate the same component and/or the same description.

Referring to FIG. 4C, the RF line structure 231 may include conductive lines 330 formed in each layer of multiple layers. For example, the conductive lines 330 of the RF line structure 231 may include twelve conductive lines. As an example, the conductive lines 330 may include a first conductive line 441, a second conductive line 442, a third conductive line 443, a fourth conductive line 444, a fifth conductive line 445, a sixth conductive line 446, a seventh conductive line 447, an eighth conductive line 448, a ninth conductive line 449, a tenth conductive line 450, an eleventh conductive line 451, and/or a twelfth conductive line 452.

According to an embodiment, each conductive line of an RF line structure (e.g., the RF line structure 231 or an RF line structure 235) may have substantially the same shape. For example, each conductive line of the conductive lines 330 may have a length 421 and a width 422. As an example, the length 421 may be about 2 mm. As a non-limiting example, the length 421 may belong to a range of about 1.8 mm or above and less than about 2.2 mm. As an example, the width 422 may be about 0.15 mm. As a non-limiting example, the width 422 may belong to a range of about 0.135 mm or above and less than about 0.165 mm. Each conductive line of the conductive lines 330 may have a thickness 423. As an example, the thickness 423 may be about 0.02 m. As a non-limiting example, the thickness 423 may belong to a range of about 0.018 mm or above and less than about 0.022 mm. Adjacent two conductive lines (e.g., the fifth conductive line 445 and the sixth conductive line 446) of the conductive lines 330 may be spaced apart in a direction (e.g., a z-axis direction).

A shape of a conductive line may influence inductance provided by the conductive line. For example, as a length of a conductive line increases, inductance may increase. For example, as a width of a conductive line increases, inductance may be reduced. For example, as a thickness of a conductive line increases, inductance may be reduced. An RF line structure (e.g., the RF line structure 231 or the RF line structure 235) according to embodiments of the present disclosure may include a disposition structure of conductive lines to reduce total inductance in a length of a specific RF line. If a width of each conductive line is increased, inductance of each conductive line may be reduced. Meanwhile, due to the increase in width, a space for disposing another component or wiring in a PCB 250 may be reduced. In embodiments of the present disclosure, a feeding structure including conductive lines stacked in a vertical direction (e.g., the z-axis direction) instead of a horizontal direction (e.g., an xy plane) may be used to effectively use a space in the PCB 250 and reduce composite impedance.

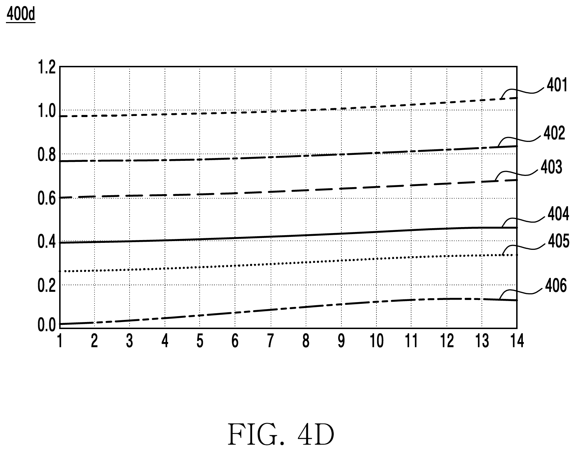

FIG. 4D illustrates an example of inductance of a multilayer RF line structure (e.g., an RF line structure 231).

Referring to FIG. 4D, a graph 400d indicates inductance for each frequency. A horizontal axis of the graph 400d indicates a frequency (unit: GHz), and a vertical axis of the graph 400d indicates an inductance value (unit: nano henry (nH)). In the graph 400d, inductance that varies according to how many conductive lines exemplified in FIG. 4C are stacked is illustrated. A first line 401 indicates inductance of one conductive line. A second line 402 indicates inductance of an RF line structure in which three conductive lines are stacked. A third line 403 indicates inductance of an RF line structure in which five conductive lines are stacked. A fourth line 404 indicates inductance of an RF line structure in which seven conductive lines are stacked. A fifth line 405 indicates inductance of an RF line structure in which nine conductive lines are stacked. A sixth line 406 indicates inductance of an RF line structure in which twelve conductive lines are stacked. As the larger number of conductive lines are stacked, it may be confirmed that inductance of an RF line structure is reduced.

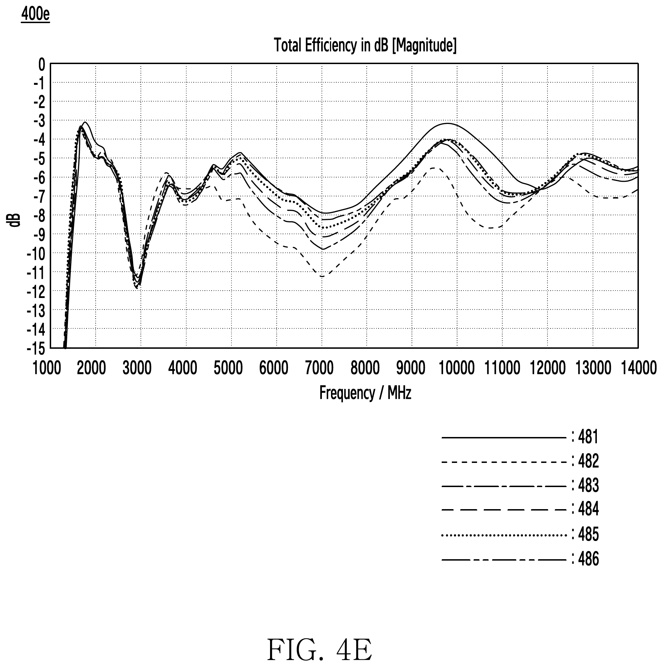

FIG. 4E illustrates an example of performance of an antenna using a multilayer RF line structure. Total efficiency may be used as the performance of the antenna. The total efficiency may indicate a ratio of an actual radiated power of total power transmitted by the antenna.

Referring to FIG. 4E, a graph 400e indicates total efficiency for each frequency. A horizontal axis of the graph 400e indicates a frequency (unit: GHz), and a vertical axis of the graph 400e indicates total efficiency (unit: decibel (dB)). A first line 481 indicates total efficiency when performing an ideal feed without an RF line. A second line 482 indicates total efficiency of an antenna using an RF line structure having one conductive line of a single layer. A width of each conductive line may be about 0.15 mm. A third line 483 indicates total efficiency of an antenna using an RF line structure in which five conductive lines are stacked. A width of each conductive line may be about 0.15 mm. A fourth line 484 indicates total efficiency of an antenna using an RF line structure in which nine conductive lines are stacked. A width of each conductive line may be about 0.15 mm. A fifth line 485 indicates total efficiency of an antenna using an RF line structure in which twelve conductive lines are stacked, and a width of each conductive line of the twelve conductive lines may be about 0.15 mm. A sixth line 486 indicates total efficiency of an antenna using an RF line structure in which twelve conductive lines are stacked, and a width of each conductive line of the twelve conductive lines may be about 0.5 mm.

Referring to the graph 400e, it may be confirmed that as the number of stacked conductive lines increases, total efficiency of an antenna becomes closer to total efficiency in an ideal feed. This is because inductance corresponding to a length of an RF line is reduced due to a stacked structure of the conductive lines. Since a size of inductance applied to a path through which a signal is fed is reduced even if it has the same length of an RF line, an impedance change may be relatively small. In addition, when comparing the fifth line 485 and the sixth line 486 of the graph 400e, it may be confirmed that total efficiency of an antenna increases as a width of a conductive line increases. This is because inductance of corresponding conductive line is reduced as a width of each conductive line increases. A width of a conductive line of an RF line structure may be designed based on a disposition between components in a PCB 250.

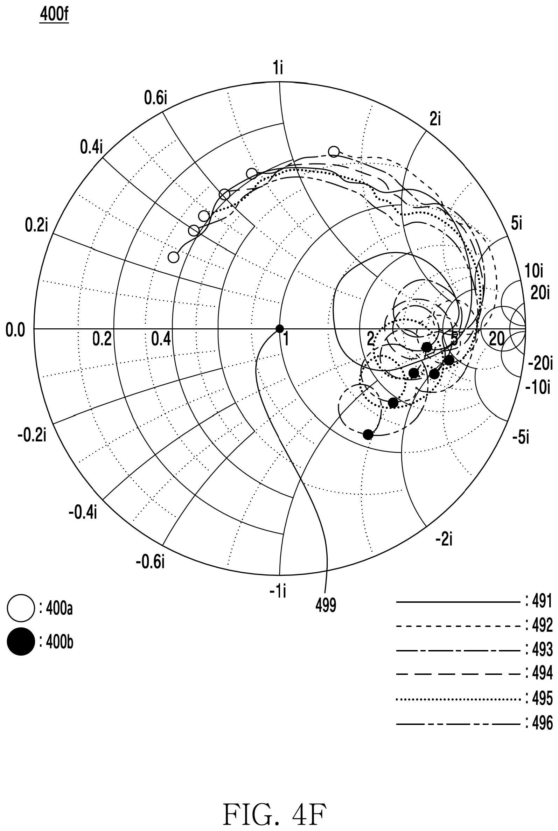

FIG. 4F illustrates an example of a Smith chart for an antenna using a multilayer RF line structure.

Referring to FIG. 4F, a Smith chart 400f represents impedance (unit: ohm) for each frequency. The impedance may indicate a value normalized based on 50 ohms, and may be used to calculate a reflection coefficient (e.g., S₁₁). Each concentric circle of the Smith chart 400f may indicate points in which a real number portion (e.g., a resistance portion) of impedance is the same. Each line of the Smith chart 400f indicates impedance according to a frequency change from a first frequency 490a (e.g., about 5 GHz) to a second frequency 490b (e.g., about 14 GHz). A first line 491 indicates impedance when performing an ideal feed without an RF line. A second line 492 indicates impedance of an antenna using an RF line structure having one conductive line of a single layer. A width of each conductive line may be about 0.15 mm. A third line 493 indicates impedance of an antenna using an RF line structure in which five conductive lines are stacked. A width of each conductive line may be about 0.15 mm. A fourth line 494 indicates impedance of an antenna using an RF line structure in which nine conductive lines are stacked. A width of each conductive line may be about 0.15 mm. A fifth line 495 indicates impedance of an antenna using an RF line structure in which twelve conductive lines are stacked, and a width of each conductive line of the twelve conductive lines may be about 0.15 mm. A sixth line 496 indicates impedance of an antenna using an RF line structure in which twelve conductive lines are stacked, and a width of each conductive line of the twelve conductive lines may be about 0.5 mm.

Referring to the Smith chart 400f, it may be confirmed that as the number of stacked conductive lines increases, an impedance change in a high frequency band is reduced. Additionally, it may be confirmed that as the number of stacked conductive lines increases, impedance is formed close to a center point 499 (e.g., 1 ohm) for impedance matching. Since a size of inductance applied to a path through which a signal is fed is reduced even if it has the same length of an RF line, an impedance change may be relatively small. In addition, when comparing the fifth line 495 and the sixth line 496 of the Smith chart 400f, it may be confirmed that as a width of a conductive line increases, an impedance change is reduced. This is because inductance of each conductive line is reduced as a width of each conductive line increases. A width of a conductive line of an RF line structure may be designed based on a disposition between components in a PCB 250.

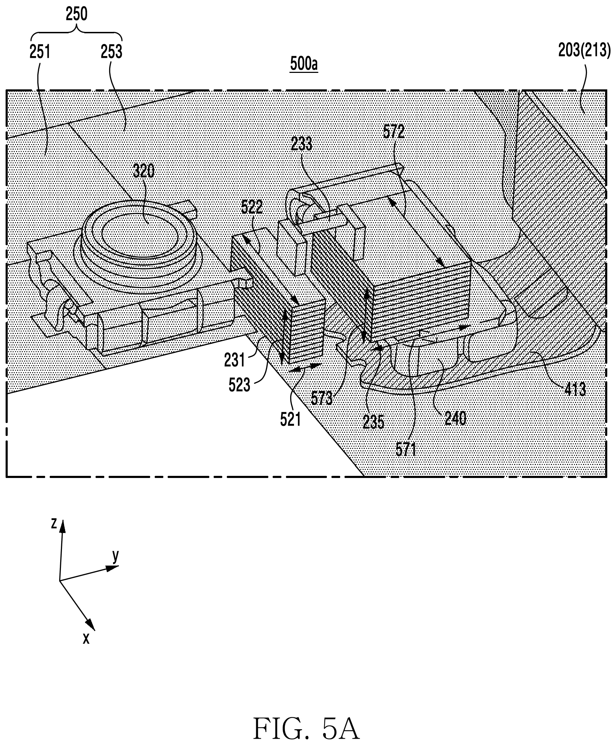

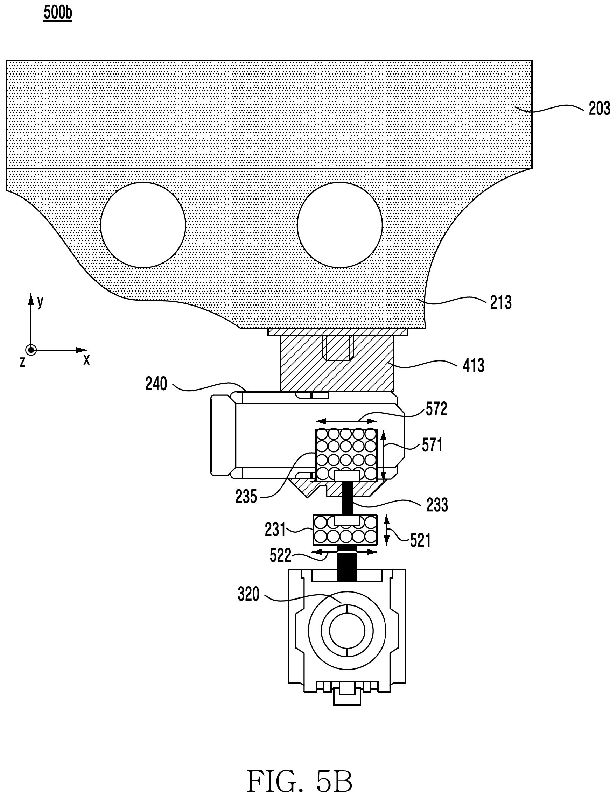

FIGS. 5A and 5B illustrate an example of an antenna using a multilayer RF line structure. The same reference number may be used to indicate the same component and/or the same description.

Referring to FIG. 5A, an example 500a indicates a feeding structure of an antenna. An electronic device 101 may include a PCB 250. The PCB 250 may include a ground area 251 and a signal area 253. The electronic device 101 may include a feeding circuit 320. At least a portion of the feeding circuit 320 may be disposed on the ground area 251 of the PCB 250. The feeding circuit 320 may be electrically connected to a processor (e.g., a processor 120). For example, the feeding circuit 320 may include an RF switching circuit connected to a communication module (e.g., a communication module 190 or an RFFE module). The feeding circuit 320 may be connected to an RF line structure 231 formed in the signal area 253 of the PCB 250. According to an embodiment, the electronic device 101 may include the RF line structure 231 as a component of the feeding structure. A feeding path including the RF line structure 231, impedance matching circuitry 233, and an RF line structure 235 may be used for signal transmission. The RF line structure 235 may be connected to a contact member 240. The electronic device 101 may include a conductive pad 413 coupled to a conductive portion 203 (or a protruding portion 213 of the conductive portion 203). For example, the conductive pad 413 may have an 'L'-shape. The descriptions of FIG. 4A may be referenced for the conductive pad 413.

According to an embodiment, the RF line structure 231 may include conductive lines (e.g., conductive lines 330 or conductive lines 350). In the signal area 253, the conductive lines may be used for signal transmission of the PCB 250. The conductive lines may be stacked in a direction (e.g., a z-axis direction) in which layers of the PCB 250 are stacked. For example, the RF line structure 231 and the RF line structure 235 may be used to reduce inductance in the feeding structure. The RF line structure 231 may have a length 521 (e.g., a y-axis length), a width 522 (e.g., an x-axis length), and a thickness 523 (e.g., a z-axis length). The RF line structure 231 may include multiple conductive lines (e.g., the conductive lines 330) stacked in a direction (e.g., the z-axis direction). As a non-limiting example, in order to provide lower inductance than inductance of the RF line structure 231 of the example 400a, the RF line structure 231 of the example 500a may include conductive portions having the wider width 522. For example, the RF line structure 231 may have the width 522 of about 1 mm. As an example, the RF line structure 231 may include a conductive line formed in each layer of twelve layers. Each conductive line may have a width of about 1 mm. The RF line structure 235 may have a length 571 (e.g., a y-axis length), a width 572 (e.g., an x-axis length), and a thickness 573 (e.g., a z-axis length). The RF line structure 235 may include multiple conductive lines (e.g., the conductive lines 350) stacked in a direction (e.g., the z-axis direction). As an example, the RF line structure 235 may include conductive lines having a width of about 1 mm. The thickness 573 of the RF line structure 235 may be substantially the same as the thickness 523 of the RF line structure 231. As an example, the number of conductive lines stacked on the RF line structure 235 may be twelve. The number of conductive lines stacked on the RF line structure 231 may be twelve. As a non-limiting example, the thickness 573 of the RF line structure 235 may be different from the thickness 523 of the RF line structure 231. The number of conductive lines stacked on the RF line structure 235 may be different from the number of conductive lines stacked on the RF line structure 231.

Referring to FIG. 5B, an example 500b indicates a diagram in which the feeding structure of the antenna of FIG. 5A is viewed in a direction (e.g., a (-)z-axis direction). The electronic device 101 may include the RF line structure 231 electrically connected to the feeding circuit 320. An RF signal of the feeding circuit 320 may be provided to the conductive portion 203 through the RF line structure 231, the impedance matching circuitry 233, the RF line structure 235, the contact member 240, and the conductive pad 413. When the PCB 250 is viewed in a direction (e.g., the (-)z-axis direction), the RF line structure 231 may have the length 521 and the width 522. For example, inductance of a single conductive line having the length 521 and the width 522 may be L₁. Inductance of a structure in which single conductive lines having the length 521 and the width 522 are stacked in a direction (e.g., the z-axis direction) may be L₂. L₂ may be less than L₁. The RF line structure 235 may have the length 571 and the width 572 when the PCB 250 is viewed in a direction (e.g., the (-)z-axis direction). For example, inductance of a single conductive line having the length 571 and the width 572 may be L₃. Inductance of a structure in which single conductive lines having the length 571 and the width 572 are stacked in a direction (e.g., the z-axis direction) may be L₄. L₄ may be less than L₃. By efficiently stacking conductive lines in a limited space of the PCB 250, influence of inductance due to a length (e.g., the length 521 or the length 571) of an RF line may be reduced.

In FIGS. 5A and 5B, a feeding structure including conductive lines in which both the RF line structure 231 and the RF line structure 235 are stacked has been described. However, embodiments of the present disclosure are not limited thereto. According to an embodiment, the impedance matching circuitry 233 and the feeding circuit 320 are connected through a conductive line of a single layer of an RF line, and the RF line structure 235 between the impedance matching circuitry 233 and the contact member 240 may have a multilayer RF line structure.

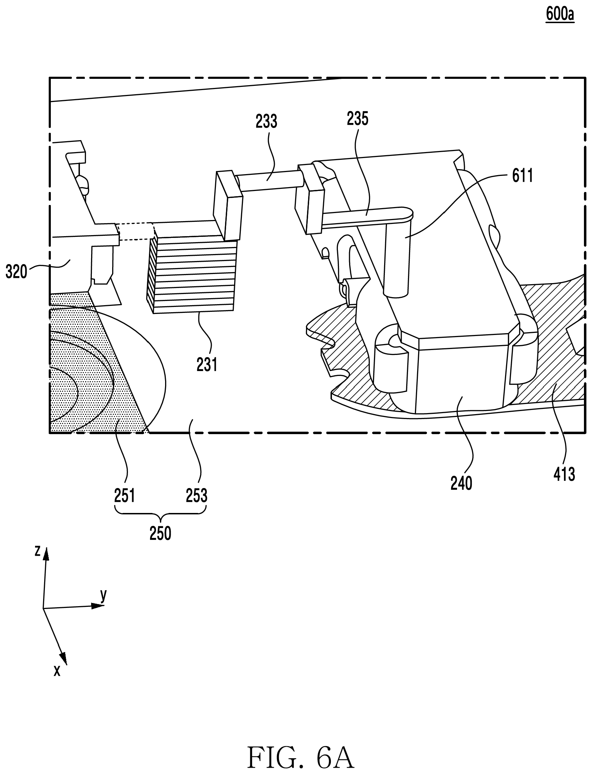

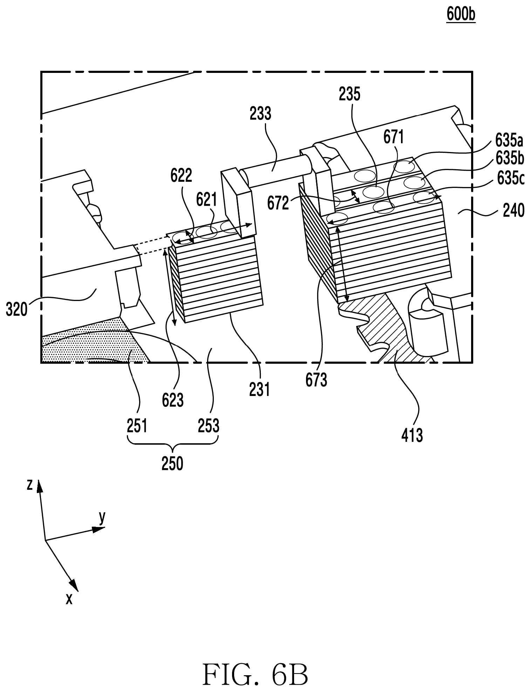

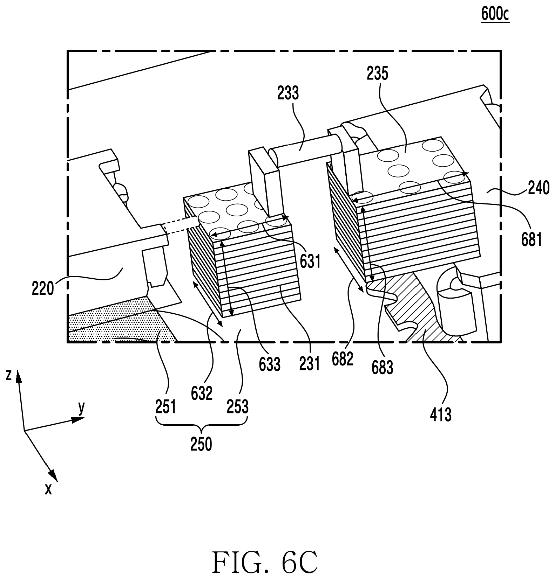

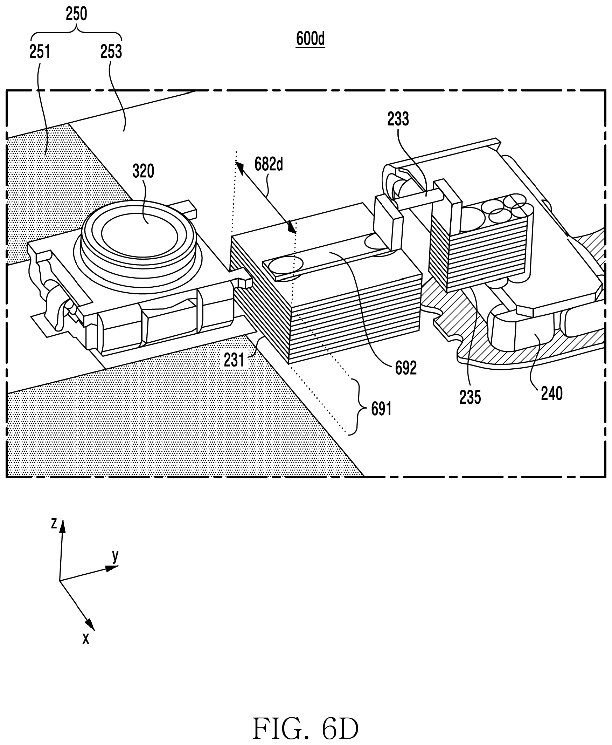

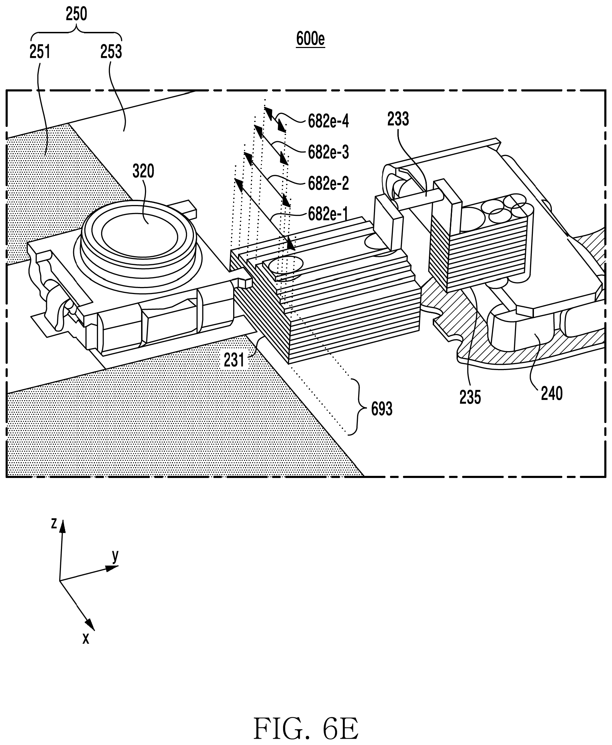

FIGS. 6A, 6B, 6C, 6D, and 6E illustrate an example of an antenna using a multilayer RF line structure. The same reference number may be used to indicate the same component and/or the same description.

Referring to FIG. 6A, an example 600a represents a feeding structure using a multilayer RF line structure. An electronic device 101 may include a feeding circuit 320. The feeding circuit 320 may be connected to an RF line structure 231 formed in a signal area 253 of a PCB 250. According to an embodiment, the electronic device 101 may include the RF line structure 231 as a component of the feeding structure. A feeding path including the RF line structure 231, impedance matching circuitry 233, and an RF line structure 235 may be used for transmission of an RF signal. The RF line structure 235 may be connected to a contact member 240. The RF signal may be provided to a conductive portion 203 through the contact member 240 and a conductive pad 413. According to an embodiment, the RF line structure 231 may include conductive lines (e.g., conductive lines 330 and conductive lines 350). The conductive lines may be used in the signal area 253 for signal transmission of the PCB 250. The RF line structure 235 may include a conductive line formed in a single layer. As an example, the conductive line of the RF line structure 235 may be disposed on a first side (e.g., a side facing a (+)z-axis) of the PCB. The impedance matching circuitry 233 may be disposed between the RF line structure 231 and the RF line structure 235. At least one component of the impedance matching circuitry 233 may be disposed on the first side (e.g., the side facing the (+)z-axis) of the PCB 250. The RF line structure 235 may include a via 611. The conductive line of the RF line structure 235 may be connected to the contact member 240 through the via 611.

Referring to FIG. 6B, an example 600b represents a feeding structure using a multilayer RF line structure. The example 600b indicates the feeding structure using the multilayer RF line structure. The electronic device 101 may include the feeding circuit 320. The feeding circuit 320 may be connected to the RF line structure 231 formed in the signal area 253 of the PCB 250. According to an embodiment, the electronic device 101 may include an RF line structure (e.g., the RF line structure 231 or the RF line structure 235) as a component of the feeding structure. A feeding path including the RF line structure 231, the impedance matching circuitry 233, and the RF line structure 235 may be used for transmission of an RF signal. The RF line structure 235 may be connected to the contact member 240. The RF signal may be provided to the conductive portion 203 through the contact member 240 and the conductive pad 413.

According to an embodiment, the RF line structure 231 may include conductive lines (e.g., the conductive lines 330). Since a separate copper layer for signal transmission of the PCB 250 is not included in the signal area 253, the conductive lines may be used. The conductive lines may have the same shape. For example, a shape of each conductive line of the conductive lines may have a length 621 and a width 622 on a plane (e.g., an xy plane). The conductive lines may be stacked in an axis (e.g., a z-axis direction). As the conductive lines are stacked, the RF line structure 231 may have a thickness 623. According to an embodiment, the RF line structure 235 may include conductive lines. Since a separate copper layer is not included in the signal area 253 for signal transmission of the PCB 250, the conductive lines may be used. The conductive lines may have the same shape. For example, a shape of each conductive line of the conductive lines may have a length 671 and a width 672 on a plane (e.g., the xy plane). The conductive lines may be stacked in an axis (e.g., the z-axis direction). As the conductive lines are stacked, the RF line structure 235 may have a thickness 673. As a non-limiting example, the length 621, the width 622, and/or the thickness 623 of the RF line structure 231 may be independent of the length 671, the width 672, and/or the thickness 673 of the RF line structure 235, respectively.

According to an embodiment, the conductive lines (e.g., the conductive lines 350) of the RF line structure 235 may further include conductive lines disposed in different areas on a plane (the xy plane) as well as stacked conductive portions. For example, the RF line structure 235 may include a first set 635a of conductive lines, a second set 635b of conductive lines, and/or a third set 635c of conductive lines. The first set 635a of conductive lines may include conductive lines stacked in a direction (e.g., the z-axis direction) on a first area of a plane (e.g., the xy plane). The second set 635b of conductive lines may include conductive lines stacked in a direction (e.g., the z-axis direction) on a second area of a plane (e.g., the xy plane). The second area may be different from the first area. The second area may be adjacent to the first area. The third set 635c of conductive lines may include conductive lines stacked in a direction (e.g., the z-axis direction) on the third area of a plane (e.g., the xy plane). The third area may be different from the first area and the second area. The third area may be adjacent to the second area. Composite impedance for conductive lines may be further reduced through parallel connection in a horizontal direction as well as parallel connection in a vertical direction.

Referring to FIG. 6C, an example 600c represents a feeding structure using a multilayer RF line structure. The electronic device 101 may include the feeding circuit 320. According to an embodiment, the electronic device 101 may include an RF line structure (e.g., the RF line structure 231 or the RF line structure 235) as a component of the feeding structure. A feeding path including the RF line structure 231, the impedance matching circuitry 233, and the RF line structure 235 may be used for transmission of an RF signal. The RF line structure 235 may be connected to the contact member 240. The RF signal may be provided to the conductive portion 203 through the contact member 240 and the conductive pad 413. Unlike the structure of the example 600b in which each set that conductive lines (e.g., the conductive lines 330 or the conductive lines 350) are stacked is disposed in parallel on the xy plane, each RF line structure in the example 600c may be implemented in a block unit. In order to provide lower impedance than an RF line formed in a single layer as a path for transmitting an RF signal, an RF line structure may have a shape that is thickened in a direction (e.g., the z-axis direction). For example, the first RF line structure 231 may include a conductive block having a length 631 and a width 632 on a plane (e.g., the xy plane) and a thickness 633 on an axis (e.g., a z-axis). For example, the second RF line structure 235 may include a conductive block having a length 681 and a width 682 on a plane (e.g., the xy plane) and a thickness 683 on an axis (e.g., the z-axis). As a non-limiting example, the length 631, width 632, and/or thickness 633 of the conductive block of the RF line structure 231 may be independent of the length 681, width 682, and/or thickness 683 of the conductive block of the RF line structure 235, respectively.

Referring to FIG. 6D, an example 600d represents a feeding structure using a multilayer RF line structure. The electronic device 101 may include a PCB 250. The PCB 250 may include a ground area 251 and a signal area 253. The electronic device 101 may include a feeding circuit 320. At least a portion of the feeding circuit 320 may be disposed on the ground area 251 of the PCB 250. The feeding circuit 320 may be electrically connected to a processor (e.g., processor (120)). For example, the feeding circuit 320 may be connected to an RF line structure 231 formed in a signal area 253 of a PCB 250. According to an embodiment, the electronic device 101 may include the RF line structure (e.g., the RF line structure 231, or the RF line structure 235) as a component of the feeding structure. A feeding path including the RF line structure 231, impedance matching circuitry 233, and an RF line structure 235 may be used for transmission of an RF signal. The RF line structure 235 may be connected to a contact member 240. The RF signal may be provided to a conductive portion 203 through the contact member 240 and a conductive pad 413.

In order to provide a lower impedance than an RF line formed in a single layer as a path for transmitting an RF signal, the RF line structure (e.g., the RF line structure 231 or the RF line structure 235) may have a shape that is thickened in one direction (e.g., the z-axis direction). For example, the first RF line structure 231 may include a conductive block having a width (682d) in one plane (e.g., the xy plane) and in which a plurality of conductive lines are stacked in one axis (e.g., the z-axis). According to an embodiment, the conductive lines (e.g., the conductive lines 350) of the RF line structure 231 may be formed across layers 691 other than the top layer 692 of the PCB 250. The layers 691 are layers disposed below the top layer 692, and for example, the conductive lines may be disposed to be embedded within the PCB 250. The RF line structure 231 may correspond to a wiring structure having a shape that escapes the top layer 692. In order to prevent and/or mitigate damage (e.g., cracks due to a pressing structure, damage due to external electrical component) and/or performance degradation (e.g., electromagnetic interference, interference due to external electrical component) caused by external components (e.g., a rear plate, a rear structure), the conductive lines may be formed in the layers 691. As a non-limiting example, although not illustrated in FIG. 6D, the conductive lines may be formed in the layers 691, and a structure for electromagnetic shielding (e.g., a shield can) may be placed in the top layer 692.

Referring to FIG. 6E, an example 600e represents a feeding structure using a multilayer RF line structure. The electronic device 101 may include a PCB 250. The PCB 250 may include a ground area 251 and a signal area 253. The electronic device 101 may include a feeding circuit 320. At least a portion of the feeding circuit 320 may be disposed on the ground area 251 of the PCB 250. The feeding circuit 320 may be electrically connected to a processor (e.g., processor (120)). For example, the feeding circuit 320 may be connected to an RF line structure 231 formed in a signal area 253 of a PCB 250. According to an embodiment, the electronic device 101 may include the RF line structure (e.g., the RF line structure 231, or the RF line structure 235) as a component of the feeding structure. A feeding path including the RF line structure 231, impedance matching circuitry 233, and an RF line structure 235 may be used for transmission of an RF signal. The RF line structure 235 may be connected to a contact member 240. The RF signal may be provided to a conductive portion 203 through the contact member 240 and a conductive pad 413.

In order to provide a lower impedance than an RF line formed in a single layer as a path for transmitting an RF signal, the RF line structure (e.g., the RF line structure 231 or the RF line structure 235) may have a shape that is thickened in one direction (e.g., the z-axis direction). According to an embodiment, the first RF line structure 231 may include a conductive block including conductive lines having different widths. The conductive lines 693 of the conductive block may be stacked on one axis (e.g., the z-axis). For example, the first RF line structure 231 may include conductive lines stacked in a pyramid shape. The width may gradually increase from an upper layer to a lower layer. For example, the first RF line structure 231 may include a conductive block in which a conductive line corresponding to a first width 682e-1, a conductive line corresponding to a second width 682e-2 wider than the first width 682e-1, a conductive line corresponding to a third width 682e-3 wider than the second width 682e-2), and a conductive line corresponding to a fourth width 682e-4 wider than the third width 682e-3 are sequentially stacked. The width of the conductive line may provide an electrical characteristic (e.g., inductance) corresponding to the width. Since the width of the conductive line is designed differently in each layer, the inductance required for the first RF line structure 231 may be provided within a limited space.

The RF line structure according to embodiments of the present disclosure may further reduce the composite impedance of the conductive lines through parallel connections in the horizontal direction as well as in the vertical direction. For example, to efficiently utilize space within a plane (e.g., xy plane) within a PCB 250 and reduce composite impedance, a feed structure (i.e., a hybrid structure) including conductive lines that are connected in parallel in the horizontal direction (e.g., xy plane) and stacked in the vertical direction (e.g., z-axis direction) may be utilized. For example, an RF line structure may include one conductive line disposed in a first layer and two conductive lines that are arranged in parallel in a second layer different from the first layer. Since all of the conductive lines are electrically connected in parallel, the overall composite impedance may be lower than the individual impedance.

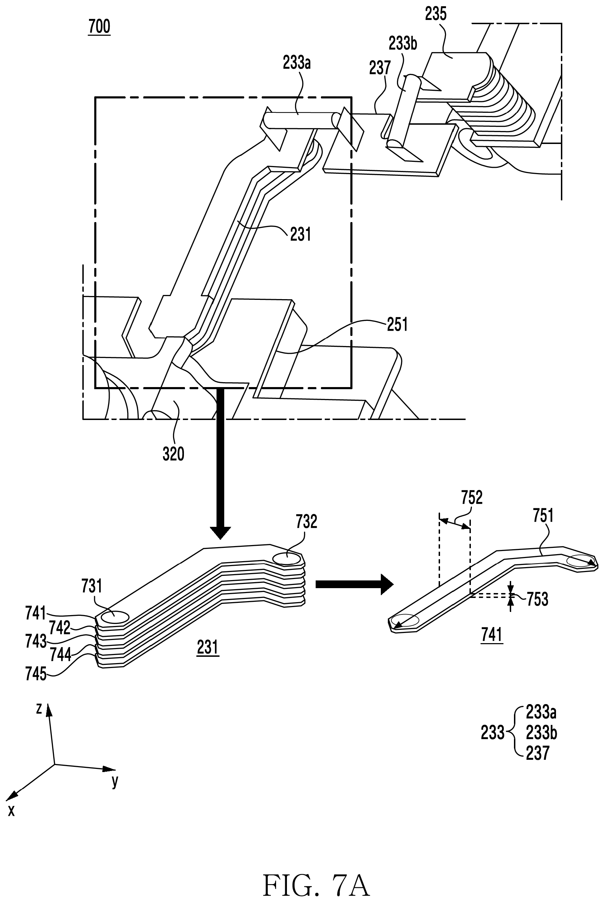

FIG. 7A illustrates an example of a conductive pattern of a multilayer RF line structure. The same reference number may be used to indicate the same component and/or the same description. In an RF line structure, a conductive line may have various shapes in addition to a shape having a quadrangular cross section exemplified through the above-described drawings. For example, as exemplified in FIG. 7A, it may have a shape having a polygon on a plane (e.g., an xy plane). As a non-limiting example, the polygon may have a curved length direction on a plane.

Referring to FIG. 7A, an example 700 indicates a feeding structure using a multilayer RF line structure. An electronic device 101 may include a feeding circuit 320. The feeding circuit 320 may be connected to an RF line structure 231 formed in a fill-cut area (e.g., a signal area 253) of a PCB 250. A feeding path including the RF line structure 231, impedance matching circuitry 233, and an RF line structure 235 may be used for transmission of an RF signal. For example, the impedance matching circuitry 233 may include a first component 233a, a second component 233b, and a conductive line 237 for connecting the first component 233a and the second component 233b. The first component 233a may be an inductor, a capacitor, or a register. The second component 233b may be an inductor, a capacitor, or resistance. The first component 233a may be connected to the RF line structure 231. The second component 233b may be connected to the RF line structure 235. The RF line structure 235 may be connected to a contact member 240. The RF signal may be provided to a conductive portion 203 through the contact member 240 and a conductive pad 413. According to an embodiment, the RF line structure 231 may include conductive lines (e.g., conductive lines 330).

The RF line structure 231 may include the conductive lines (e.g., the conductive lines 330) stacked in a direction (e.g., a z-axis direction). For example, the RF line structure 231 may include a first conductive line 741, a second conductive line 742, a third conductive line 743, a fourth conductive line 744, and a fifth conductive line 745. The conductive lines of the RF line structure 231 may have substantially the same shape. Each of the conductive lines of the RF line structure 231 may include a first end portion adjacent to the feeding circuit 320 of the feeding circuit 320 and the impedance matching circuitry 233, and a second end portion adjacent to the impedance matching circuitry 233 of the feeding circuit 320 and the impedance matching circuitry 233. The first end portion of the conductive lines of the RF line structure 231 may be coupled to a first conductive via 731. The second end portion of the conductive lines of the RF line structure 231 may be coupled to a second conductive via 732.

One conductive line (e.g., the first conductive line 741) may function as an inductor. For example, a shape of the first conductive line 741 may have a length 751, a width 752, and a thickness 753. The length 751, the width 752, and the thickness 753 may be used to determine inductance of the first conductive line 741. The inductance may be proportional to a length of a conducting wire, while inversely proportional to a cross-sectional area. For example, as the length 751 increases, the inductance may increase. As the width 752 is reduced, the inductance may increase. As conductive lines are coupled through conductive vias (e.g., the first conductive via 731 and the second conductive via 732), inductance of inductors may be synthesized in a parallel connection structure. Since composite inductance becomes smaller than inductance of an individual inductor in the parallel connection structure, inductance of an RF line structure may be reduced.

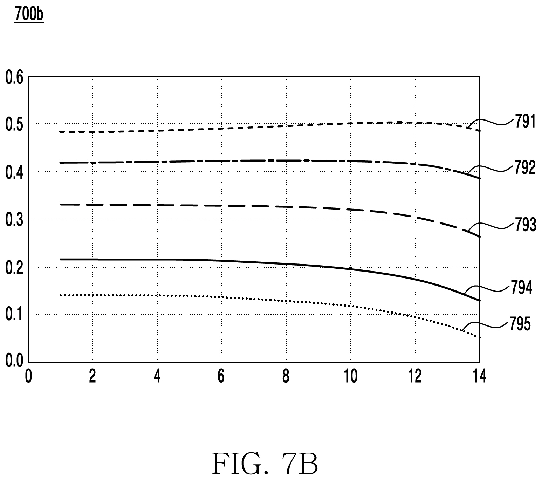

FIG. 7B illustrates an example of impedance of a multilayer RF line structure.

Referring to FIG. 7B, a graph 700b indicates inductance for each frequency. A horizontal axis of the graph 700b indicates a frequency (unit: GHz), and a vertical axis of the graph 700b indicates an inductance value (unit: nH). In the graph 700b, inductance that varies according to how many conductive lines exemplified in FIG. 7A are stacked is illustrated. As an example, a length 751 of one conductive line may be about 1.3 mm. As an example, a width 752 of one conductive line may be about 0.15 mm. As an example, a thickness 753 of one conductive line may be about 0.02 mm. As an example, when conductive portions are stacked, a width of a conductive via coupled to the conductive portions may be about 0.1 mm. A first line 791 indicates inductance of one conductive line. A second line 792 indicates inductance of an RF line structure in which three conductive lines are stacked. A third line 793 indicates inductance of an RF line structure in which five conductive lines are stacked. A fourth line 794 indicates inductance of an RF line structure in which seven conductive lines are stacked. A fifth line 795 indicates inductance of an RF line structure in which nine conductive lines are stacked. Through the graph 700b, it may be confirmed that inductance is reduced through stacking of multiple conductive lines.

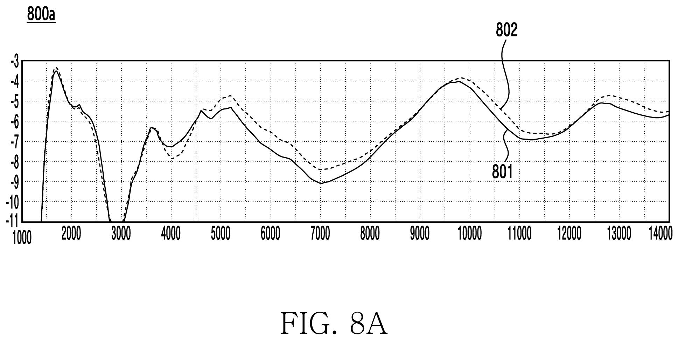

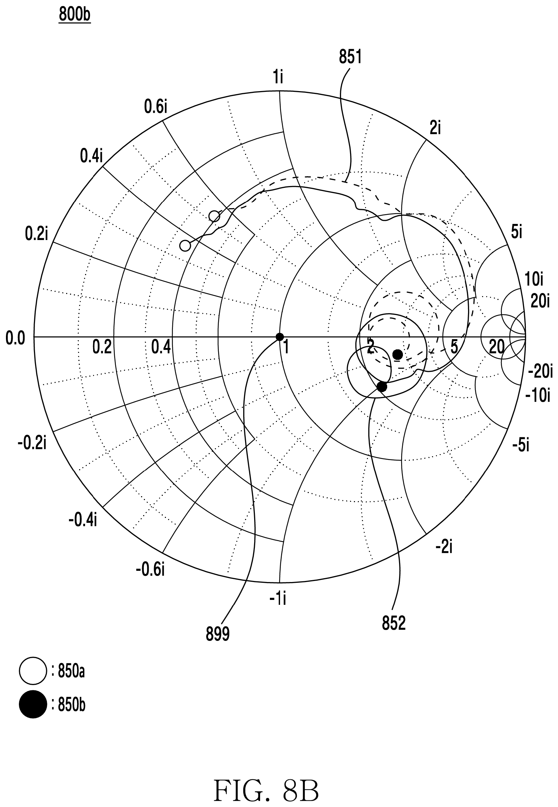

FIGS. 8A and 8B illustrate an example of performance of a multilayer RF line structure. As the performance, total efficiency of an antenna may be used. The total efficiency may indicate a ratio of an actual radiated power of total power transmitted by the antenna.

Referring to FIG. 8A, a graph 800a indicates total efficiency for each frequency. A horizontal axis of the graph 800a indicates a frequency (unit: MHz), and a vertical axis of the graph 800a indicates total efficiency (unit: dB). A first line 801 indicates total efficiency of an antenna when both an RF line structure 231 and an RF line structure 235 are single-layer conductive lines. A second line 802 indicates total efficiency of an antenna using the RF line structure 231 and the RF line structure 235 of the example 500a of FIG. 5A. Referring to the graph 800a, it may be confirmed that total efficiency is improved through the RF line structure 231 and the RF line structure 235 in which multiple conductive lines are stacked.

Referring to FIG. 8B, a Smith chart 800b represents impedance (unit: ohm) for each frequency. The impedance may indicate a value normalized based on 50 ohms and may be used to calculate a reflection coefficient (e.g., S₁₁). Each concentric circle of the Smith chart 800b may indicate points in which a real number portion (e.g., a resistance portion) of impedance is the same. Each line of the Smith chart 800b indicates impedance according to a frequency change from a first frequency 850a (e.g., about 5 GHz) to a second frequency 850b (e.g., about 14 GHz). The first line 851 indicates impedance when both the RF line structure 231 and the RF line structure 235 are the single-layer conductive lines. The second line 852 indicates impedance of a feeding structure including the RF line structure 231 and the RF line structure 235 of the example 500a of FIG. 5A. Referring to the Smith chart 800b, it may be confirmed that impedance is formed close to a center point 899 (e.g., 1 ohm) for impedance matching through the RF line structure 231 and the RF line structure 235 in which multiple conductive lines are stacked. It may be confirmed that an impedance change is relatively small, since a size of inductance applied to a path through which a signal is fed is reduced even if it has the same length of an RF line.

An RF line structure (e.g., the RF line structure 231 or the RF line structure 235) positioned in a fill-cut area (e.g., a signal area 253) of a PCB 250, lumped components (e.g., an inductor or a capacitor of impedance matching circuitry 233), and/or contact structure(s) (e.g., a contact member 240 or a conductive pad 413) may be understood as a component of an antenna. For efficient impedance matching of a radiator (e.g., a conductive portion 203) for multiple frequency bands, it may be required to reduce influence due to structurally occurring inductance. In order to reduce the influence of the structurally occurring inductance, a line structure according to embodiments of the present disclosure may include conductive lines that are disposed in a stacked manner to reduce inductance.

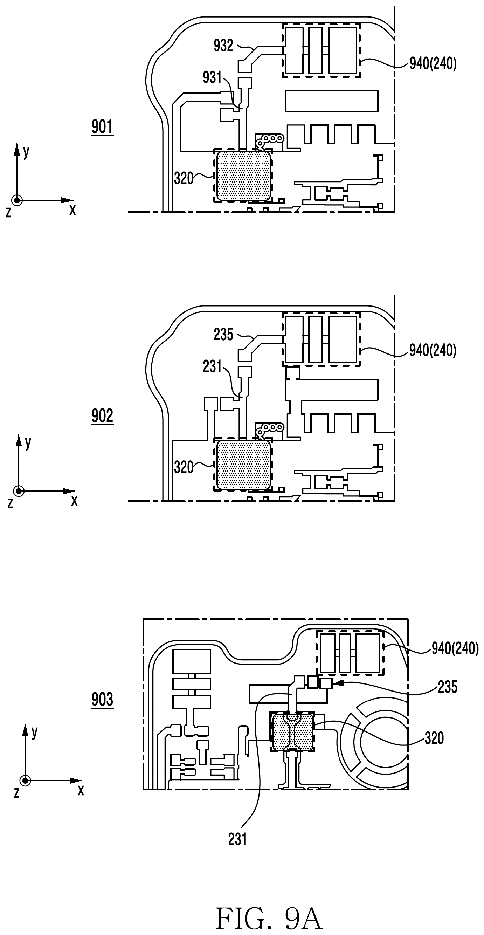

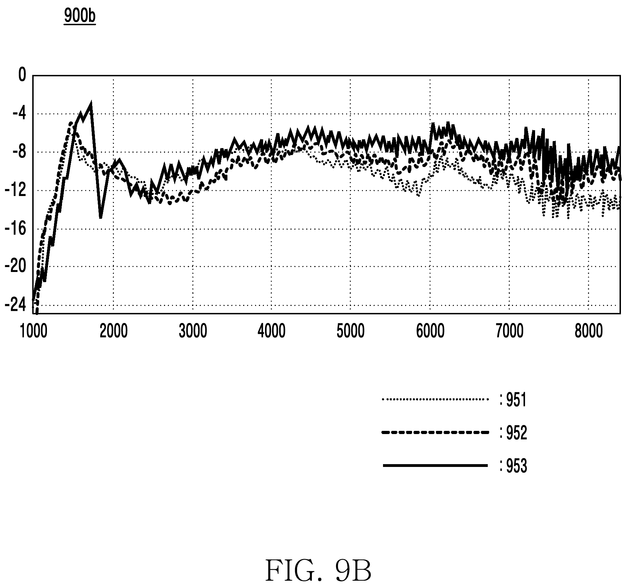

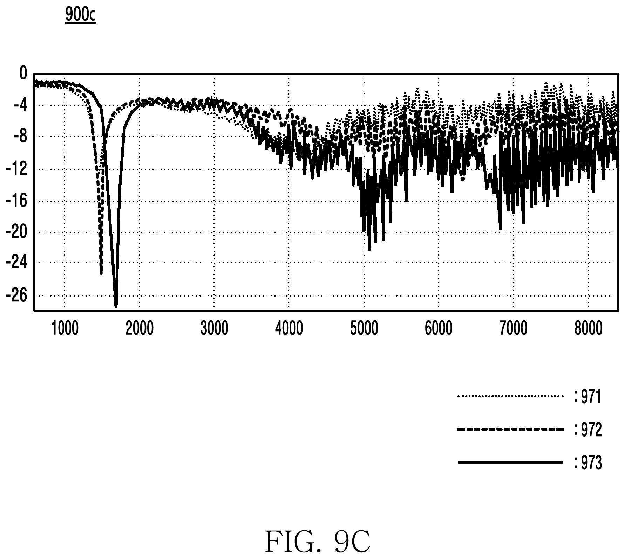

FIGS. 9A, 9B, and 9C illustrate an example of performance of a multilayer RF line structure. The same reference number may be used to indicate the same component and/or the same description.

Referring to FIG. 9A, in an example 901, an electronic device 101 may include a feeding circuit 320, a first RF line 931, a second RF line 932, and a contact portion 940 (e.g., a contact member 240). The first RF line 931 and the second RF line 923 may be formed above a layer of a PCB (e.g., a PCB 250). The second RF line 923 may be connected to a contact member of the contact portion 940 through a via. A sum of a length of the first RF line 931, a length of the second RF line 923, and a length of the via may be about 4.5 mm.

In an example 902 according to an embodiment of the present invention, the electronic device 101 may include the feeding circuit 320, an RF line structure 231, an RF line structure 235, and the contact portion 940 (e.g., the contact member 240). According to an embodiment, the RF line structure 231 may include a conductive line disposed on each layer of at least two of multiple layers of the PCB 250 in a signal area 253 between a metal frame 200 and a ground area 251. The conductive lines may be stacked in a direction (e.g., a z-axis direction). Each of the conductive lines may be used as a path through which an RF signal of the feeding circuit 320 is transmitted. The RF signal may be provided to the RF line structure 235 through each conductive line. As a non-limiting example, the RF signal may be provided to the RF line structure 235 through impedance matching circuitry (e.g., impedance matching circuitry 233). The RF line structure 235 may include a conductive line disposed on each layer of at least two of multiple layers of the PCB 250 in the signal area 253 between the metal frame 200 and the ground area 251. The conductive lines may be stacked in a direction (e.g., the z-axis direction). Each of the conductive lines may be used as a path through which the RF signal of the feeding circuit 320 is transmitted. The RF signal may be provided to the contact member 240 through each conductive line. A sum of a length (e.g., a length on an xy plane) of the RF line structure 231, a length (e.g., a length on the xy plane) of the RF line structure 235, and a length of the via may be about 4.5 mm.

In an example 903 according to an embodiment of the present invention, the electronic device 101 may include the feeding circuit 320, the RF line structure 231, the RF line structure 235, and the contact portion 940 (e.g., the contact member 240). The descriptions of the example 902 may be referenced for the RF line structure 231, the RF line structure 235, and the contact portion 940. In the example 903, the RF line structure 231 and the RF line structure 235 illustrated in FIG. 7A may be used. A distance between a feeding unit (e.g., the feeding circuit 320) and a contact unit (e.g., the contact portion 940) in the example 903 may be shorter than a distance between a feeding unit and a contact unit in the example 902. A required length of an RF line may be shortened. For example, a sum of a length of the RF line structure 231 on a plane (e.g., the xy plane) and a length of the RF line structure 235 on a plane (e.g., the xy plane) in the example 903 may be shorter than a sum of a length of the RF line structure 231 on a plane (e.g., the xy plane) and a length of the RF line structure 235 on a plane (e.g., the xy plane) in the example 902. As an example, in the example 903, a sum of the length (e.g., the length on the xy plane) of the RF line structure 231, the length (e.g., the length on the xy plane) of the RF line structure 235, and the length of the via may be about 2.9 mm.

Referring to FIG. 9B, a graph 900b indicates total radiation efficiency for each frequency. A horizontal axis of the graph 900b indicates a frequency (unit: MHz), and a vertical axis of the graph 900b indicates total radiation efficiency (unit: dB). A first line 951 indicates total radiation efficiency in a feeding structure of the example 901. A second line 952 indicates total radiation efficiency in a feeding structure of the example 902. A third line 953 indicates total radiation efficiency in a feeding structure of the example 903. Referring to the graph 900b, it may be confirmed that an RF line structure using conductive lines of multiple layers provides higher total radiation efficiency than a conductive line of a single layer. Referring to the graph 900b, it may be confirmed that total radiation efficiency increases as a distance between the feeding unit (e.g., the feeding circuit 320) and the contact unit (e.g., the contact portion 940) becomes closer. As an example, as inductance due to a length of an RF line is reduced in the feeding structure of the example 903, impedance matching may be performed better than another structure (e.g., the feeding structure of the example 901 and the feeding structure of the example 902) in a high frequency band (e.g., a frequency band of about 3 GHz or above) (i.e., matching efficiency may be higher).

Referring to FIG. 9C, a graph 900c indicates a reflection coefficient for each frequency. A horizontal axis of the graph 900c indicates a frequency (unit: MHz), and a vertical axis of the graph 900c indicates a reflection coefficient (unit: dB). A first line 971 indicates a reflection coefficient in the feeding structure of the example 901. A second line 972 indicates a reflection coefficient in the feeding structure of the example 902. A third line 973 indicates a reflection coefficient in the feeding structure of the example 903. As a reflection coefficient is reduced, power loss is reduced, and more power may be transmitted. In other words, as the reflection coefficient is reduced, matching efficiency may be increased. Referring to the graph 900c, it may be confirmed that an RF line structure using conductive lines of multiple layers has a lower reflection coefficient than a conductive line of a single layer. Referring to the graph 900c, it may be confirmed that a reflection coefficient is reduced as a distance between the feeding unit (e.g., the feeding circuit 320) and the contact unit (e.g., the contact portion 940) becomes closer.

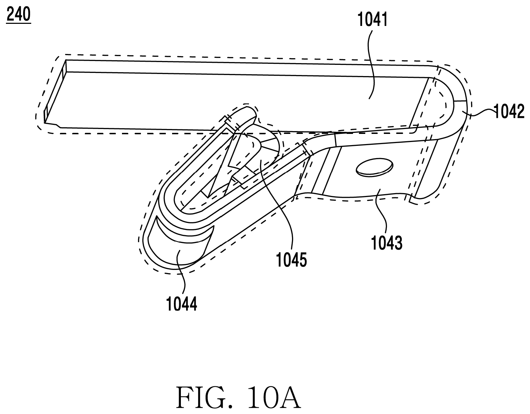

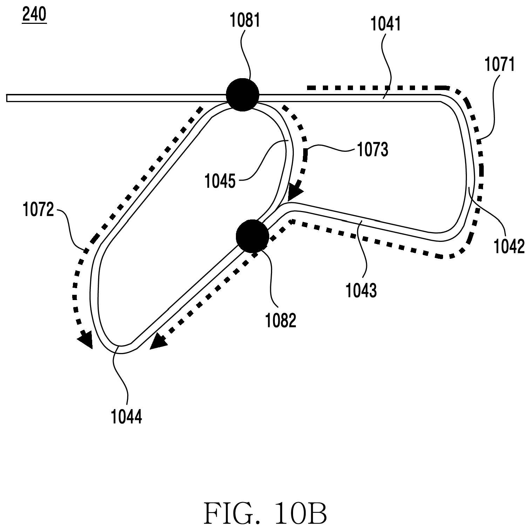

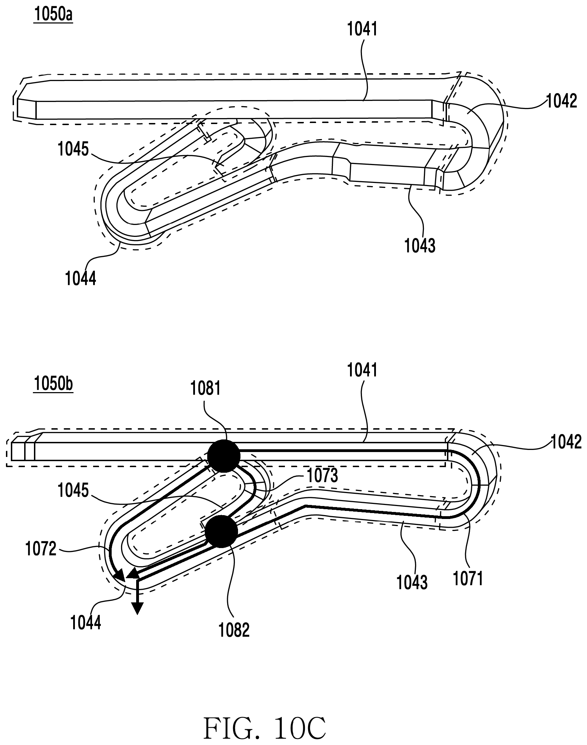

FIGS. 10A, 10B, and 10C illustrate an example of a contact member (e.g., a contact member 240) having multiple contact points.

Referring to FIG. 10A, the contact member 240 according to an embodiment may include a support portion 1041, an elastic portion 1042, a connecting portion 1043, a first bending portion 1044, and a second bending portion 1045. The support portion 1041 may include a supporting side for coupling the contact member 240 to one side of a component (e.g., a PCB 250). The elastic portion 1042 may include a material having elasticity. The elastic portion 1042 may be formed by extending from the support portion 1041. The connecting portion 1043 may be disposed to be connected to the elastic portion 1042 and spaced apart from the supporting side of the support portion 1041. The connecting portion 1043 may be formed by extending from the elastic portion 1042. The first bending portion 1044 may be connected to the connecting portion 1043 and have a curved shape. As an example, the connecting portion 1043 may be formed in a direction away from the supporting side of the support portion 1041. The first bending portion 1044 may have a curved shape by extending from the connecting portion 1043. The curved shape may be formed to face the supporting side of the support portion 1041 after bending. The second bending portion 1045 may be connected to the first bending portion 1044, and may have a curved shape. As an example, a portion of the first bending portion 1044 may be formed in a direction toward the supporting side of the support portion 1041. The second bending portion 1045 may have a shape curved in a direction different from a portion of the first bending portion 1044 by extending from the portion of the first bending portion 1044 or being coupled to the portion of the first bending portion 1044. The second bending portion 1045 may be coupled, connected, or in contact with the portion of the first bending portion 1044 and a portion of the connecting portion 1043. The curved shape may be formed to face the connecting portion 1043 (or the first bending portion 1044) after bending.

Referring to FIG. 10B, the contact member 240 may have multiple contact points when pressure is applied to the contact member 240. According to an embodiment, the first bending portion 1044 may be configured to contact a point (e.g., a first contact point 1081) of the support portion 1041 while pressure is applied to the contact member 240. According to an embodiment, the second bending portion 1045 may be configured to contact a point (e.g., a second contact point 1082) of the connecting portion 1043 (or the first bending portion 1044) while pressure is applied to the contact member 240.

According to an embodiment, the contact member 240 may be disposed on one side of the PCB 250. The contact member 240 may contact a portion (e.g., a protruding portion 231) of a conductive portion 203 that functions as an antenna radiator of the metal frame 200 or a component (e.g., a conductive pad 413) connected to the conductive portion 203 through pressing pressure (e.g., pressure in a z-axis direction). As an example, an area of the first bending portion 1044 of the contact member 240 may contact the portion (e.g., the protruding portion 231) of the conductive portion 203 or a component (e.g., the conductive pad 413) connected to the conductive portion 203. The contact member 240 may provide an RF signal to the conductive portion 203 due to the contact. When performing the contact, the contact member 240 may have the multiple contact points. As the contact member 240 has the multiple contact points, multiple paths for the RF signal may be formed in the contact member 240. For example, the multiple paths may include a first path 1071 using the support portion 1041, the elastic portion 1042, and the connecting portion 1043. For example, the multiple paths may include a second path 1072 using the support portion 1041 and the first bending portion 1044. Through the first contact point 1081, the RF signal may flow directly from the support portion 1041 to the first bending portion 1044. For example, the multiple paths may include a third path 1073 using the support portion 1041 and the second bending portion 1045. Through the first contact point 1081 and the second contact point 1082, the RF signal may flow from the support portion 1041, through the second bending portion 1045, to the connecting portion 1043 and the first bending portion 1044.

Referring to FIG. 10C, an example 1050a indicates a disposition of each component (e.g., the support portion 1041, the elastic portion 1042, the connecting portion 1043, the first bending portion 1044, and the second bending portion 1045) while pressing pressure is applied to the contact member 240. The example 1050b indicates paths (e.g., the first path 1071, the second path 1072, or the third path 1073) using multiple contact points (e.g., the first contact point 1081 and the second contact point 1082) while pressing pressure is applied to the contact member 240.

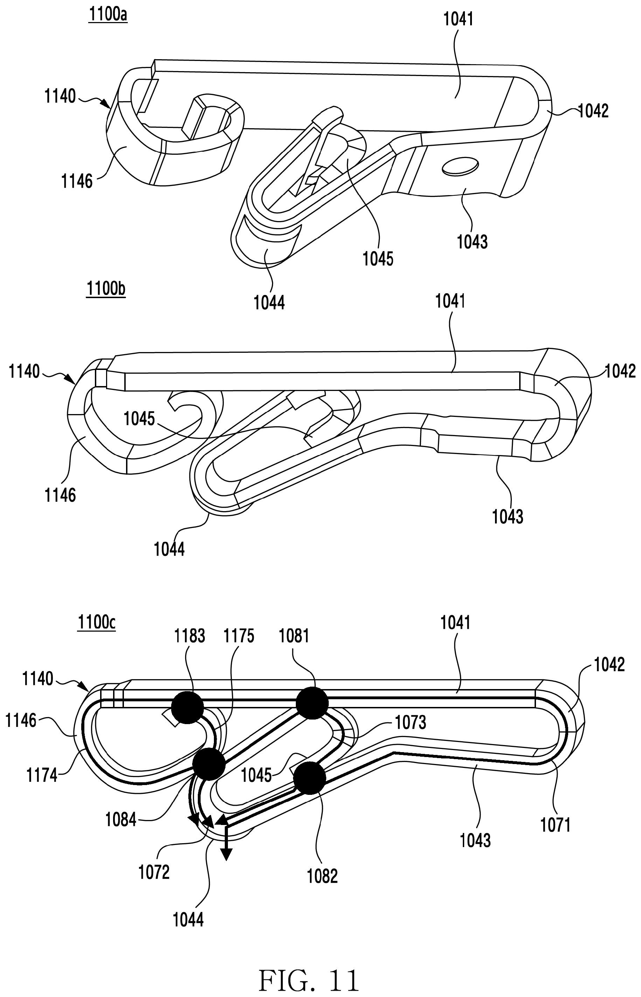

FIG. 11 illustrates an example of a contact member having multiple contact points. The same reference number may be used to indicate the same component and/or the same description. In FIG. 11, a contact member having four contact points is described.

Referring to FIG. 11, an example 1100a indicates a contact member 1140. The example 1100a indicates a shape of the contact member 1140 when pressure (e.g., pressure in a z-axis direction) is not applied to the contact member 1140. The contact member 1140 may include a support portion 1041, an elastic portion 1042, a connecting portion 1043, a first bending portion 1044, a second bending portion 1045, and a third bending portion 1046. The descriptions of FIGS. 10A to 10C may be referenced for the support portion 1041, the elastic portion 1042, the connecting portion 1043, the first bending portion 1044, and the second bending portion 1045. The third bending portion 1146 may be connected to the support portion 1041 and have a curved shape. For example, the third bending portion 1146 may be curved in a direction away from a supporting side of the support portion 1041 and then curved back in a direction closer to the supporting side. As an example, the third bending portion 1146 may extend from a side (e.g., a side opposite to a side to which the elastic portion 1042 is connected) of the support portion 1041 in a 'C'-shape or a 'G'-shape. A portion of the third bending portion 1146 may be formed of a material having elasticity.

An example 1100b indicates a disposition of each component (e.g., the support portion 1041, the elastic portion 1042, the connecting portion 1043, the first bending portion 1044, the second bending portion 1045, and the third bending portion 1146) while pressing pressure is applied to the contact member 1140. According to an embodiment, while pressing pressure is applied to the contact member 1140, the third bending portion 1146 may contact the support portion 1041. By the contact between the third bending portion 1146 and the support portion 1041, a third contact point 1183 may be formed. According to an embodiment, while pressing pressure is applied to the contact member 1140, the third bending portion 1146 may contact the first bending portion 1044. A fourth contact point 1184 may be formed by the contact between the third bending portion 1146 and the first bending portion 1044.

An example 1100c indicates paths (e.g., a first path 1071, a second path 1072, a third path 1073, a fourth path 1174, or a fifth path 1175) using multiple contact points (e.g., a first contact point 1081, a second contact point 1082, the third contact point 1183, or the fourth contact point 1184) while pressing pressure is applied to the contact member 1140. The descriptions of FIGS. 10A to 10C may be referenced for the first path 1071, the second path 1072, and the third path 1073. The fourth path 1174 indicates a path of an RF signal transmitted to the first bending portion 1044 through the fourth contact point 1184 along the third bending portion 1146 extending from the support portion 1041. The fifth path 1175 indicates a path of an RF signal transmitted from the third contact point 1183 at the support portion 1041 to the first bending portion 1044 through the fourth contact point 1184 along an end portion of the third bending portion 1146.

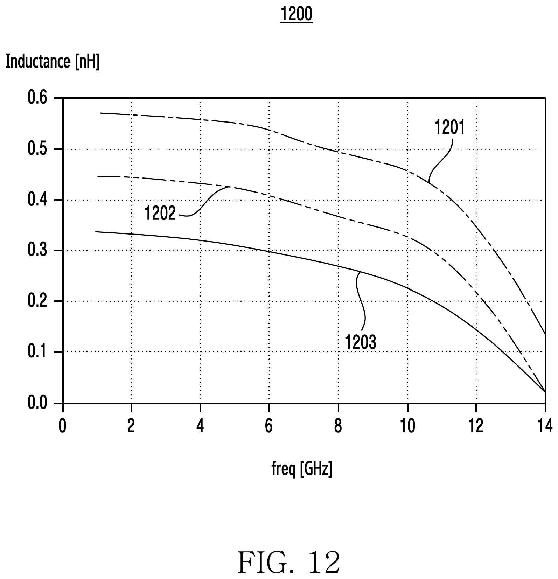

FIG. 12 illustrates an example of performance of a contact member having multiple contact points.

Referring to FIG. 12, a graph 1200 indicates inductance for each frequency. A horizontal axis of the graph 400d indicates a frequency (unit: GHz), and a vertical axis of the graph 1200 indicates an inductance value (unit: nH). In the graph 1200, inductance according to a structure of a contact member 240 is illustrated. When a contact member without the second bending structure 1045 in the contact member 240 of FIGS. 10A to 10C is pressed (e.g., when pressure is applied in a z-axis direction), a first line 1201 indicates inductance of the contact member. Since there is no second bending structure 1045, only a first contact point 1081 may be formed and a second contact point 1082 may not be formed. As an example, the number of contact points (e.g., the first contact point 1081) of a contact member 1140 may be one. The number of paths (e.g., a first path 1071 or a second path 1072) of the contact member 1140 may be two. A second line 1202 indicates inductance of the contact member 240 when the contact member 240 of FIGS. 10A to 10C is pressed (e.g., when pressure is applied in the z-axis direction). As an example, the number of contact points (e.g., the first contact point 1081 or the second contact point 1082) of the contact member 1140 may be two. The number of paths (e.g., the first path 1071, the second path 1072, or a third path 1073) of the contact member 1140 may be three. A third line 1203 indicates inductance of the contact member 1140 when the contact member 1140 of FIG. 11 is pressed (e.g., when pressure is applied in the z-axis direction). As an example, the number of contact points (e.g., the first contact point 1081, the second contact point 1082, a third contact point 1183, or a fourth contact point 1184) of the contact member 1140 may be four. The number of paths (e.g., the first path 1071, the second path 1072, the third path 1073, a fourth path 1174, or a fifth path 1175) of the contact member 1140 may be five.

Referring to the graph 1200, it may be confirmed that inductance is reduced as the number of contact points increases. Referring to the graph 1200, it may be confirmed that inductance is reduced as the number of paths increases. As more contact points are formed in a contact member, the number of paths for transmitting an RF signal may increase. It may be understood that a parallel connection of inductors increase as the number of paths increases. Therefore, when pressure is applied to a contact member, inductance of the contact member may be reduced as the number of contact points increases.

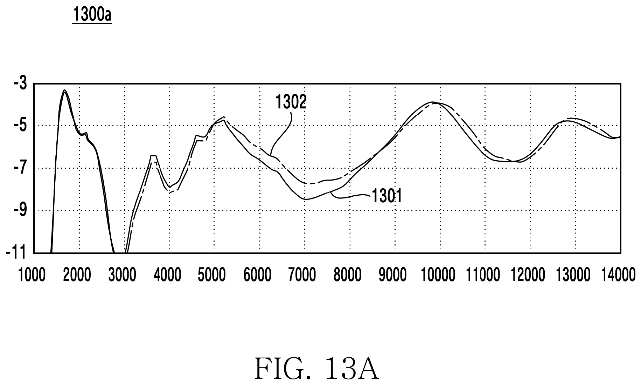

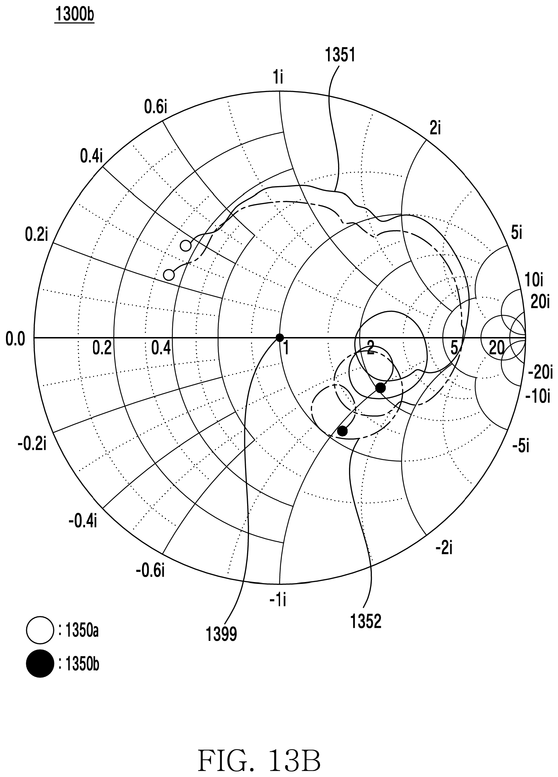

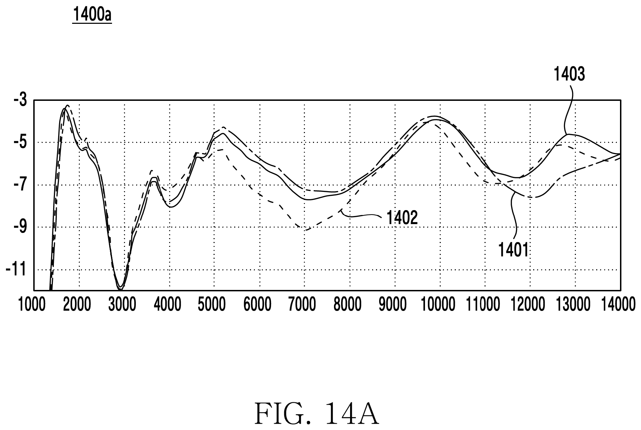

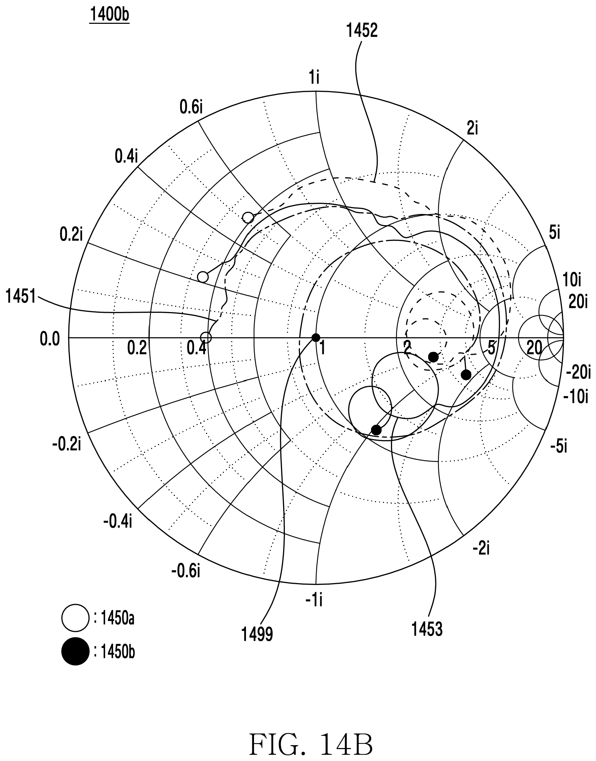

FIGS. 13A, 13B, 14A, and 14B illustrate an example of performance of a contact member (e.g., a contact member 240 of FIGS. 10A to 10C) having multiple contact points.

Referring to FIG. 13A, a graph 1300a indicates total efficiency for each frequency. A horizontal axis of the graph 1300a indicates a frequency (unit: MHz), and a vertical axis of the graph 1300a indicates total efficiency (unit: dB). A first line 1301 indicates total efficiency of an antenna using the RF line structure 231 and the RF line structure 235 of the example 500a of FIG. 5A. A second line 1302 indicates total efficiency of an antenna when the contact member 240 described in FIGS. 10A to 10C is used in the example 500a of FIG. 5A. Referring to the graph 1300a, it may be confirmed that total efficiency is improved due to an additional inductance reduction through the contact member 240 of FIGS. 10A to 10C.

Referring to FIG. 13B, a Smith chart 1300b indicates impedance (unit: ohm) for each frequency. The impedance may indicate a value normalized based on 50 ohms, and may be used to calculate a reflection coefficient (e.g., S₁₁). Each concentric circle of the Smith chart 1300b may indicate points in which a real number portion (e.g., a resistance portion) of impedance is the same. Each line of the Smith chart 1300b indicates impedance according to a frequency change from a first frequency 1350a (e.g., about 5 GHz) to a second frequency 1350b (e.g., about 14 GHz). A first line 1351 indicates impedance of a feeding structure including the RF line structure 231 and the RF line structure 235 of the example 500a of FIG. 5A, and the contact member having a contact point. For example, the contact member having the contact point may have a shape without a second bending structure 1045 in the contact member 240 of FIGS. 10A to 10C. A second line 1352 indicates impedance of a feeding structure including the RF line structure 231, and the RF line structure 235 of the example 500a of FIG. 5A, and the contact member 240 having multiple contact points (e.g., a first contact point 1081 and a second contact point 1082). Referring to the Smith chart 1300b, it may be confirmed that an impedance change is relatively small due to a low inductance size of the contact member 240 having the multiple contact points. Additionally, it may be confirmed that the second line 1352 is formed closer to a center point 1399 (e.g., 1 ohm) for impedance matching than the first line 1351.

Referring to FIG. 14A, a graph 1400a indicates total efficiency for each frequency. A horizontal axis of the graph 1400a indicates a frequency (unit: MHz), and a vertical axis of the graph 1400a indicates total efficiency (unit: dB). A first line 1401 indicates total efficiency of an antenna when performing an ideal feed without an RF line. A second line 1402 indicates total efficiency of an antenna using an RF line structure having one conductive line of a single layer and a connecting member having a single contact point. A third line 1403 indicates total efficiency of an antenna using the RF line structure 231 and the RF line structure 235 of the example 500a of FIG. 5A, and the contact member 240 of FIGS. 10A to 10C. Referring to the graph 1400a, it may be confirmed that total efficiency is improved through an RF line structure stacked across multiple layers and the contact member 240 of FIGS. 10A to 10C. The RF line structure stacked across multiple layers may be used to reduce composite inductance in a limited RF length. The multiple contact points of the contact member 240 of FIGS. 10A to 10C may form as many paths as possible in the contact member 240. Through the paths, inductance of the contact member 240 may be reduced.

Referring to FIG. 14B, a Smith chart 1400b indicates impedance (unit: ohm) for each frequency. The impedance may indicate a value normalized based on 50 ohms, and may be used to calculate a reflection coefficient (e.g., S₁₁). Each line of the Smith chart 1400b indicates impedance according to a frequency change from a first frequency 1450a (e.g., about 5 GHz) to a second frequency 1450b (e.g., about 14 GHz). A first line 1451 represents impedance when performing an ideal feed without an RF line. A second line 1452 indicates impedance of a feeding structure using an RF line structure having one conductive line of a single layer and a connecting member having a single contact point. A third line 1453 indicates impedance of a feeding structure using the RF line structure 231 and the RF line structure 235 of the example 500a of FIG. 5A, and the contact member 240 of FIGS. 10A to 10C. Referring to the Smith chart 1400b, it may be confirmed that the third line 1453 is formed closer to the first line 1451 than the second line 1452 due to a low inductance size. In addition, it may be confirmed that the third line 1453 is formed closer to a center point 1499 (e.g., 1 ohm) for impedance matching than the second line 1452.

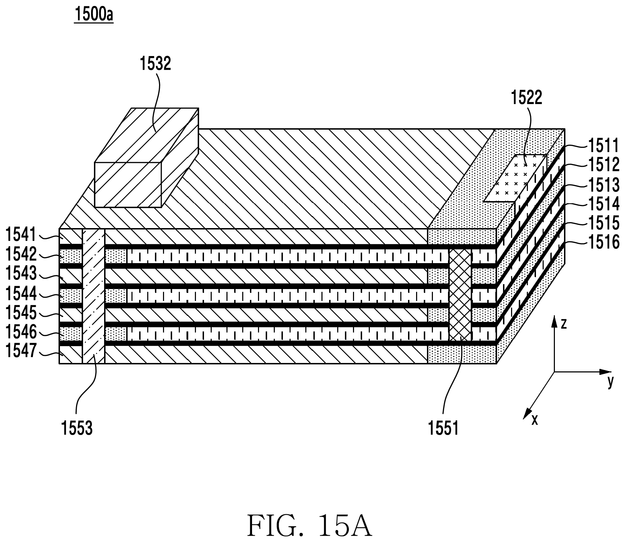

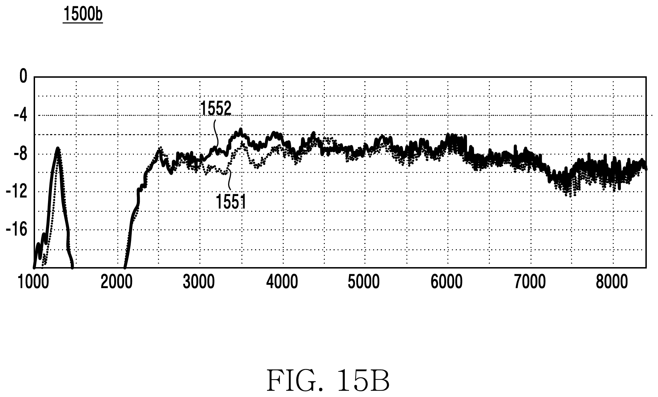

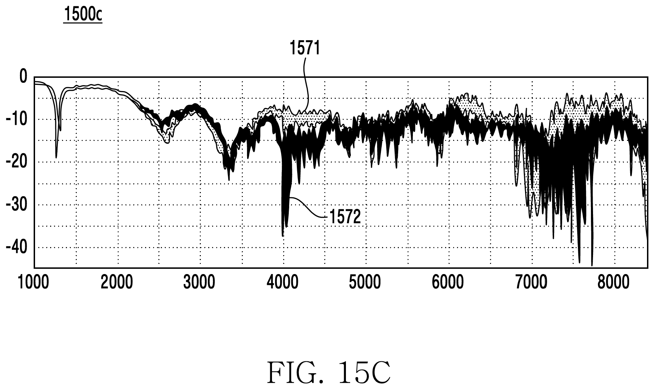

FIGS. 15A, 15B, and 15C illustrate an example of a structure and performance of an antenna using a multilayer RF line structure and a metal-insulator-metal stacked structure. The metal-insulator-metal stacked structure may be referred to as a MIM structure.

Referring to FIG. 15A, the MIM structure may be formed between a feeding area 1522 and a contact area 1532. For example, the feeding area 1522 may include a point connected to a portion in which an RF signal is fed. As a non-limiting example, an RF signal passing through an RF line structure 231 may be provided to the feeding area 1522. The MIM structure may be understood as an example of an RF line structure 235. For example, the contact area 1532 may correspond to a contact member (e.g., a contact member 240 or a contact member 1140). A PCB 250 may include multiple conductive layers. A non-conductive layer (e.g., an insulating layer or a dielectric layer) may be disposed between adjacent conductive layers. For example, the PCB 250 may include a first conductive layer 1541, a second conductive layer 1542, a third conductive layer 1543, a fourth conductive layer 1544, a fifth conductive layer 1545, a sixth conductive layer 1546, and/or a seventh conductive layer 1547. As an example, a non-conductive layer 1511 may be disposed between the first conductive layer 1541 and the second conductive layer 1542. A non-conductive layer 1512 may be disposed between the second conductive layer 1542 and the third conductive layer 1543. A non-conductive layer 1513 may be disposed between the third conductive layer 1543 and the fourth conductive layer 1544. A non-conductive layer 1514 may be disposed between the fourth conductive layer 1544 and the fifth conductive layer 1545. A non-conductive layer 1515 may be disposed between the fifth conductive layer 1545 and the sixth conductive layer 1546. A non-conductive layer 1516 may be disposed between the sixth conductive layer 1546 and the seventh conductive layer 1547.

The multiple conductive layers of the PCB 250 may be distinguished into a first set of layers and a second set of layers. For example, the first set of layers may be odd-numbered layers of the PCB 250. As an example, the first set of layers may include the first conductive layer 1541, the third conductive layer 1543, the fifth conductive layer 1545, and/or the seventh conductive layer 1547. For example, the second set of layers may be even-numbered layers of the PCB 250. As an example, the second set of layers may include the second conductive layer 1542, the fourth conductive layer 1544, and/or the sixth conductive layer 1546. According to an embodiment, the first set of layers and the second set of layers may be arranged alternately. Each layer of the first set of layers of the PCB 250 may include a conductive plate. Each layer of the second set of layers of the PCB 250 may include a conductive plate. The conductive plates of the first set of layers of the PCB 250 may be connected to a first conductive via 1551. When the first conductive via 1551 penetrates the layers of the PCB 250, the first conductive via 1551 may not be connected to the conductive plates of the second set of layers of the PCB 250. The conductive plates of the second set of layers of the PCB 250 may be connected to a second conductive via 1553. When the second conductive via 1553 penetrates the layers of the PCB 250, the second conductive via 1553 may not be connected to the conductive plates of the first set of layers of the PCB 250.

The conductive plates of the first set of layers may be electrically connected through the first conductive via 1551. The conductive plates of the second set of layers may be electrically connected through the second conductive via 1553. The conductive plates of the first set of layers may be disposed not to contact the conductive plates of the second set of layers. At least a portion (e.g., a conductive plate of the second layer 1542) of the conductive plates of the second set of layers may be electrically connected to the feeding unit 1522. An RF signal of the feeding unit 1522 may be provided to each of the conductive plates of the second set of layers. The conductive plates of the second set of layers may be coupled to the conductive plates of the first set of layers. Through the coupling, RF signals may flow through the conductive plates of the first set of layers. The RF signals flowing through the conductive plates of the first set of layers may be provided to an antenna radiator (e.g., a conductive portion 203) through the contact area 1532.

Referring to FIG. 15B, a graph 1500b illustrates total radiation efficiency for each frequency. A horizontal axis of the graph 1500b indicates a frequency (unit: MHz), and a vertical axis of the graph 1500b represents total radiation efficiency (unit: dB). A first line 1551 indicates total radiation efficiency of an antenna using the RF line structure 231 including stacked conductive lines and the RF line structure 235 including a single conductive line. A second line 1552 indicates total radiation efficiency of an antenna using the RF line structure 231 including the stacked conductive lines and the MIM structure of FIG. 15A. Referring to the graph 1500b, it may be confirmed that the total radiation efficiency of the second line 1552 is higher than the total radiation efficiency of the first line 1551. It may be confirmed that total radiation efficiency of about 1 dB is improved through the MIM structure.

Referring to FIG. 15C, a graph 1500c indicates a reflection coefficient for each frequency. A horizontal axis of the graph 1500c indicates a frequency (unit: MHz), and a vertical axis of the graph 1500b indicates a reflection coefficient (unit: dB). A first line 1571 indicates a reflection coefficient in a feeding structure having the RF line structure 231 including the stacked conductive lines and the RF line structure 235 including the single conductive line. A second line 1572 indicates a reflection coefficient in a feeding structure having the RF line structure 231 including the stacked conductive lines and the MIM structure of FIG. 15A. As a reflection coefficient is reduced, power loss is reduced, and more power may be transmitted. In other words, as the reflection coefficient is reduced, matching efficiency may be increased. Referring to the graph 1500c, it may be confirmed that the reflection coefficient is lowered through the MIM structure.

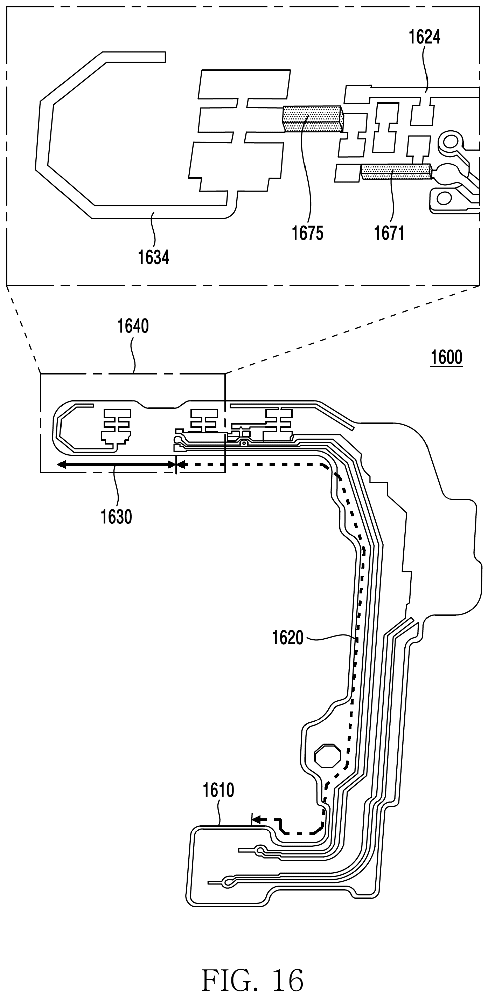

FIG. 16 illustrates an example of a flexible printed circuit board (FPCB) using a multilayer RF line structure.

Referring to FIG. 16, an electronic device 101 may include an FPCB 1600. The FPCB 1600 may include a connector portion 1610 connected to a component, a line portion 1620 including signal lines (e.g., a strip line), and a feeding portion 1630 connected to a radiator. Referring to an area 1640, the FPCB 1600 may include a conductive pattern 1624 in the line portion 1620. The conductive pattern 1624 may include a line for transmitting an RF signal. The FPCB 1600 may include a conductive pattern 1634 in the feeding portion 1630. The conductive pattern 1634 may be coupled to a contact member (e.g., a contact member 240) of the radiator (e.g., a conductive portion 203). An increase in inductance due to a length of an RF line in the FPCB 1600 may negatively affect impedance matching. The FPCB 1600 may be formed with fewer layers than layers of a rigid PCB (e.g., a PCB 250). As an example, the FPCB 1600 may include about 3 to 5 layers. Instead of stacking conductive lines in fewer layers, an additional conductive structure may be used. According to an embodiment, a conductive structure 1671 may be disposed above an RF line in the conductive pattern 1624. According to an embodiment, a conductive structure 1675 may be disposed to reduce inductance of a line between the conductive pattern 1624 and the conductive pattern 1634. A conductive structure (e.g., the conductive structure 1671 or the conductive structure 1675) may be coupled to an RF line through conductor soldering. As a thickness of an RF line increases, inductance of the RF line may be reduced. Efficiency of impedance matching may be improved due to the reduced inductance.

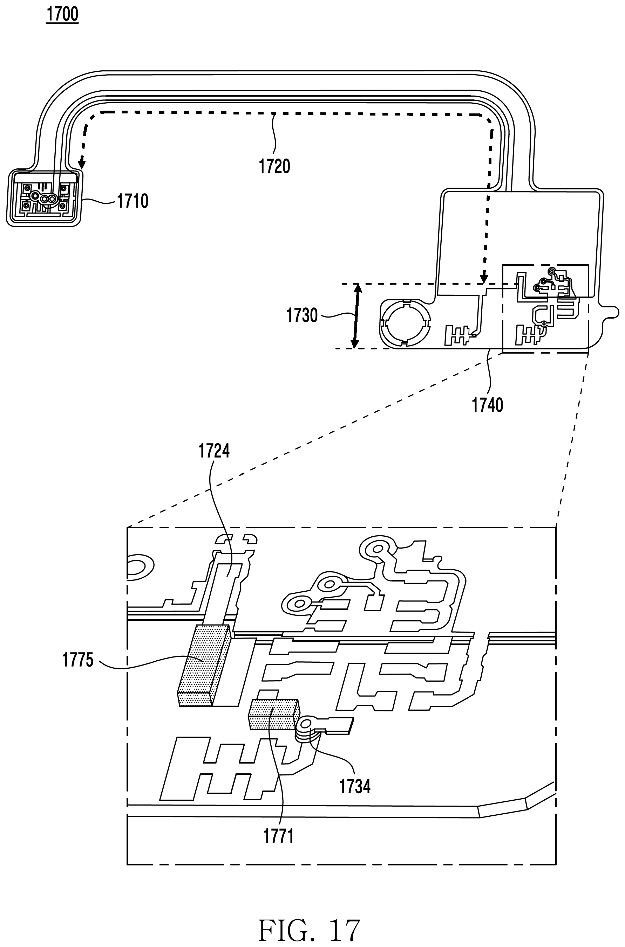

FIG. 17 illustrates an example of an FPCB using a multilayer RF line structure.

Referring to FIG. 17, an electronic device 101 may include an FPCB 1700. The FPCB 1700 may include a connector portion 1710 connected to a component, a line portion 1720 including signal lines (e.g., a strip line), and a feeding portion 1730 connected to a radiator. Referring to an area 1740, the FPCB 1700 may include a conductive pattern 1724 and/or a conductive pattern 1734 in the feeding portion 1730. The conductive pattern 1734 may be connected to a contact member of the radiator. An increase in inductance due to a length of an RF line in the FPCB 1700 may negatively affect impedance matching. In order to reduce influence due to inductance, a conductive structure for reducing the inductance of the RF line may be additionally disposed. According to an embodiment, a conductive structure 1771 may be disposed above an RF line in the conductive pattern 1724. According to an embodiment, the conductive structure 1775 may be disposed above an RF line in the conductive pattern 1734. A conductive structure (e.g., the conductive structure 1771 or the conductive structure 1775) may be coupled to an RF line through conductor soldering. As a thickness of an RF line increases, inductance of the RF line may be reduced. Efficiency of impedance matching may be improved due to the reduced inductance.

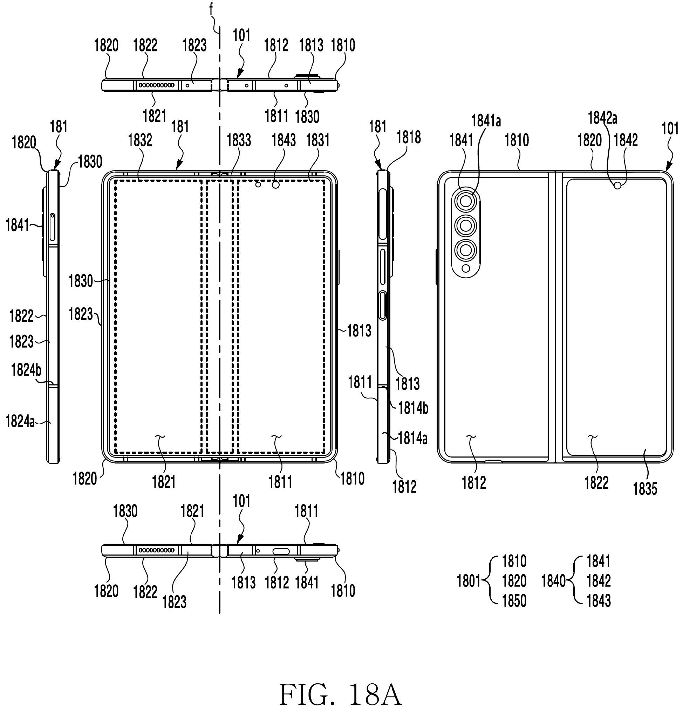

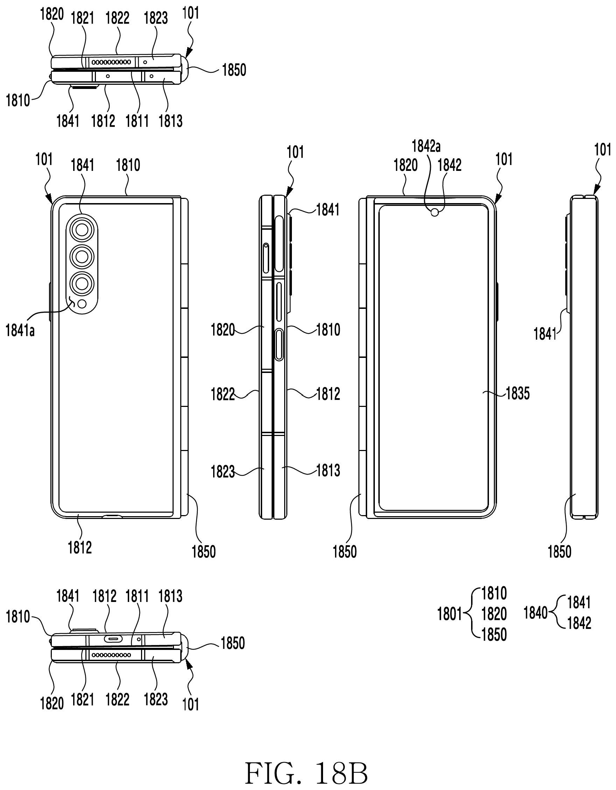

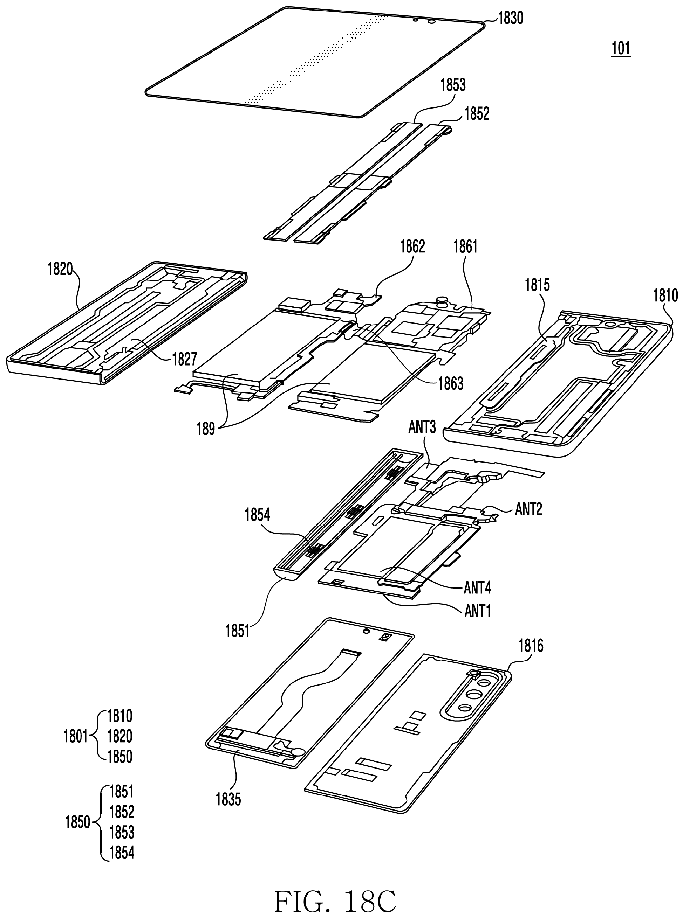

FIGS. 18A, 18B, and 18C illustrate examples of a foldable-type electronic device. FIG. 18A illustrates an example of an unfolded state of an exemplary foldable electronic device. FIG. 18B illustrates an example of a folded state of an exemplary foldable electronic device. FIG. 18C is an exploded view of an exemplary foldable electronic device.

Referring to FIGS. 18A, 18B, and 18C, a foldable electronic device (e.g., the electronic device 101 of FIG. 1) may include a housing 1801, a flexible display 1830, (e.g., the display module 160 of FIG. 1), and at least one camera 1840.

For example, the housing 1801 may form an exterior of the foldable electronic device 101. For example, the housing 1801, which is a physical exterior of the foldable electronic device 101 to be exposed to the outside, may surround components that are disposed inside the foldable electronic device 101 and are not exposed to the outside. For example, the housing 1801 may include a first housing part 1810, a second housing part 1820, and a hinge structure 1850.

For example, the first housing part 1810 may include a first surface 1811, a second surface 1812 opposite the first surface 1811, and a first side surface 1813 surrounding at least a portion of the first surface 1811 and the second surface 1812. For example, the first surface 1811 may be referred to as a front surface of the first housing part 1810, and the second surface 1812 may be referred to as a rear surface of the first housing part 1810. The first side surface 1813 may be connected to a periphery of the first surface 1811 and a periphery of the second surface 1812. The first surface 1811, the second surface 1812, and the first side surface 1813 may form an inner space of the first housing part 1810. For example, at least one component may be disposed in a space surrounded by the first surface 1811, the second surface 1812, and the first side surface 1813.

For example, the second housing part 1820 may include a third surface 1821, a fourth surface 1822 opposite the third surface 1821, and a second side surface 1823 surrounding at least a portion of the third surface 1821 and the fourth surface 1822. For example, the third surface 1821 may be referred to as a front surface of the second housing part 1820, and the fourth surface 1822 may be referred to as a rear surface of the second housing part 1820. The second side surface 1823 may be connected to a periphery of the third surface 1821 and a periphery of the fourth surface 1822. The third surface 1821, the fourth surface 1822, and the second side surface 1823 may form an inner space of the second housing part 1820. For example, at least one component may be disposed in a space surrounded by the third surface 1821, the fourth surface 1822, and the second side surface 1823.

For example, the flexible display 1830 may be configured to display visual information. For example, the flexible display 1830 may include a display area including a plurality of pixels. For example, an active area may be referred to as an active area displaying visual information. For example, the flexible display 1830 may form at least a portion of the front surface of the housing 1801. For example, the flexible display 1830 may at least partially form the first surface 1811 and the third surface 1821.

For example, the flexible display 1830 may include a first display area 1831 forming at least a portion of the first surface 1811 of the first housing part 1810, a second display area 1832 forming at least a portion of the third surface 1821 of the second housing part 1820, and a third display area 1833 disposed between the first display area 1831 and the second display area 1832. For example, the first display area 1831, the second display area 1832, and the third display area 1833 may at least partially form a front surface of the housing 1801. For example, the foldable electronic device 101 may further include a sub-display 1835 distinguished from the flexible display 1830. The sub-display 1835 may be disposed on the fourth surface 1822 of the second housing part 1820. The sub-display 1835 may be referred to as a cover display.

For example, the at least one camera 1840 may be configured to obtain an image based on receiving light from an external subject of the foldable electronic device 101. For example, the at least one camera 1840 may include a first cameras 1841, a second cameras 1842, or a third cameras 1843. For example, the first cameras 1841 may be disposed within the first housing part 1810. For example, the first housing part 1810 may include at least one opening 1841a overlapped to the first cameras 1841 when the foldable-type electronic device 101 is viewed from above. The first cameras 1841 may obtain an image based on receiving light from the outside of the foldable electronic device 101 through the at least one opening 1841a.

For example, the second camera 1842 may be disposed within the second housing part 1820. The second housing part 1820 may include at least one opening 1842a overlapped to the second camera 1842 when the foldable electronic device 101 is viewed from above. The second camera 1842 may obtain an image based on receiving light from the outside of the foldable electronic device 101 through the at least one opening 1842a.

For example, the third camera 1843 may be disposed within the first housing part 1810. For example, the first display area 1831 of the flexible display 1830 may include at least one opening overlapped to the third camera 1843 when the flexible display 1830 is viewed from above. The third camera 1843 may obtain an image based on receiving light from the outside of the flexible display 1830 through the at least one opening.

For example, the second camera 1842 and the third camera 1843 may be disposed below the flexible display 1830 (e.g., the (+) z-axis direction). For example, the second camera 1842 and/or the third camera 1843 may include an under display camera (UDC) and/or a punch hole camera.

For example, the first housing part 1810 and the second housing part 1820 may be rotatably coupled. For example, the second housing part 1820 may be rotatably coupled to the first housing part 1810 through the hinge structure 1850.

For example, the hinge structure 1850 may rotatably connect the first housing part 1810 and the second housing part 1820. The hinge structure 1850 may be disposed between the first housing part 1810 and the second housing part 1820 of the foldable electronic device 101 so that the foldable electronic device 101 may be foldable. The hinge structure 1850 may enable the foldable electronic device 101 to be changed from an unfolded state to a folded state. The hinge structure 1850 may enable the foldable electronic device 101 to be changed from the folded state to the unfolded state. The hinge structure 1850 may maintain the foldable electronic device 101 in an intermediate state between the unfolded state and the folded state.

For example, the unfolded state may be referred to as a state in which a first direction in which the first display area 1830a faces and a second direction in which the second display area 1830b faces are the same. For example, the folded state may be referred to as a state in which the first direction is opposite to the second direction. When the foldable electronic device 101 is in the folded state, the first housing part 1810 and the second housing part 1820 may be stacked or overlapped.

For example, when the foldable electronic device 101 is in the folded state and the intermediate state, the first direction and the second direction may be different. For example, when the foldable electronic device 101 is in the folded state, the first direction and the second direction may be opposite to each other. For example, when the foldable electronic device 101 is in the intermediate state, the first direction may have an inclination (e.g., an angle between 0 and 180 degrees) with respect to the second direction.

For example, the foldable electronic device 101 may be rotatable based on a folding axis f. The folding axis f may be referred to as a virtual line extending along a direction parallel to a longitudinal direction of the foldable electronic device 101 (e.g., y-axis) or a direction parallel to a width direction of the foldable electronic device 101 (e.g., x-axis).

For example, the foldable electronic device 101 may include at least one conductive portion 1814a and 1824a, and at least one non-conductive portion 1814b and 1824b included in a first side 1813 and/or a third side 1823. For example, at least one conductive portion 1814a and 1824a may be separated from other conductive portions within the first side 1813 and/or the third side 1823, by contacting the at least one non-conductive portion 1814b and 1824b. The at least one conductive portion 1814a and 1824a may operate as an antenna radiator to be used for communication with an external electronic device.

Referring to FIG. 18C, the hinge structure 1850 may include a hinge cover 1851, a first hinge plate 1852, a second hinge plate 1853, and a hinge module 1854. The hinge cover 1851 may surround internal components of the hinge structure 1850 and form an outer surface of the hinge structure 1850. For example, when the foldable electronic device 101 is in the folded state, at least a portion of the hinge cover 1851 may be exposed to the outside of the foldable electronic device 101 through a space between the first housing part 1810 and the second housing part 1820. According to another embodiment, when the foldable electronic device 101 is in the unfolded state, the hinge cover 1851 may be covered by the first housing part 1810 and the second housing part 1820 and may not be exposed to the outside of the foldable electronic device 101.

For example, the first hinge plate 1852 and the second hinge plate 1853 may rotatably connect the first housing part 1810 and the second housing part 1820, by being operably coupled to the first housing part 1810 and the second housing part 1820, respectively. For example, the first hinge plate 1852 may be operably coupled to a first frame 1815 of the first housing part 1810, and the second hinge plate 1853 may be operably coupled to a second frame 1827 of the second housing part 1820. As the first hinge plate 1852 and the second hinge plate 1853 are operably coupled to the first frame 1815 and the second frame 1827, respectively, the first housing part 1810 and the second housing part 1820 may be rotatable according to a rotation of the first hinge plate 1852 and the second hinge plate 1853.

The hinge module 1854 may rotate the first hinge plate 1852 and the second hinge plate 1853. For example, the hinge module 1854 may rotate the first hinge plate 1852 and the second hinge plate 1853 with respect to a folding axis f, by including rotatable gears engaged with each other.

For example, the first housing part 1810 may include the first frame 1815 and a rear cover 1816. The first frame 1815 may be disposed inside the first housing part 1810 and may support at least one component disposed within the first housing part 1810. The rear cover 1816 may at least partially form the second surface 1822 of the first housing part 1810. For example, the second housing part 1820 may include the second frame 1827. The second frame 1827 may be disposed inside the second housing part 1820 and may support at least one component disposed in the second housing part 1820. For example, the sub-display 1835 may be disposed below the second frame 1827 (e.g., the (+) z-axis direction).

In addition to the at least one camera 1840 described above, the exemplary foldable electronic device 101 may include a plurality of electronic components for implementing various functions. For example, the foldable electronic device 101 may include a first printed circuit board 1861, a second printed circuit board 1862, a connection structure 1863 (e.g., the flexible printed circuit board), and/or a battery 189. The above-described electronic components are merely exemplary and are not limited thereto.

For example, the first printed circuit board 1861 and the second printed circuit board 1862 may provide an electrical connection of components in the foldable electronic device 101, respectively. For example, the first printed circuit board 1861 may be disposed within the first housing part 1810, and the second printed circuit board 1862 may be disposed within the second housing part 1820. The first printed circuit board 1861 may provide an electrical connection between electronic components disposed in the first housing part 1810. The second printed circuit board 1862 may provide an electrical connection between electronic components disposed in the second housing part 1820. The connection structure 1863 may electrically connect the first printed circuit board 1861 and the second printed circuit board 1862. For example, the connection structure 1863 may extend from the first printed circuit board 1861 to the second printed circuit board 1862 across the hinge structure 1850. For example, the connection structure 1863 may at least partially overlap the hinge structure 1850.

For example, the battery 189, which is a device for supplying power to at least one component of the foldable electronic device 101, may include, for example, a non-rechargeable primary battery and/or a rechargeable secondary battery.

For example, the foldable electronic device 101 may include a plurality of antennas ANT1, ANT2, ANT3, and ANT4 to be used for communication with an external electronic device. For example, the foldable electronic device 101 may include a main antenna (ANT1), a sub-antenna (ANT2), an ultra-wide band (UWB) antenna (ANT3), and/or an antenna for short-range wireless communication (ANT4). However, it is not limited thereto.

Hereinafter, one or more components to be described later with reference to the drawings may be implemented together with the components of the foldable electronic device 101 described with reference to FIGS. 18A, 18B, and 18C. The same reference numerals are assigned to the same components as the above-described components, and overlapping descriptions may be omitted.

In the present disclosure, relative terms such as "above" and "under" may be used to describe a relative position between components. For example, when the foldable electronic device 101 illustrated in the drawings is flipped over, "above" and "under" may be interchanged.

A RF line structure in which conductive lines (e.g., RF line structure 231 and/or RF line structure 235) according to embodiments of the present disclosure can also be applied to the foldable electronic device (e.g., electronic device 101) of FIGS. 18A, 18B, and 18C. In one embodiment, a foldable electronic device (e.g., electronic device 101) may include an RF line structure with stacked conductive lines, located in a fill-cut area of the PCB (e.g., first printed circuit board 1861) of the first housing part 1810. A portion of the metal frame of the first housing part 1810 may be connected to the RF line structure and used as an antenna radiator. In another embodiment, a foldable electronic device (e.g., electronic device 101) may include an RF line structure with stacked conductive lines, located in a fill-cut area of the PCB (e.g., second printed circuit board 1862) of the second housing part 1820. A portion of the metal frame of the second housing part 1820 may be connected to the RF line structure and used as an antenna radiator.

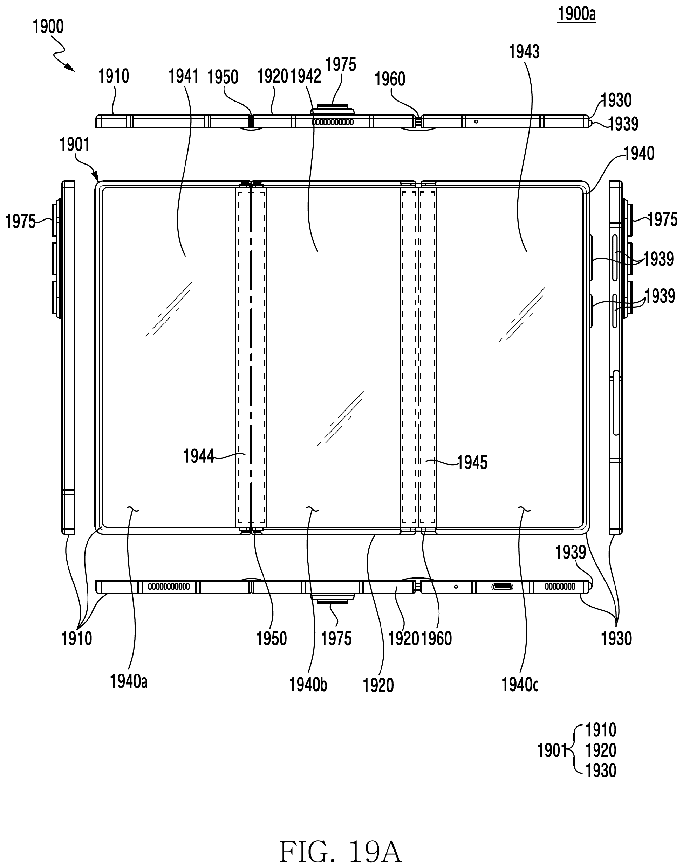

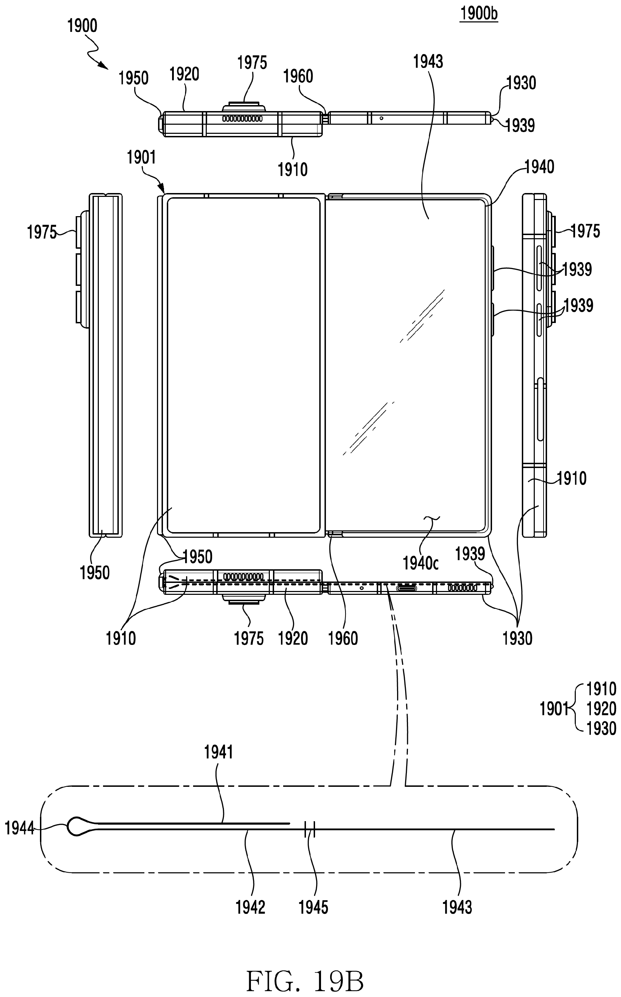

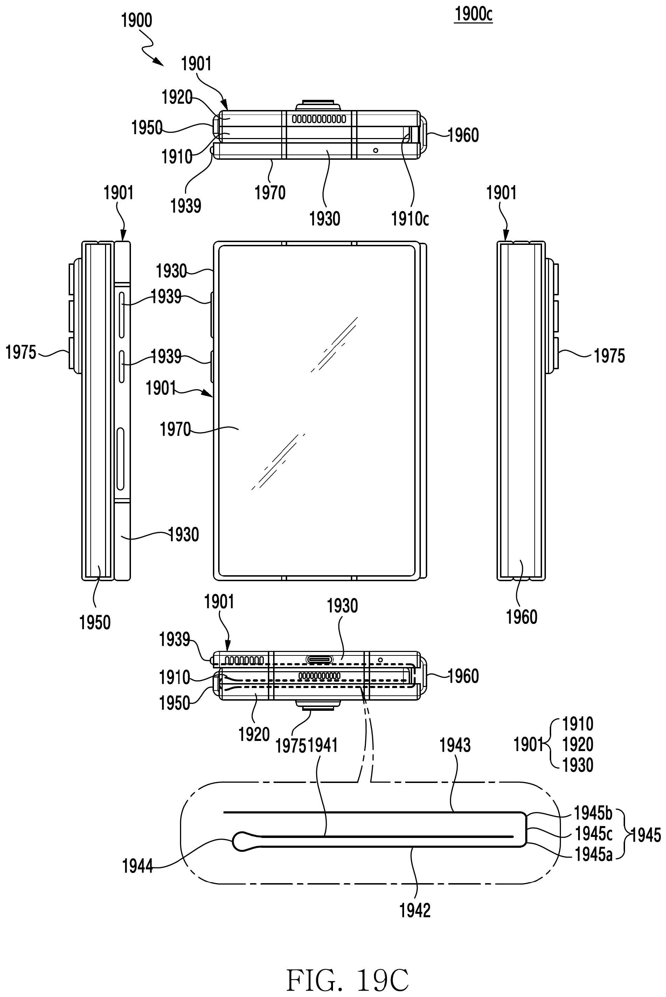

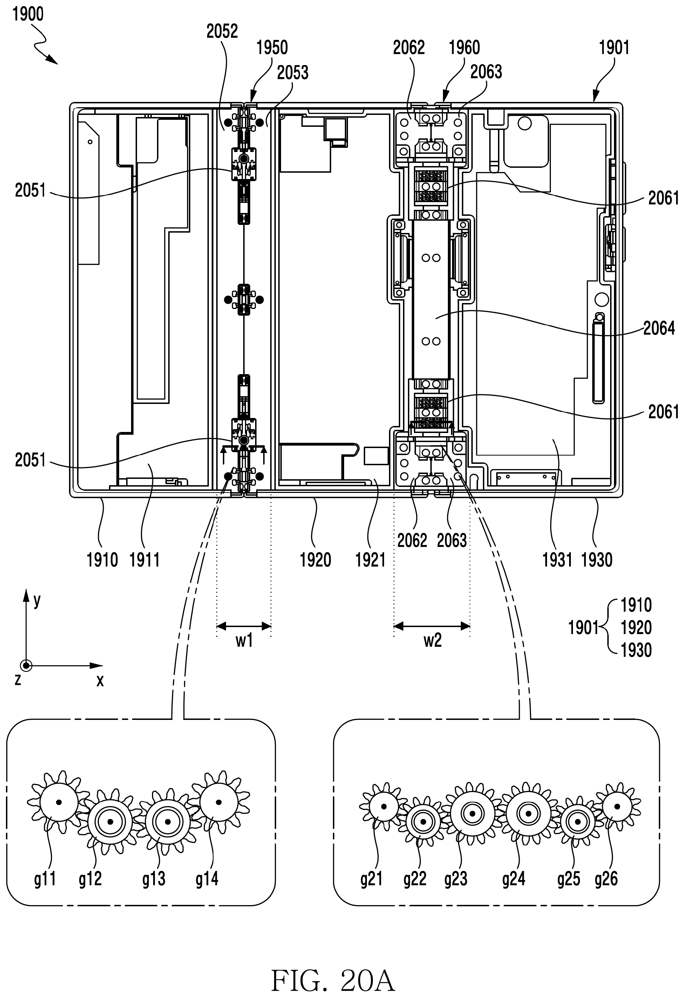

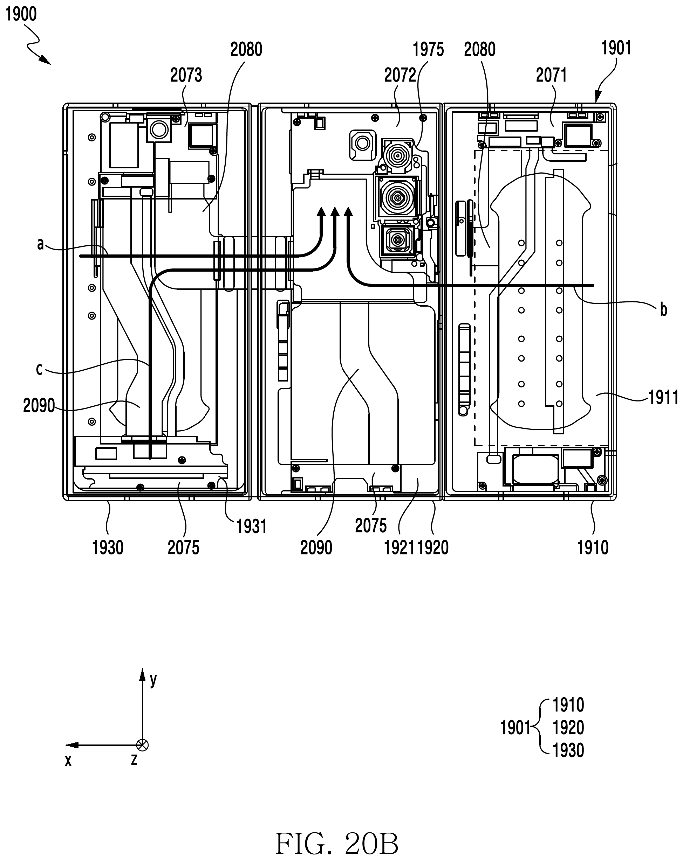

FIGS. 19A, 19B, 19C, 20A, and 20B illustrate an example of a foldable-type electronic device (e.g., the electronic device 101). FIG. 19A illustrates an example of a first state of an electronic device. FIG. 19B illustrates an example of a second state of an electronic device. FIG. 19C illustrates an example of a third state of an electronic device.

Referring to FIGS. 19A, 19B, and 19C, the electronic device 1900 may include a housing structure 1901, a flexible display 1940, a first hinge structure 1950, a second hinge structure 1960, and a display 1970. The housing structure 1901 may include a first housing part 1910, a second housing part 1920, and a third housing part 1930.

The first housing part 1910 may be rotatably coupled to the second housing part 1920 by the first hinge structure 1950. The second housing part 1920 and the first housing part 1910 may be rotated with respect to the first hinge structure 1950. While the first housing part 1910 rotates with respect to the first hinge structure 1950, the second housing part 1920 may rotate with respect to the first hinge structure 1950. For example, when the second housing part 1920 and the first housing part 1910 are rotated with respect to the first hinge structure 1950, an angular displacement of the second housing part 1920 may be substantially equal to an angular displacement of the first housing part 1910.

The third housing part 1930 may be rotatably coupled to the second housing part 1920 by the second hinge structure 1960. The second housing part 1920 and the third housing part 1930 may be rotated with respect to the second hinge structure 1960. While the second housing part 1920 is rotated with respect to the second hinge structure 1960, the third housing part 1930 may be rotated with respect to the second hinge structure 1960. For example, when the second housing part 1920 and the third housing part 1930 are rotated with respect to the second hinge structure 1960, the angular displacement (or angular change) of the second housing part 1920 may be substantially equal to the angular displacement of the third housing part 1930.

The first hinge structure 1950 and the second hinge structure 1960 may change a state of the electronic device. The first hinge structure 1950 and the second hinge structure 1960 may provide (or enable) a first state 1900a of the electronic device 1900 (or a first state 1900a of the housing structure 1901). The first state 1900a of the electronic device 1900 (or the first state 1900a of the housing structure 1901) may be described as an unfolded state (or unfolding state) of the electronic device 1900 (or the housing structure 1901). In the first state 1900a, a front surface of the first housing part 1910, a front surface of the second housing part 1920, and a front surface of the third housing part 1930 may define a front surface of the electronic device 1900. In the first state 1900a, the front surface of the first housing part 1910, the front surface of the second housing part 1920, and the front surface of the third housing part 1930 may face the same direction. In the first state 1900a, the electronic device 1900 may provide a large display region of the flexible display 1940 to the user.

The first hinge structure 1950 and the second hinge structure 1960 may provide a second state 1900b of the electronic device 1900. The second state 1900b of the electronic device 1900 may be described as a state in which the electronic device 1900 is partially folded and partially unfolded (or a single folding state or a half folding state). For example, in the second state 1900b, the front surface of the second housing part 1920 and the front surface of the third housing part 1930 may face the same direction, and the front surface of the first housing part 1910 and the front surface of the second housing part 1920 may face opposite directions. For example, in a third state, the first housing part 1910 and the second housing part 1920 may be folded, and the second housing part 1920 and the third housing part 1930 may be unfolded. In the second state 1900b, the electronic device 1900 may transfer visual information through a portion (e.g., a third display region 1940c) of the flexible display 1940.

The electronic device 1900 may be changed from the first state 1900a to the third state 1900c through the second state 1900b. The electronic device 1900 may be changed from the first state 1900a, which is an unfolded state, to the second state 1900b, which is a partially unfolded state. For example, the electronic device 1900 may be changed from the first state 1900a in which the first housing part 1910, the second housing part 1920, and the third housing part 1930 face the same direction, to the second state 1900b in which the front surface of the first housing part 1910 faces the front surface of the second housing part 1920. The electronic device 1900 may be changed from the second state 1900b, which is partially unfolded, to the third state 1900c, which is folded. For example, when changing from the second state 1900b to the third state 1900c, the folded first housing part 1910 and the second housing part 1920 may be disposed on the third housing part 1930.

The first hinge structure 1950 and the second hinge structure 1960 may provide a third state 1900c of the electronic device 1900 (or a third state 1900c of the housing structure 1901). The third state 1900c of the electronic device 1900 (or the third state 1900c of the housing structure 1901) may be described as a state in which the electronic device 1900 (or the housing structure 1901) is folded (or a folding state or a multi-folding state). In the third state 1900c, the front surface of the first housing part 1910 and the front surface of the second housing part 1920 may face opposite directions, and the front surface of the second housing part 1920 and the front surface of the third housing part 1930 may face opposite directions. In the third state 1900c, the front surface of the first housing part 1910 and the front surface of the third housing part 1930 may face the same direction. For example, in the third state 1900c, the front surface of the second housing part 1920 may face the front surface of the first housing part 1910, and the front surface of the third housing part 1930 may face a rear surface of the first housing part 1910. In the third state 1900c, a rear surface of the second housing part 1920 may be exposed to the outside. The camera 1975 may be disposed on the rear surface of the second housing part 1920. In the third state 1900c, a rear surface of the third housing part 1930 may be exposed to the outside. The display 1970 may be disposed on the rear surface of the third housing part 1930. In the third state 1900c, the electronic device 1900 may provide visual information through the display 1970 that is folded to enhance portability and is disposed on the third housing part 1930 of the electronic device 1900 in the third state 1900c.

The electronic device 1900 may further include a key button 1939. The key button 1939 may be exposed from a structure (e.g., opening) formed on a side surface of the third housing part 1930 and may partially protrude to the outside of the electronic device 1900. The key button 1939 may provide a physical input to processing circuitry inside the electronic device 1900 by a pressure transmitted from the outside. The key button 1939 may not be included in the electronic device 1900 and may be implemented in another form, such as a soft key displayed on the flexible display 1940 or the display 1970.

The key button may be disposed on the side surface of the third housing part 1930 so as to be exposed to the outside in the third state 1900c. As the state of the electronic device 1900 is changed from the third state 1900c to the first state 1900a by a user looking at the display, the key button 1939 disposed in the third housing part 1930 may be moved from the left to the right. For example, referring to FIG. 19A, in the first state 1900a, when the flexible display 1940 is viewed from above, the key button 1939 may be disposed on the right. Referring to FIG. 19C, in the third state 1900c, when the display 1970 is viewed from above, the key button 1939 may be disposed on the left.

The flexible display 1940 may at least partially define a surface of the electronic device 1900. The flexible display 1940 may be partially disposed within the housing structure 1901. The flexible display 1940 may define a front surface of the electronic device 1900. The flexible display 1940 may include a first unbendable portion 1941, a second unbendable portion 1942, a third unbendable portion 1943, a first bendable portion 1944, and a second bendable portion 1945. The first unbendable portion 1941 of the flexible display 1940 may be disposed on the front surface of the first housing part 1910. The second unbendable portion 1942 of the flexible display 1940 may be disposed on the front surface of the second housing part 1920. The third unbendable portion 1943 of the flexible display 1940 may be disposed on the front surface of the third housing part 1930. The first bendable portion 1944 of the flexible display 1940 may be disposed between the first unbendable portion 1941 and the second unbendable portion 1942 of the flexible display 1940. For example, the first bendable portion 1944 of the flexible display 1940 may be disposed on the first hinge structure 1950 connecting the first housing part 1910 and the second housing part 1920. The second bendable portion 1945 of the flexible display 1940 may be disposed between the second unbendable portion 1942 and the third unbendable portion 1943 of the flexible display 1940. For example, the second bendable portion 1945 of the flexible display 1940 may be disposed on the second hinge structure 1960 connecting the second housing part 1920 and the third housing part 1930.

The first hinge structure 1950 and the second hinge structure 1960 may face substantially the same direction as the first unbendable portion 1941 of the flexible display 1940, the second unbendable portion 1942 of the flexible display 1940, and the third unbendable portion 1943 of the flexible display 1940. In the first state 1900a, the first bendable portion 1944 and the second bendable portion 1945 may be disposed in substantially the same horizontal plane as the first unbendable portion 1941, the second unbendable portion 1942, and the third unbendable portion 1943.

The first hinge structure 1950 and the second hinge structure 1960 may provide a second state 1900b of the electronic device 1900. In the second state 1900b, the first unbendable portion 1941 of the flexible display 1940 may face the second unbendable portion 1942 of the flexible display 1940, and the third unbendable portion 1943 of the flexible display 1940 may face the same direction as the second unbendable portion 1942 of the flexible display 1940. For example, the second unbendable portion 1942 and the third unbendable portion 1943 may be disposed in substantially the same horizontal plane.

In the second state 1900b, as the first bendable portion 1944 of the flexible display 1940 is bent by the first hinge structure 1950, the first bendable portion 1944 of the flexible display 1940 may be folded, so that the first unbendable portion 1941 of the flexible display 1940 and the second unbendable portion 1942 of the flexible display 1940 face different directions.

In the second state 1900b, as the second bendable portion 1945 of the flexible display 1940 is maintained in the unfolded state by the second hinge structure 1960, the second bendable portion 1945 of the flexible display 1940 may be unfolded so that the second unbendable portion 1942 of the flexible display 1940 and the third unbendable portion 1943 of the flexible display 1940 face the same direction.

The first hinge structure 1950 and the second hinge structure 1960 may provide a third state 1900c of the electronic device 1900. In the third state 1900c, the second unbendable portion 1942 of the flexible display 1940 may face the first unbendable portion 1941 of the flexible display 1940, and the third unbendable portion 1943 of the flexible display 1940 may face the rear surface of the first housing part 1910.

In the third state 1900c, as the first bendable portion 1944 of the flexible display 1940 is bent by the first hinge structure 1950, the first bendable portion 1944 of the flexible display 1940 may be folded so that the first unbendable portion 1941 of the flexible display 1940 and the second unbendable portion 1942 of the flexible display 1940 face different directions.

In the third state 1900c, as the second bendable portion 1945 of the flexible display 1940 is bent by the second hinge structure 1960, the second bendable portion 1945 of the flexible display 1940 may be folded so that the second unbendable portion 1942 of the flexible display 1940 and the third unbendable portion 1943 of the flexible display 1940 face different directions. The second bendable portion 1945 may further include a first deformation portion 1945a, a second deformation portion 1945b, and a planar portion 1945c. The first deformation portion 1945a may be disposed between the planar portion 1945c and the second unbendable portion 1942, and the second deformation portion 1945b may be disposed between the planar portion 1945c and the third unbendable portion 1943. The planar portion 1945c may be disposed between the first deformation portion 1945a and the second deformation portion 1945b. The planar portion 1945c may be supported by a support plate (e.g., the support plate 2064 of FIG. 20A) that is distinct from the hinge plates (e.g., the third hinge plate 2062 and the fourth hinge plate 2063 of FIG. 20A) of the second hinge structure 1960. Regardless of the state of the electronic device 1900, the planar portion 1945c may maintain a planar surface. The first deformation portion 1945a and the second deformation portion 1945b may be unfolded in the first state 1900a and the second state 1900b, and in the third state 1900c, the first deformation portion 1945a and the second deformation portion 1945b may be folded so that the second unbendable portion 1942 and the third unbendable portion 1943 face different directions.

In the third state 1900c, the first housing part 1910 may be disposed between the second housing part 1920 and the third housing part 1930. In the third state 1900c, the second bendable portion 1945 of the flexible display 1940 disposed on the second hinge structure 1960 may partially face the side surface 1910c of the first housing part 1910.

A display region of the flexible display 1940 may include a first display region 1940a, a second display region 1940b, and a third display region 1940c. The display region indicates a region capable of providing visual information from the flexible display 1940. In the first state 1900a, the entire display region of the flexible display 1940 may be viewed from the front surface of the housing structure 1901. For example, in the first state 1900a, the first display region 1940a, the second display region 1940b, and the third display region 1940c of the flexible display 1940 may be visually exposed. The electronic device 1900 may provide, to the user, a large display region including the first display region 1940a, the second display region 1940b, and the third display region 1940c.

In the second state 1900b, the display region of the flexible display 1940 may be partially visible from the front surface of the third housing part 1930. For example, the third unbendable portion 1943 may be visually exposed, and the first display region 1940a and the second display region 1940b may not be visually exposed.

In the third state 1900c, the display region of the flexible display 1940 may not be visible. For example, in the third state 1900c, the first display region 1940a, the second display region 1940b, and the third display region 1940c of the flexible display 1940 may not be visually exposed.

As a non-limiting example, when the flexible display 1940 is used to display a screen in the first state 1900a of the electronic device 1900, the first display region 1940a, the second display region 1940b, and the third display region 1940c of the flexible display 1940 may be activated. As a non-limiting example, in the second state 1900b of the electronic device 1900, when the flexible display 1940 is used to display a screen, the third display region 1940c may be activated, and the first display region 1940a and the second display region 1940b of the flexible display 1940 may be deactivated. As a non-limiting example, in the third state 1900c of the electronic device 1900, the first display region 1940a, the second display region 1940b, and the third display region 1940c of the flexible display 1940 may be deactivated.

As a non-limiting example, when the flexible display 1940 is used to display a screen in the first state 1900a of the electronic device 1900, the first display region 1940a, the second display region 1940b, and the third display region 1940c of the flexible display 1940 may display visual information. As a non-limiting example, in the second state 1900b of the electronic device 1900, when the flexible display 1940 is used to display a screen, the third display region 1940c may provide visual information, and the first display region 1940a and the second display region 1940b of the flexible display 1940 may provide a black image. As a non-limiting example, in the third state 1900c, the first display region 1940a, the second display region 1940b, and the third display region 1940c of the flexible display 1940 may provide a black image.

FIG. 20A is a plan view of an electronic device from which a flexible display is removed. FIG. 20B is a rear view of an electronic device from which a rear cover and a display are removed.

Referring to FIGS. 20A and 20B, the electronic device 1900 may include a first hinge structure 1950 and a second hinge structure 1960. A first width w1 of the first hinge structure 1950 may be narrower than a second width w2 of the second hinge structure 1960. A difference between the first width w1 of the first hinge structure 1950 and the second width w2 of the second hinge structure 1960 may be greater than or equal to a thickness of the first housing part 1910. For example, the second hinge structure 1960 may have the second width w2 wider than the first width w1 so that the first housing part 1910 is disposed between the second housing part 1920 and the third housing part 1930 according to the third state 1900c. The first hinge structure 1950 may be referred to as a narrow hinge structure in terms of having a narrower width than the second hinge structure 1960. The second hinge structure 1960 may be referred to as a wide hinge structure in terms of having a wider width than the first hinge structure 1950.

The first hinge structure 1950 may include a first set of gears 2051, a first hinge plate 2052, and a second hinge plate 2053. The first hinge plate 2052 may be coupled to a first support portion 1911 of the first housing part 1910. The second hinge plate 2053 may be coupled to a second support portion 1921 of the second housing part 1920. Gears g11, g12, g13, and g14 included in the first set of gears 2051 may be configured to rotate the first hinge plate 2052 and the second hinge plate 2053. For example, the gears g11, g12, g13, and g14 included in the first set of gears 2051 may rotate the second hinge plate 2053 (or the second housing part 1920) by linking with a rotation of the first hinge plate 2052 (or the first housing part 1910). After the first hinge plate 2052 (or the first housing part 1910) rotates, the gears g11, g12, g13, and g14 included in the first set of gears 2051 may rotate in accordance with a rotation of the first hinge plate 2052 (or the first housing part 1910). The second hinge plate 2053 (or the second housing part 1920) may rotate by linking with the rotation of the first hinge plate 2052 in accordance with the rotation of the gears g11, g12, g13, and g14 included in the first set of gears 2051. The gears g11, g12, g13, and g14 included in the first set of gears 2051 may include a first gear g11, a second gear g12, a third gear g13, and a fourth gear g14. The first gear g11 may be disposed adjacent to the first hinge plate 2052, and the fourth gear g14 may be disposed adjacent to the second hinge plate 2053. The second gear g12 and the third gear g13 may be disposed between the first gear g11 and the fourth gear g14. The first gear g11, the second gear g12, the third gear g13, and the fourth gear g14 may be sequentially engaged. According to a rotation of the first gear g11 in a first rotation direction (e.g., clockwise), the second gear g12 engaged with the first gear g11 may be rotated in a second rotation direction (e.g., counterclockwise) opposite to the first rotation direction. According to the rotation of the second gear g12 in the second rotation direction, the third gear g13 engaged with the second gear g12 may be rotated in the first rotation direction. The fourth gear g14 may be rotated in the second rotation direction according to the rotation of the third gear g13 in the first rotation direction. As the first gear g11 and the fourth gear g14 rotate in different directions, the first housing part 1910 connected to the first hinge plate 2052 and the second housing part 1920 connected to the second hinge plate 2053 may be folded or unfolded.

The second hinge structure 1960 may include a second set of gears 2061, a third hinge plate 2062, a fourth hinge plate 2063, and a support plate 2064. The third hinge plate 2062 may be coupled to the second support portion 1921 of the second housing part 1920. The fourth hinge plate 2063 may be coupled to a third support portion 1931 of the third housing part 1930. Gears g21, g22, g23, g24, g25, and g26 included in the second set of gears 2061 may be configured to rotate the third hinge plate 2062 and the fourth hinge plate 2063. For example, the gears g21, g22, g23, g24, g25, and g26 included in the second set of gears 2061 may rotate the fourth hinge plate 2063 (or the third housing part 1930) by linking with a rotation of the third hinge plate 2062 (or the second housing part 1920). After the third hinge plate 2062 (or the second housing part 1920) is rotated, the gears g21, g22, g23, g24, g25, and g26 included in the second set of gears 2061 may rotate according to the rotation of the third hinge plate 2062 (or the second housing part 1920). The fourth hinge plate 2063 (or the third housing part 1930) may be rotated by linking with the rotation of the third hinge plate 2062 according to the rotation of the gears g21, g22, g23, g24, g25, and g26 included in the second set of gears 2061.

The gears g21, g22, g23, g24, g25, and g26 included in the second set of gears 2061 may include a first gear g21, a second gear g22, a third gear g23, a fourth gear g24, a fifth gear g25, and a sixth gear g26. The first gear g21 may be disposed adjacent to the third hinge plate 2062, and the sixth gear g26 may be disposed adjacent to the fourth hinge plate 2063. The second gear g22, the third gear g23, the fourth gear g24, and the fifth gear g25 may be disposed between the first gear g21 and the sixth gear g26. The first gear g21, the second gear g22, the third gear g23, the fourth gear g24, the fifth gear g25, and the sixth gear g26 may be sequentially engaged. According to a rotation of a first rotation direction (e.g., clockwise) of the first gear g21, the second gear g22 engaged with the first gear g21 may be rotated in a second rotation direction (e.g., counterclockwise) opposite to the first rotation direction. According to the rotation of the second gear g22 in the second rotation direction, the third gear g23 engaged with the second gear g22 may be rotated in the first rotation direction. According to the rotation of the third gear g23 in the first rotation direction, the fourth gear g24 may be rotated in the second rotation direction. According to the rotation of the fourth gear g24 in the second rotation direction, the fifth gear g25 engaged with the fourth gear g24 may be rotated in the first rotation direction. According to the rotation of the fifth gear g25 in the first rotation direction, the sixth gear g26 engaged with the fifth gear g25 may be rotated in the second rotation direction. As the first gear g21 and the sixth gear g26 rotate in different directions, the second housing part 1920 connected to the third hinge plate 2062 and the third housing part 1930 connected to the fourth hinge plate 2063 may be folded or unfolded.

The first hinge structure 1950 and the second hinge structure 1960 may further include a spiral structure. The spiral structure may include a helical spiral groove formed in each hinge plate or a rotation member connected to the hinge plate and a moving member sliding along the spiral groove. The hinge plates connected to the hinge structure may be configured to rotate at substantially the same angular displacement through the spiral structure.

The electronic device 1900 may include a first printed circuit board 2071, a second printed circuit board 2072, and a third printed circuit board 2073.

The first printed circuit board 2071 may be disposed on the first support portion 1911 of the first housing part 1910. Hardware components within the first housing part 1910 may be mounted in the first printed circuit board 2071.

The second printed circuit board 2072 may be disposed on the second support portion 1921 of the second housing part 1920. Hardware component in the second housing part 1920 may include at least one processor (e.g., an application processor (AP) or a communication processor (CP)) mounted in the second printed circuit board 2072 and including processing circuitry, memory including one or more storage mediums, communication circuitry, and the rear camera 1975. The rear camera 1975 may be exposed through a structure (e.g., opening) of the rear surface of the second housing part 1920.

The third printed circuit board 2073 may be disposed in the third support portion 1931 of the third housing part 1930. Hardware components within the third housing part 1930 may be mounted in the third printed circuit board 2073. Hardware components disposed on the third printed circuit board 2073 may support hardware components disposed on the second printed circuit board 2072, or operate independently. The hardware components disposed on the third printed circuit board 2073 may include a speaker, a front camera, and/or display driving circuitry.

Hardware components disposed on the first printed circuit board 2071 may support hardware components disposed on the second printed circuit board 2072 and/or hardware components disposed on the third printed circuit board 2073, or operate independently.

The electronic device 1900 may further include a sub-printed circuit board 2075, flexible printed circuit boards 2080 and 2090. The sub-printed circuit board 2075 may be disposed on at least a portion of the first housing part 1910, the second housing part 1920, and the third housing part 1930. The flexible printed circuit boards 2080 and 2090 may include a first flexible printed circuit board 2080 and a second flexible printed circuit board 2090. The first flexible printed circuit board 2080 may electrically connect printed circuit boards disposed on each of the housing parts 1910, 1920, and 1930. The second flexible printed circuit board 2090 may connect a printed circuit board within a housing part in which the sub-printed circuit board 2075 is disposed and the sub-printed circuit board 2075, by the second flexible printed circuit board 2090.

Electronic components within the electronic device 1900 may be connected to at least one processor within the second printed circuit board 2072 through the flexible printed circuit boards 2080 and 2090. For example, a signal received from an antenna disposed in the third housing part 1930 may be transmitted to the second printed circuit board 2072 on which at least one processor (e.g., AP or CP) is disposed through a signal path (a) provided by the first flexible printed circuit board 2080. A driving circuit for the flexible display 1940 disposed within the first housing part 1910 may be connected to the second printed circuit board 2072 on which at least one processor (e.g., AP) is disposed, through a signal path (b) provided by the first flexible printed circuit board 2080. A driving circuit for the display 1970 connected to the sub-printed circuit board 2075 disposed on the first housing part 1910 may be electrically connected to the second printed circuit board 2072 on which at least one processor (e.g., AP) is disposed through a signal path (c) provided by the sub-printed circuit board 2075 and the first flexible printed circuit board 2080 and the second flexible printed circuit board 2090. The electronic device 1900 may further include batteries. Each of the batteries may be attached to support portions 1911, 1921, and 1931 included in the housing parts 1910, 1920, and 1930. The support portions 1911, 1921, and 1931 may support rechargeable batteries.

The arrangement of hardware components is exemplary, unlike the above description, the rear camera 1975 and the second printed circuit board 2072 may be disposed in the third housing part 1930, and the third printed circuit board 2073 may be disposed in the second housing part 1920.

It is illustrated that the first housing part 1910 and the third housing part 1930 rotate in opposite directions with respect to the second housing part 1920, but are not limited thereto. For example, while changing from the first state 1900a to the third state 1900c, the first housing part 1910 may rotate counterclockwise with respect to the second housing part 1920, and the third housing part 1930 may rotate counterclockwise with respect to the second housing part 1920. As the first housing part 1910 and the third housing part 1930 rotate in the same direction, a portion of the display region of the flexible display 1940 within the second state may be visually exposed.

According to embodiments of the present disclosure, a RF line structure with stacked conductive lines (e.g., RF line structure 231 and/or RF line structure 235) may also be applied to the foldable-type electronic device (e.g., electronic device 101) of FIGS. 19A, 19B, 19C, 20A, and 20B. According to an embodiment, a foldable-type electronic device (e.g., electronic device 101) may include an RF line structure disposed in a fill-cut area of a PCB (e.g., first printed circuit board 2071) of the first housing part 1910. In the RF line structure, a plurality of conductive lines may be stacked along a stacking direction of the PCB. The conductive lines may be spaced apart at regular intervals. The conductive lines may be coupled through a plurality of vias. A portion of a metal frame of the first housing part 1910 may be used as an antenna radiator for signals fed through the RF line structure. According to another embodiment, a foldable-type electronic device (e.g., electronic device 101) may include an RF line structure disposed in a fill-cut area of a PCB (e.g., second printed circuit board 2072) of the second housing part 1920 and having stacked conductive lines. A portion of a metal frame of the second housing part 1920 may be connected to the RF line structure and used as an antenna radiator. According to yet another embodiment, a foldable-type electronic device (e.g., electronic device 101) may include an RF line structure disposed in a fill-cut area of a PCB (e.g., third printed circuit board 2073) of the third housing part 1930 and having stacked conductive lines. A portion of a metal frame of the third housing part 1930 may be connected to the RF line structure and used as an antenna radiator.

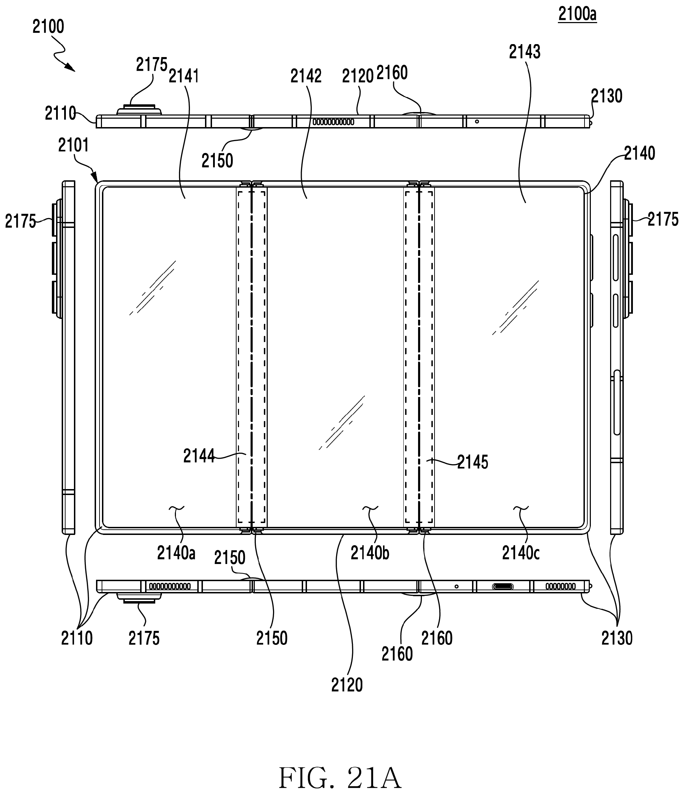

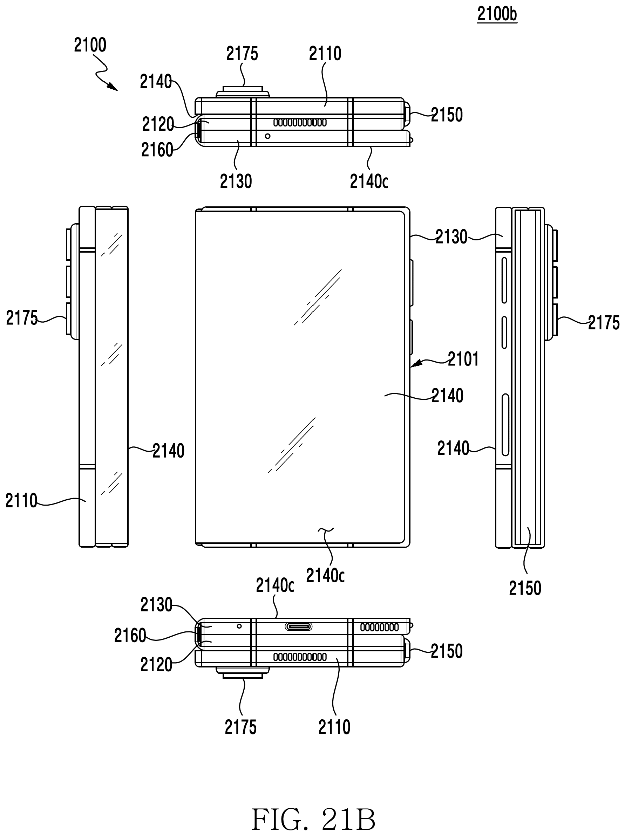

FIGS. 21A and 21B illustrate examples of a foldable-type electronic device (e.g., electronic device 101). FIG. 21A illustrates an example of a first state of an electronic device. FIG. 21B illustrates an example of a second state of an electronic device.

Referring to FIGS. 21A and 21B, the electronic device 2100 may include a housing structure 2101, a flexible display 2140, a first hinge structure 2150, and a second hinge structure 2160. The first housing structure 2101 may include a first housing part 2110, a second housing part 2120, and a third housing part 2130.

The first housing part 2110 may be rotatably coupled to the second housing part 2120 by the first hinge structure 2150. The first housing part 2110 and the second housing part 2120 may be rotated with respect to the first hinge structure 2150. The first hinge structure 2150 may cause the first housing part 2110 to rotate in conjunction with a rotation of the second housing part 2120. While the first housing part 2110 is rotated with respect to the first hinge structure 2150, the second housing part 2120 may be rotated with respect to the first hinge structure 2150. For example, when the first housing part 2110 and the second housing part 2120 rotate with respect to the first hinge structure 2150, angular displacement (or angular change) of the first housing part 2110 may be substantially equal to angular displacement of the second housing part 2120.

The third housing part 2130 may be rotatably coupled to the second housing part 2120 by the second hinge structure 2160. The second housing part 2120 and the third housing part 2130 may be rotated with respect to the second hinge structure 2160. The second hinge structure 2160 may cause the second housing part 2120 to rotate in conjunction with a rotation of the third housing part 2130. While the third housing part 2130 is rotated with respect to the second hinge structure 2160, the second housing part 2120 may be rotated with respect to the second hinge structure 2160. For example, when the second housing part 2120 and the third housing part 2130 rotate with respect to the second hinge structure 2160, angular displacement of the second housing part 2120 may be substantially equal to angular displacement of the third housing part 2130.

The first hinge structure 2150 and the second hinge structure 2160 may change a state of the electronic device 2100. The first hinge structure 2150 and the second hinge structure 2160 may provide a first state 2100a of the electronic device 2100 (or a first state 2100a of the housing structure 2101) (or enable it). The first state 2100a of the electronic device 2100 (or the first state 2100a of the housing structure 2101) may be described as an unfolded state (or an unfolding state) of the electronic device 2100 (or the housing structure 2101). In the first state 2100a, a front surface of the first housing part 2110, a front surface of the second housing part 2120, and a front surface of the third housing part 2130 may define a front surface of the electronic device 2100. In the first state 2100a, the front surface of the first housing part 2110, the front surface of the second housing part 2120, and the front surface of the third housing part 2130 may face the same direction. In the first state 2100a, the electronic device 2100 may provide a user with a large display area of the flexible display 2140.

The first hinge structure 2150 and the second hinge structure 2160 may provide a second state 2100b of the electronic device 2100 (or a second state 2100b of the housing structure 2101). The second state 2100b of the electronic device 2100 (or the second state 2100b of the housing structure 2101) may be described as a folded state (or a multi-folding state or a folding state) of the electronic device 2100 (or the housing structure 2101). While the state of the electronic device 2100 is changed from the first state 2100a to the second state 2100b, a rotation direction of the first housing part 2110 with respect to the second housing part 2120 may be the same as a rotation direction of the third housing part 2130 with respect to the second housing part 2120.

In the second state 2100b, the front surface of the first housing part 2110 and the front surface of the second housing part 2120 may face opposite directions to each other, and the front surface of the second housing part 2120 and the front surface of the third housing part 2130 may face opposite directions to each other. For example, in the second state 2100b, the front surface of the first housing part 2110 may face the front surface of the second housing part 2120, and a rear surface of the second housing part 2120 may face the front surface of the third housing part 2130. In the second state 2100b, the electronic device 2100 may be folded to improve portability. In the folded state, visual information may be provided through a portion (e.g., the third display area 2140c) of a display area of the display 2140 disposed outside the electronic device 2100.

The first hinge structure 2150 and the second hinge structure 2160 may provide a third state of the electronic device 2100. The third state of the electronic device 2100 may be described as a state in which the electronic device 2100 is partially folded and partially unfolded (or a single folding state or a half folding state). For example, in the third state, the front surface of the second housing part 2120 and the front surface of the third housing part 2130 may face each other in the same direction, and the front surface of the first housing part 2110 may face the front surface of the second housing part 2120. For example, in the third state, the first housing part 2110 and the second housing part 2120 may be folded, and the second housing part 2120 and the third housing part 2130 may be unfolded.

However, it is not limited thereto, and in the third state, the front surface of the first housing part 2110 and the front surface of the second housing part 2120 may face the same direction, and the rear surface of the second housing part 2120 may face the rear surface of the third housing part 2130. For example, in the third state, the second housing part 2120 and the third housing part 2130 may be folded, and the first housing part 2110 and the second housing part 2120 may be unfolded. The electronic device 2100 may be changed from the first state 2100a to the second state 2100b through the third state. The electronic device 2100 may be changed from the first state 2100a that is an unfolded state to the third state that is a partially unfolded state. For example, the electronic device 2100 may be changed from the first state 2100a in which the first housing part 2110, the second housing part 2120, and the third housing part 2130 face the same direction to the third state in which the front surface of the first housing part 2110 faces the front surface of the second housing part 2120. The electronic device 2100 may be changed from the third state 2100c that is a partially unfolded state to the second state 2100b that is a folded state. For example, when the third state 2100c changes to the second state 2100b, the folded first housing part 2110 and second housing part 2120 may be disposed on the third housing part 2130. As the state of the electronic device 2100 changes to the second state 2100b, the rear surface of the second housing part 2120 folded with respect to the first housing part 2110 may face the rear surface of the third housing part 2130.

The flexible display 2140 may at least partially define an exterior of the electronic device 2100. The flexible display 2140 may be partially disposed within the housing structure 2101. The flexible display 2140 may define a front surface of the electronic device 2100. The flexible display 2140 may include a first unbendable portion 2141, a second unbendable portion 2142, a third unbendable portion 2143, a first bendable portion 2144, and a second bendable portion 2145. The first unbendable portion 2141 of the flexible display 2140 may be disposed on the front surface of the first housing part 2110. The second unbendable portion 2142 of the flexible display 2140 may be disposed on the front surface of the second housing part 2120. The third unbendable portion 2143 of the flexible display 2140 may be disposed on the front surface of the third housing part 2130. The first bendable portion 2144 of the flexible display 2140 may be disposed between the first unbendable portion 2141 and the second unbendable portion 2142 of the flexible display 2140. For example, the first bendable portion 2144 of the flexible display 2140 may be disposed on the first hinge structure 2150 connecting the first housing part 2110 and the second housing part 2120. The second bendable portion 2145 of the flexible display 2140 may be disposed between the second unbendable portion 2142 and the third unbendable portion 2143 of the flexible display 2140. For example, the second bendable portion 2145 of the flexible display 2140 may be disposed on the second hinge structure 2160 connecting the second housing part 2120 and the third housing part 2130.

The first hinge structure 2150 and the second hinge structure 2160 may face substantially the same direction as the first unbendable portion 2141, the second unbendable portion 2142, and the third unbendable portion 2143 of the flexible display 2140. In the first state 2100a, the first bendable portion 2144 and the second bendable portion 2145 may be disposed in substantially the same horizontal plane as the first unbendable portion 2141, the second unbendable portion 2142, and the third unbendable portion 2143.

The first hinge structure 2150 and the second hinge structure 2160 may provide the second state 2100b of the electronic device 2100. In the second state 2100b, the first unbendable portion 2141 of the flexible display 2140 may face the third unbendable portion 2143 of the flexible display 2140, and the second unbendable portion 2142 of the flexible display 2140 may be visible through the front surface of the second housing part 2120. In the second state 2100b, the first bendable portion 2144 of the flexible display 2140 may be folded so that the first unbendable portion 2141 of the flexible display 2140 and the second unbendable portion 2142 of the flexible display 2140 face different directions. In the second state 2100b, the second bendable portion 2145 of the flexible display 2140 may be folded so that the second unbendable portion 2142 of the flexible display 2140 and the third unbendable portion 2143 of the flexible display 2140 face different directions.

In the first state 2100a, the entire display area of the flexible display 2140 may be visible from the front surface of the housing structure 2101. For example, a first display area 2140a, a second display area 2140b, and a third display area 2140c of the flexible display 2140 may be visually exposed. The electronic device 2100 may provide a user with a large display area including the first display area 2140a, the second display area 2140b, and the third display area 2140c within the first state 2100a. In the second state 2100b, the display area of the flexible display 2140 may be partially visible. For example, the first display area 2140a and the second display area 2140b of the flexible display 2140 may not be visually exposed, and the third display area 2140c may be visually exposed.

As a non-limiting example, when the flexible display 2140 is used to display a screen in the first state 2100a of the electronic device 2100, the first display area 2140a, the second display area 2140b, and the third display area 2140c of the flexible display 2140 may be activated. As a non-limiting example, when the flexible display 2140 is used to display a screen in the second state of the electronic device 2100, the third display area 2140c may be activated, and the first display area 2140a and the second display area 2140b of the flexible display 2140 may be deactivated.

As a non-limiting example, when the flexible display 2140 is used to display a screen in the first state 2100a of the electronic device 2100, the first display area 2140a, the second display area 2140b, and the third display area 2140c of the flexible display 2140 may display visual information. As a non-limiting example, when the flexible display 2140 of the electronic device 2100 is used to display a screen in the second state 2100b or the third state, the third display area 2140c may provide visual information, and the first display area 2140a and the second display area 2140b of the flexible display 2140 may provide a black image.

It is illustrated that the second housing part 2120 and the third housing part 2130 rotate in the same direction with respect to the first housing part 2110, but it is not limited thereto. For example, while changing from the first state 2100a to the second state 2100b, the first housing part 2110 may rotate clockwise with respect to the second housing part 2120, and the third housing part 2130 may rotate counterclockwise with respect to the second housing part 2120. As the first housing part 2110 and the third housing part 2130 rotate in different directions, the display area of the flexible display 2140 may be deactivated without being visually exposed in the second state.

According to embodiments of the disclosure, a RF line structure with stacked conductive lines (e.g., RF line structure 231 and/or RF line structure 235 may also be applied to the foldable-type electronic device (e.g., electronic device 101) of FIGS. 21A and 21B. According to an embodiment, a foldable-type electronic device (e.g., electronic device 101) may include an RF line structure disposed in a fill-cut area of a PCB of the first housing part 2110. In the RF line structure, a plurality of conductive lines may be stacked along a stacking direction of the PCB. The conductive lines may be spaced apart at regular intervals. The conductive lines may be coupled through a plurality of vias. A portion of a metal frame of the first housing part 2110 may be connected to the RF line structure and used as an antenna radiator. According to another embodiment, a foldable-type electronic device (e.g., electronic device 101) may include an RF line structure disposed in a fill-cut area of a PCB of the second housing part 2120 and having stacked conductive lines. A portion of a metal frame of the second housing part 2120 may be connected to the RF line structure and used as an antenna radiator. According to yet another embodiment, a foldable-type electronic device (e.g., electronic device 101) may include an RF line structure disposed in a fill-cut area of a PCB of the third housing part 2130 and having stacked conductive lines. A portion of a metal frame of the third housing part 2130 may be connected to the RF line structure and used as an antenna radiator.

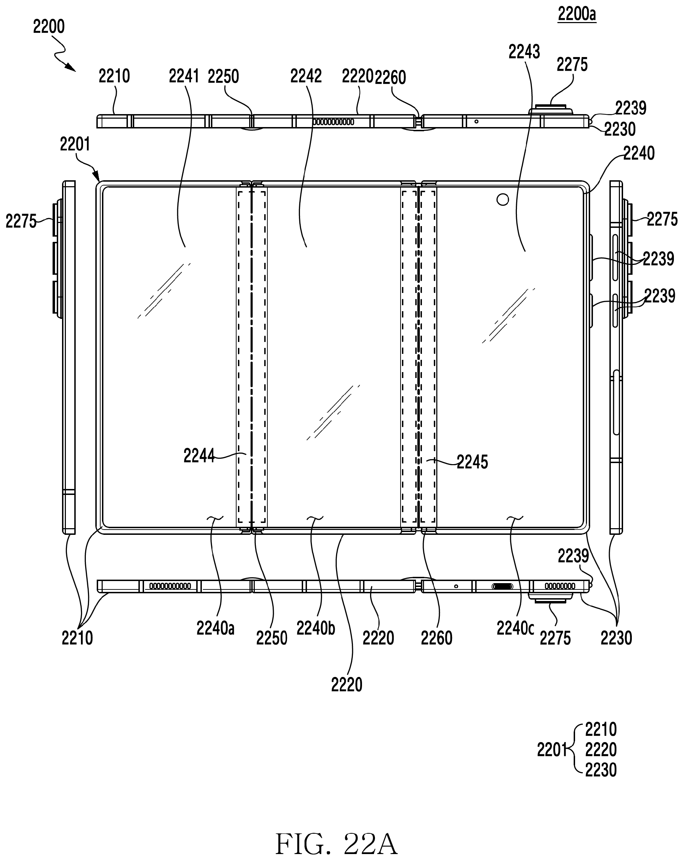

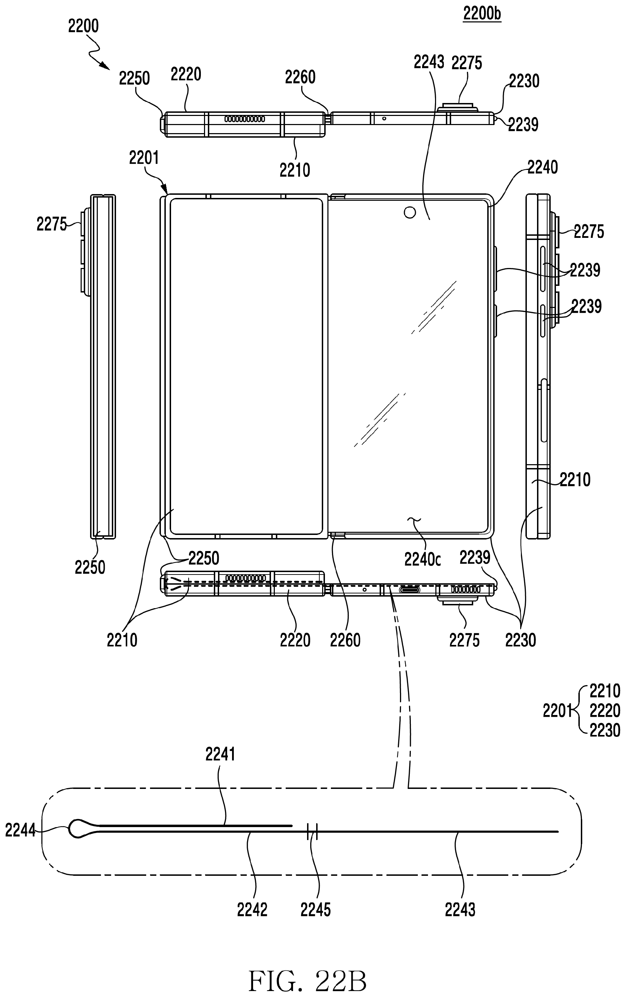

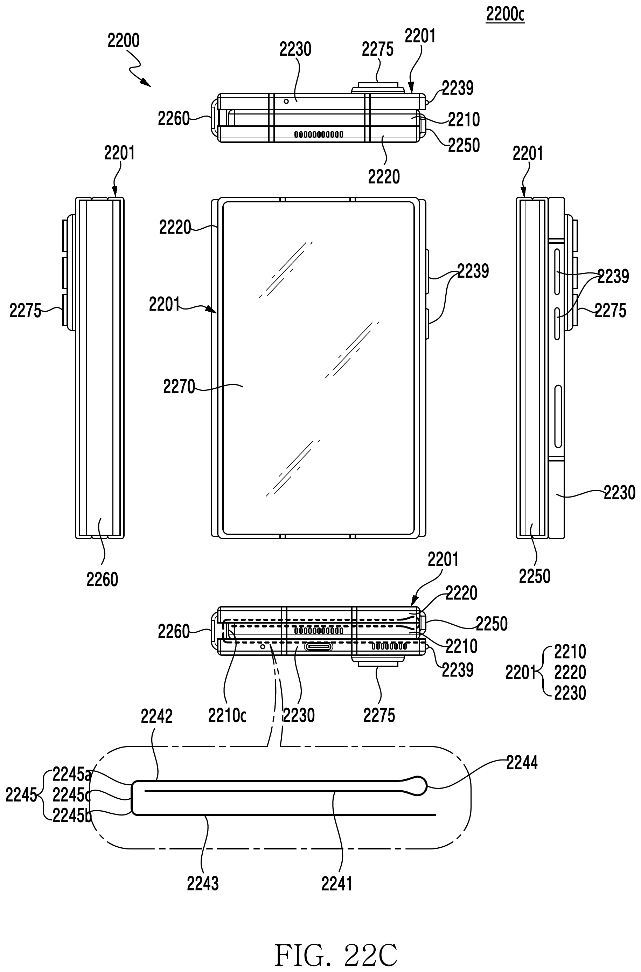

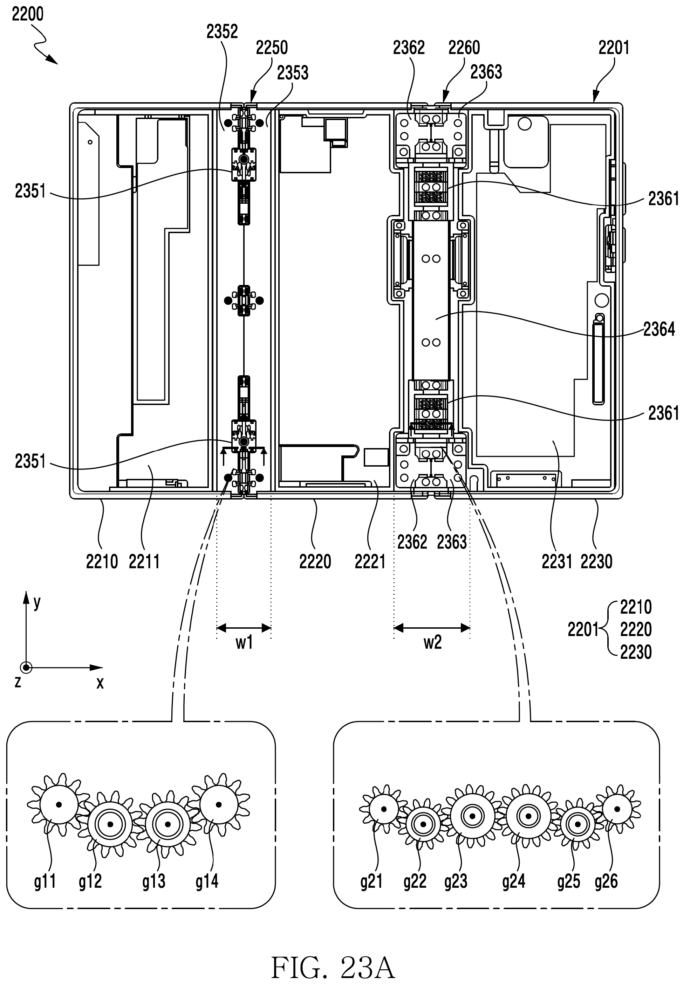

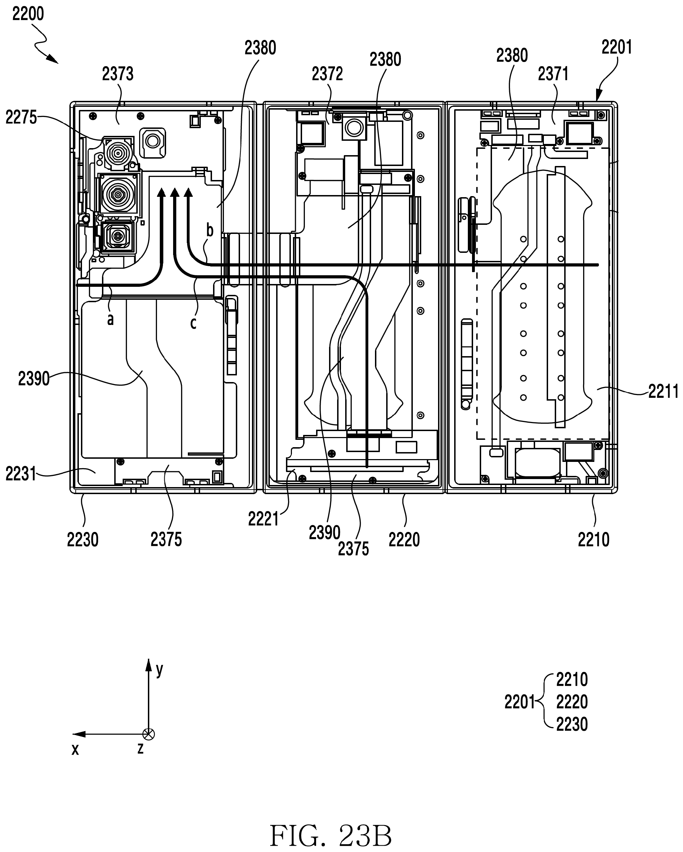

FIG. 22A, FIG. 22B, FIG. 22C, FIG. 23A, and FIG. 23B illustrate an example of foldable-type electronic device (e.g., electronic devices (101)). FIG. 22A illustrates an example of a first state 2200a of an electronic device. FIG. 22B illustrates an example of a second state 2200b of an electronic device. FIG. 22C illustrates an example of a third state of an electronic device.

Referring to FIG. 22A, FIG. 22B and FIG. 22C, an electronic device 2200 may include a housing structure 2201, a flexible display 2240, a first hinge structure 2250, a second hinge structure 2260, and a display 2270. The housing structure 2201 may include a first housing part 2210, a second housing part 2220, and a third housing part 2230.

The first housing part 2210 may be rotatably coupled with the second housing part 2220 by the first hinge structure 2250. The second housing part 2220 and the first housing part 2210 may rotate with respect to the first hinge structure 2250. While the first housing part 2210 is rotated with respect to the first hinge structure 2250, the second housing part 2220 is rotated with respect to the first hinge structure 2250. For example, when the second housing part 2220 and the first housing part 2210 are rotated with respect to the first hinge structure 2250, angular displacement of the second housing part 2220 is substantially equal to angular displacement of the first housing part 2210.

The third housing part 2230 may be rotatably coupled with the second housing part 2220 by the second hinge structure 2260. The second housing part 2220 and the third housing part 2230 may rotate with respect to the second hinge structure 2260. While the second housing part 2220 is rotated with respect to the second hinge structure 2260, the third housing part 2230 is rotated with respect to the second hinge structure 2260. For example, when the second housing part 2220 and the third housing part 2230 are rotated with respect to the second hinge structure 2260, angular displacement (or angular change) of the second housing part 2220 is substantially equal to angular displacement of the third housing part 2230.

The first hinge structure 2250 and the second hinge structure 2260 may change a state of the electronic device 2200. The first hinge structure 2250 and the second hinge structure 2260 may provide (or enable) a first state 2200a of the electronic device 2200 (or a first state 2200a of the housing structure 2201). The first state 2200a of the electronic device 2200 (or the housing structure 2201) may be described as a state of the electronic device 2200 (or the housing structure 2201) being unfolded (or an unfolded state). In the first state 2200a, a front side of the first housing part 2210, a front side of the second housing part 2220, and a front side of the third housing part 2230 may define a front side of the electronic device 2200. In the first state 2200a, the front side of the first housing part 2210, the front side of the second housing part 2220, and the front side of the third housing part 2230 may face the same direction. In the first state 2200a, the electronic device 2200 may provide a user with a larger display area of the flexible display 2240.

The first hinge structure 2250 and the second hinge structure 2260 may provide a second state 2200b of the electronic device 2200. The second state 2200b of the electronic device 2200 may be described as a state of the electronic device 2200 (or the housing structure 2201) being partially unfolded and partially folded (or single folded state or half folded state). For example, in the second state 2200b, the front side of the second housing part 2220 and the front side of the third housing part 2230 may face the same direction and the front side of the first housing part 2210 and the front side of the second housing part 2220 may be face opposite directions. For example, in the second state 2200b, the first housing part 2210 and the second housing part 2220 may be folded and the second housing part 2220 and the third housing part 1 30 may be unfolded. In the second state 2200b, the electronic device 2200 may provide the visual information through a portion of the flexible display 2240 (e.g., the third display area 2240c).

The electronic device 2200 may change from the first state 2200a to the second state 2200b through the second state 2200b. The electronic device 2200 may change from the first state 2200a, which is an unfolded state, to the second state 2200b, which is a partially unfolded state. For example, the electronic device 2200 may change from the first state 2200a in which the first housing part 2210, the second housing part 2220, and the third housing part 2230 face the same direction, to the second state 2200b in which the front surface of the first housing part 2210 faces the front surface of the second housing part 2220. The electronic device 2200 may change from the second state 2200b, which is a partially unfolded state, to the second state 2200b, which is a folded state. For example, when changing from the second state 2200b to the second state 2200b, the folded first housing part 2210 and the second housing part 2220 may be disposed on the third housing part 2230.

The first hinge structure 2250 and the second hinge structure 2260 may provide a third state 2200c of the electronic device 2200 (or a third state 2200c of the housing structure 2201). The third state 2200c of the electronic device 2200 (or the third state 2200c of the housing structure 2201) may be described as a state of the electronic device 2200 (or the housing structure 2201) being folded (or a folded state or a multi folded state). In the third state 2200c, the front side of the first housing part 2210 and the front side of the second housing part 2220 may face opposite directions and the front side of the second housing part 2220 and the front side of the third housing part 2230 may face opposite directions. In the third state 2200c, the front side of the first housing part 2210 and the front side of the third housing part 2230 may face the same direction. For example, in the third state 2200c, the front side of the second housing part 2220 may face the front side of the first housing part 2210 and the front side of the third housing part 2230 may face a rear side of the first housing part 2210. In the third state 2200c, a rear side of the second housing part 2220 may be externally exposed. The display 2270 may be disposed on the rear side of the second housing part 2220. In the third state 2200c, a rear side of the third housing part 2230 may be externally exposed. The camera may be disposed on the rear side of the third housing part 2230. In the third state 2200c, the electronic device 2200 may be folded to improve portability and provide visual information through the display 2270 disposed on the rear side of the second housing part 2220.

The electronic device 2200 may further comprise a key button 2239. The key button 2239 may be exposed from a structure formed on the lateral side of the third housing part 2230 and partially protrude from the lateral side of the third housing part 2230. The key button 2239 may provide a physical input to processing circuitry in the electronic device, by the pressure transferring from outside. The key button 2239 may not be included in the electronic device 2200 and may be implemented in other forms, such as a soft key displayed on the flexible display 2240 or display 2270.

The key button 2239 may be disposed on the lateral side of the third housing part 2230 to be exposed to the outside in the second state 2200b. The key button 2239 disposed on the third housing part may not be moved, even if it is changed from the second state 2200b to the first state 2200a by the user looking at the display 2270. For example, referring to FIG. 22A, in the first state 2200a, when the flexible display 2240 is viewed from above, the key button 2239 may be placed on the right side. Referring to FIG. 22B, in the second state 2200b, when the display 2270 is viewed from above, the key button 2239 may be placed on the right side.

The flexible display 2240 may at least partially define an exterior of the electronic device 2200. The flexible display 2240 may be partially disposed in the housing structure 2201. The flexible display 2240 may define the front side of the electronic device 2200. The flexible display 2240 may include a first unbendable portion 2241, a second unbendable portion2242, a third unbendable portion2243, a first bendable portion 2244, and a second bendable portion 2245. The first unbendable portion2241 of the flexible display 2240 may be disposed on the front side of the first housing part 2210. The second unbendable portion2242 of the flexible display 2240 may be disposed on the front side of the second housing part 2220. The third unbendable portion2243 of the flexible display 2240 may be disposed on the front side of the third housing part 2230. The first bendable portion 2244 of the flexible display 2240 may be disposed between the first unbendable portion 2241 and the second unbendable portion2242 of the flexible display 2240. For example, the first bendable portion 2244 of the flexible display 2240 may be disposed on the first hinge structure 2250 coupling the first housing part 2210 and the second housing part 2220. The second bendable portion 2245 of the flexible display 2240 may be disposed between the second unbendable portion2242 and the third unbendable portion2243 of the flexible display 2240. For example, the second bendable portion 2245 of the flexible display 2240 may be disposed on the second hinge structure 2260 coupling the second housing part 2220 and the third housing part 2230.

The first hinge structure 2250 and the second hinge structure 2260 may provide the first state 2200a in which the first unbendable portion 2241 of the flexible display 2240, the second unbendable portion2242 of the flexible display 2240, and the third unbendable portion2243 of the flexible display 2240 face the same direction. In the first state 2200a, the first bendable portion 2244 of the flexible display 2240 and the second bendable portion 2245 may be disposed in a substantially same horizontal plane with the first unbendable portion2241, the second unbendable portion2242 and the third unbendable portion 2243 of the flexible display 2240.

The first hinge structure 2250 and the second hinge structure 2260 may provide the second state 2200b of the electronic device 2200. In the second state 2200b, the second unbendable portion 2242 of the flexible display 2240 may face the first unbendable portion 2241 of the flexible display 2240 and the third unbendable portion 2243 of the flexible display 2240 may face the rear side of the first housing part 2210.

In the second state 2200b, the first bendable portion 2244 of the flexible display 2240 may be folded such that the first unbendable portion2241 of the flexible display 2240 and the second unbendable portion2242 of the flexible display 2240 face in opposite directions, as the first bendable portion 2244 of the flexible display 2240 is bent by the first hinge structure 2250.

In the second state 2200b, as the second bendable portion 2245 of the flexible display 2240 is maintained in an unfolded state by the second hinge structure 2260, the second bendable portion 2245 of the flexible display 2240 may be unfolded so that the second unbendable portion 2242 of the flexible display 2240 and the third unbendable portion 2243 of the flexible display 2240 face the same directions.

The first hinge structure 2250 and the second hinge structure 2260 may provide a third state 2200c of the electronic device 2200. In the third state 2200c, the second unbendable portion 2242 of the flexible display 2240 may face the first unbendable portion 2241 of the flexible display 2240, and the third unbendable portion 2243 of the flexible display 2240 may face a rear surface of the first housing part 2210.

In the third state 2200c, as the first bendable portion 2244 of the flexible display 2240 is bent by the first hinge structure 2250, the first bendable portion 2244 of the flexible display 2240 may be folded so that the first unbendable portion 2241 of the flexible display 2240 and the second unbendable portion 2242 of the flexible display 2240 face different directions.

In the third state 2200c, the second bendable portion 2245 of the flexible display 2240 may be folded such that the second unbendable portion2242 of the flexible display 2240 and the third unbendable portion2243 of the flexible display 2240 face in opposite directions, as the second bendable portion 2245 of the flexible display 2240 is bent by the second hinge structure 2260. The second bendable portion 2245 may further include a first deformable portion 2245a, a second deformable portion 2245b, and a planar portion 2245c. The first deformable portion 2245a is disposed between the planar portion 2245c and the second unbendable portion 2242 and the second deformable part 2245b may be disposed between the planar part 2245c and the third unbendable part 2243. The planar portion 2245c may be disposed between the first deformable portion 2245a and the second deformable portion 2245b. The planar portion 2245c may be supported by a support plate (e.g., the support plate 2364 in FIG. 23A) that is distinct from the hinge plates of the second hinge structure 2260 (e.g., the third hinge plate 2362 and fourth hinge plate 2363 in FIG. 23A). Regardless of the state of the electronic device 2200, the planar portion 2245c may remain plane. The first deformable portion 2245a and the second deformable portion 2245b are unfolded in the first state 2200a and the third state 2200b, the first deformable part 2245a and the second deformable part 2245b may be bent in the third state 2200c so that the second unbendable part 2242 and the third unbendable part 2243 face different directions. In the third state 2200c, the first housing part 2210 may be disposed between the second housing part 2220 and the third housing part 2230. In the third state 2200c, the second bendable part 2245 of the flexible display 2240 disposed on the second hinge structure 2260 may be partially face to a lateral side 2210c of the first housing part 2210.

The display area of the flexible display 2240 may include a first display area 2240a, a second display area 2240b, and a third display area 2240c. The display area may represent an area where visual information can be provided from the flexible display 2240. In the first state 2200a, the entire display area of the flexible display 2240 may be viewable from the front side of the housing structure 2201. For example, in the first state 2200a, the first display area 2240a, the second display area 2240b, and the third display area 2240c of the flexible display 2240 may be visually exposed. The electronic device 2200 may provide a user with a larger display area including the first display area 2240a, the second display area 2240b, and the third display area 2240c.

In the second state 2200b, the display area of the flexible display 2240 may be not viewable. For example, in the second state 2200b, the first display area 2240a, the second display area 2240b, and the third display area 2240c of the flexible display 2240 may not be visually exposed.

In the third state, the display area of the flexible display 2240 may be partially viewable from the front side of the third housing part 2230. For example, the third display area 2240c may be visually exposed and, the first display area 2240a and the second display area 2240b may not be visually exposed.

As a non-limiting example, when the flexible display 2240 is, in the first state 2200a of the electronic device 2200, used for displaying a screen, the first display area 2240a, the second display area 2240b, and the third display area 2240c of the flexible display 2240 are enabled. As a non-limiting example, in the second state 2200b of the electronic device 2200, the first display area 2240a, the second display area 2240b, and the third display area 2240c of the flexible display 2240 may be disabled. As a non-limiting example, when the flexible display 2240 is, in the third state of the electronic device 2200, used for displaying a screen, the third display area may be enabled and the first display area 2240a and the second display area 2240b of the flexible display 2240 may be disabled.

As a non-limiting example, when the flexible display 2240 is used to display a screen, in the first state 2200a of the electronic device 2200, the first display area 2240a of the flexible display 2240, the second display area 2240b and third display area 2240c may display visual information. As a non-limiting example, in the second state 2200b, the first display area 2240a, the second display area 2240b, and the third display area 2240c of the flexible display 2240 may provide a black image. As a non-limiting example, in the third state 2200c of the electronic device 2200, when the flexible display 2240 is used to display a screen, the third display area 2240c may provide visual information, and the first display area 2240a and the second display area 2240b of the flexible display 2240 may provide a black image.

FIG. 23A illustrates a top view of an electronic device with the flexible display removed. FIG. 23B illustrates a rear view of an electronic device with a rear cover and a display removed.

Referring to FIG. 23A and FIG. 23B, the electronic device 2200 may include the first hinge structure 2250 and the second hinge structure 2260. A width w1 of the first hinge structure 2250 may be narrower than a width w2 of the second hinge structure 2260. The difference between the width w1 of the first hinge structure 2250 and the width w2 of the second hinge structure 2260 may be equal to or greater than the thickness of the first housing part 2210. For example, the second hinge structure 2260 may have the width w2 wider than the width w1, such that the first housing part 2210 is, according to the second state 2200b, disposed between the second housing part 2220 and the third housing part 2230. The first hinge structure 2250 may refer to a narrow hinge structure, in terms of having the narrower width than the second hinge structure 2260. The second hinge structure 2260 may refer to a wider hinge structure, in terms of having the wider width than the first hinge structure 2250.

The first hinge structure 2250 may include a first set 2351 of gears, a first hinge plate 2352, and a second hinge plate 2353. The first hinge plate 2352 may be coupled to the first supporting portion 2211 of the first housing part 2210. The second hinge plate 2353 may be coupled to the second supporting portion 2221 of the second housing part 2220. The gears g11, g12, g13 and g14 included in the first set 2351 of gears may be configured to rotate the first hinge plate 2352 and the second hinge plate 2353. For example, the gears g11, g12, g13 and g14 included in the first set 2351 of gears may rotate the second hinge plate 2353 (or the second housing part 2220) in conjunction with rotation of the first hinge plate 2352 (or the first housing part 2210). When the first hinge plate 2352 (or the first housing part 2210) is rotated, the gears g11, g12, g13 and g14 included in the first set 2351 of gears may be rotated according to the rotation of the first hinge plate 2352 (or the first housing part 2210). The second hinge plate 2353 (or the second housing part 2220) is rotated in conjunction with rotation of the first hinge plate 2352 according to the rotation of the gears included in the first set 2351 of gears. The gears g11, g12, g13, g14 included in the first set of gears 2351 may include the first gear g11, the second gear g12, the third gear g13, and the fourth gear g14. The first gear g11 may be disposed adjacent to the first hinge plate 2352, and the fourth gear g14 may be disposed adjacent to the second hinge plate 2353. The second gear g12 and the third gear g13 may be disposed between the first gear g11 and the fourth gear g14. The first gear g11, the second gear g12, the third gear g13, and the fourth gear g14 may be sequentially engaged. According to the rotation of the first rotation direction (e.g. clockwise) of the first gear g11, the second gear g12 engaged with the first gear g11 may rotate in the second rotation direction (e.g. counterclockwise) opposite to the first rotation direction. According to the rotation of the second rotation direction of the second gear g12, the third gear g13 engaged with the second gear g12 may rotate in the first rotation direction. According to the rotation of the first rotation direction of the third gear g13, the fourth gear g14 may rotate in the second rotation direction. As the first gear g1 and the fourth gear g14 rotate in different directions, the first housing part 2210 connected to the first hinge plate 2352 and the second housing part 2220 connected to the second hinge plate 2353 may be folded or unfolded.

The second hinge structure 2260 may include a second set 2361 of gears, a third hinge plate 2362, a fourth hinge plate 2363, and a supporting plate 2364. The third hinge plate 2362 may be coupled to a second supporting portion 2221 of the second housing part 2220. The fourth hinge plate 2363 may be coupled to a third supporting portion 2231 of the third housing part 2230. The gears g21, g22, g23, g24, g25, and g26 included in the second set 2361 of gears may be configured to rotate the third hinge plate 2362 and the fourth hinge plate 2363. For example, the gears g21, g22, g23, g24, g25, and g26 included in the second set 2361 of gears may rotate the fourth hinge plate 2364 (or the third housing part 2230) in conjunction with rotation of the third plate 2363 (or the second housing part 2220). After the third hinge plate 2362 (or the second housing part 2220) is rotated, the gears g21, g22, g23, g24, g25, and g26 included in the second set 2361 of gears may be rotated according to the rotation of the third hinge plate 2362 (or the second housing part 2220). The fourth hinge plate 2363 (or the third housing part 2230) is rotated in conjunction with rotation of the third hinge plate 2362 (or the second housing part 1 20) according to the rotation of the gears g21, g22, g23, g24, g25, and g26included in the second set 2361 of gears.

The gears g21, g22, g23, g24, g25 and g26 included in the second set of gears 2361 may include the first gear g21, the second gear g22, the third gear g23, the fourth gear g24, the fifth gear g25, and the sixth gear g26. The first gear g21 may be disposed adjacent to the third hinge plate 2362, and the sixth gear g26 may be disposed adjacent to the fourth hinge plate 2363. The second gear g22, the third gear g23, the fourth gear g24, and the fifth gear g25 may be disposed between the first gear g11 and the fourth gear g14. the first gear g21, the second gear g22, the third gear g23, the fourth gear g24, the fifth gear g25, and the sixth gear g26may be sequentially engaged. According to the rotation of the first rotation direction (e.g. clockwise) of the first gear g21, the second gear g22 engaged with the first gear g21 may rotate in the second rotation direction (e.g. counterclockwise) opposite to the first rotation direction. According to the rotation of the second rotation direction of the second gear g22, the third gear g23 engaged with the second gear g22 may rotate in the first rotation direction. According to the rotation of the first rotation direction of the third gear g23, the fourth gear g24 may rotate in the second rotation direction. According to the rotation of the second rotation direction of the fourth gear g24, the fifth gear g25 engaged with the fourth gear g24 may rotate in the first rotation direction. According to the rotation of the first rotation direction of the fifth gear g25, the sixth gear g26 may rotate in the second rotation direction. As the first gear g21 and the sixth gear g26 rotate in different directions, the second housing part 2220 connected to the third hinge plate 2362 and the third housing part 2230 connected to the fourth hinge plate 2363 may be folded or unfolded.

The first hinge structure 2250 and the second hinge structure 2260 may further include a spiral structure. The spiral structure may include a spiral groove formed in each hinge plate or a rotating member connected to the hinge plate and a moving member sliding along the spiral groove. The hinge plates connected to the hinge structure rotate at substantially the same angular displacement through the spiral structure.

The electronic device 2200 may include a first printed circuit board 2371, a second printed circuit board 2371, and a third printed circuit board 2373.

The first printed circuit board 2371 may be disposed on the first supporting portion 2211 of the first housing part 2210. The hardware components in the first housing part 2210 may be mounted on the first printed circuit board 2371. The second printed circuit board 2371 may be disposed on the second supporting portion 2221 of the second housing part 2220. The hardware components in the second housing part 2220 may be mounted on the second printed circuit board 2372. The third printed circuit board 2373 may be disposed on the third supporting portion 2231 of the third housing part 2230. The hardware components in the third housing part 2230 may be mounted on the third printed circuit board 2373.

The hardware components disposed on the first printed circuit board 2271 may support the hardware components mounted on the second printed circuit board 2272 and/or the third printed circuit board 2273 or may independently operate.

The hardware components disposed on the second printed circuit board 2372 may support the hardware components disposed on the first printed circuit board 2371 or the third printed circuit board 2273 or may independently operate. The hardware components disposed on the second printed circuit board 2372 may include a speaker, and/or a front camera.

The hardware components disposed on the third printed circuit board 2273 may include at least one processor (e.g., application processor (AP), communication processor (CP)) including processing circuitry, memory including one or more storage media, communication circuitry, and a rear camera 2275. The rear camera 2275 may be exposed through a structure (e.g., opening) of the rear side of the second housing part 2220.

The electronic device 2200 may further include a sub printed circuit board 2375 and flexible printed circuit boards 2380 and 2390. The sub printed circuit board 2375 may be disposed on at least a portion of the first housing part 2210, the second housing part 2220, and the third housing part 2230. The flexible printed circuit boards 2380 and 2390 may include a first flexible printed circuit board 2380 and a second flexible printed circuit board 2390. The first flexible printed circuit board 2380 may electrically connect printed circuit boards disposed on each of the housing parts 2210, 2220, and 2230. The second flexible printed circuit board 2390 may connect the sub printed circuit board 2375 to the printed circuit board in the housing part in which the sub printed circuit board 2375 is disposed, through the second flexible printed circuit board 2390.

Components in the electronic device 2200 may be connected to at least one processor in the third printed circuit board 2373 through flexible printed circuit boards 2380 and 2390. For example, a signal received from an antenna disposed in the third housing part 2230 may be transmitted to the third printed circuit board 2373 on which at least one processor (e.g., AP or CP) is disposed, through a signal path a provided by the first flexible printed circuit board 2380. The driving circuit for the flexible display 2240 disposed in the first housing part 2210 may be connected to the third printed circuit board 2373 on which at least one processor (e.g., AP), through a signal path (b) provided by the sub printed circuit board 2375 and the first flexible printed circuit board 2380. The driving circuit for the display 2270 connected to the sub printed circuit board 2375 disposed in the second housing part 2220 may be electrically connected to the third printed circuit board 2373, on which at least one processor (e.g., AP) is disposed, through the signal path (c) provided by the sub printed circuit board 2375, the first flexible printed circuit board 2380, and the second flexible printed circuit board 2390.

The electronic device 2200 may further include batteries. Each of the batteries may be adhere to the supporting portions included in the housing parts 2210, 2220, and 2230. The supporting portions 2211, 2221, and 2231 may support the rechargeable batteries.

The arrangement of the hardware components is exemplary, differently from described above, and the rear camera 2275 and the second printed circuit board 2371 may be disposed in the third housing part 2230, and the third printed circuit board 2373 may be disposed in the second housing part 2220.

The first housing part 2210 and the third housing part 2230 are shown as rotating in opposite directions with respect to the second housing part 2220 but are not limited thereto. For example, while changing from the first state 2200a to the second state 2200b, the first housing part 2210 may rotate counterclockwise with respect to the second housing part 2220, and the third housing part 2230 may rotate counterclockwise with respect to the second housing part 2220. In the second state, a portion of the display area of the flexible display 2240 may be visually exposed, as the first housing part 2210 and the third housing part 2230 rotate in the same direction.

An RF line structure in which conductive lines are stacked according to embodiments of the present disclosure may also be applied to the foldable type electronic device (e.g., the electronic device 101) of FIGS. 22A, 22B, 22C, 23A, and 23B. According to an embodiment, the foldable type electronic device (e.g., the electronic device 101) may include an RF line structure disposed in a fill-cut area of a PCB (e.g., the first printed circuit board 2371) of the first housing part 2210. In the RF line structure, multiple conductive lines may be stacked along a stacking direction of the PCB. The conductive lines may be spaced apart from each other at a predetermined interval. The conductive lines may be coupled through multiple vias. A portion of a metal frame of the first housing part 2210 may be used as an antenna radiator by being connected to the RF line structure. According to another embodiment, the foldable type electronic device (e.g., the electronic device 101) may include an RF line structure disposed in a fill-cut area of a PCB (e.g., the second printed circuit board 2372) of the second housing part 2220 and in which conductive lines are stacked. A portion of a metal frame of the second housing part 2220 may be used as an antenna radiator by being connected to the RF line structure. According to another embodiment, the foldable type electronic device (e.g., the electronic device 101) may include an RF line structure disposed in a fill-cut area of a PCB (e.g., the third printed circuit board 2373) of the third housing part 2230 and in which conductive lines are stacked. A portion of a metal frame of the third housing part 2230 may be used as an antenna radiator by being connected to the RF line structure.

The effects that may be obtained from the present disclosure are not limited to those described above, and any other effects not mentioned herein will be clearly understood by those having ordinary knowledge in the art to which the present disclosure belongs, from the following description.

In the present disclosure, it is described as an example in which an RF line structure (e.g., an RF line structure 231 or an RF line structure 235) according to embodiments is disposed in a signal area (e.g., a signal area 253) of a circuit board (e.g., a PCB 250). However, embodiments of the present disclosure are not limited thereto. Any RF line structure including conductive lines disposed in a plurality of layers and first conductive via and second conductive via that are connected to the conductive lines can be understood as an embodiment of the present disclosure. For example, the electronic device 101 may include an RF line structure formed across a plurality of layers in an area other than a fill-cut area (e.g., a ground area 251).

In embodiments of the present disclosure, an electronic device 101 may be provided. The electronic device 101 may comprise a conductive portion 203 forming at least a portion of a side of the electronic device 101; wireless communication circuitry 220; a printed circuit board (PCB) 250 including a plurality of layers, on which the wireless communication circuitry 220 is disposed; a radio frequency (RF) line structure 231 disposed in the PCB 250 and electrically connected to the wireless communication circuitry 220; and a contact member disposed on the PCB 250 to electrically connect the RF line structure 231 and the conductive portion 203. The RF line structure 231 may include a first conductive line disposed on a first layer of the plurality of layers of the PCB 250, a second conductive line disposed on a second layer of the plurality of layers of the PCB 250, a first conductive via penetrating between the first layer and the second layer and coupled to a first portion of the first conductive line and a second portion of the second conductive line, and a second conductive via penetrating between the first layer and the second layer and coupled to a third portion of the first conductive line and a fourth portion of the second conductive line.

For example, the first portion of the first conductive line may comprise a first end portion adjacent to the wireless communication circuitry 220 among the wireless communication circuitry 220 and the conductive portion 203. The second portion of the second conductive line may comprise a first end portion adjacent to the wireless communication circuitry 220 among the wireless communication circuitry 220 and the conductive portion 203. The third portion of the first conductive line may comprise a third end portion adjacent to the conductive portion 203 among the wireless communication circuitry 220 and the conductive portion 203. The fourth portion of the second conductive line may comprise a third end portion adjacent to the conductive portion 203 among the wireless communication circuitry 220 and the conductive portion 203.

For example, the first conductive line and the second conductive line may be used as a signal path between the wireless communication circuitry 220 and the contact member. An RF signal from the wireless communication circuitry 220 may be fed to the conductive portion 203 through the first conductive line, the second conductive line are, and the contact member.

For example, the wireless communication circuitry 220 may include a feeding circuit for providing an RF signal. An output port of the feeding circuit may be connected to the RF line structure 231. The plurality of layers of the PCB 250 may include at least one insulating layer and a plurality of metal layers. The wireless communication circuit may be disposed on a ground area of the PCB 250 where at least a portion of the plurality of metal layers overlaps the at least one insulating layer. The RF line structure 231 may be disposed in an area of the PCB 250 where only the RF line structure 231 among the plurality of metal layers overlaps with the at least one insulating layer between the ground area and the conductive portion 203.

For example, the electronic device 101 may comprise impedance matching circuitry electrically connected to the RF line structure 231, and a second RF line structure electrically connected to the impedance matching circuitry. The impedance matching circuitry may be electrically connected to the contact member through the second RF line structure.

For example, the wireless communication circuitry 220 may be disposed on a first side of the PCB 250. The contact member may be disposed on a second side of the PCB 250 opposite the first side. The impedance matching circuitry may be disposed on the second side. The second RF line structure may include a third conductive line disposed on the second side.

For example, the wireless communication circuitry 220 may be disposed on a first side of the PCB 250. The contact member may be disposed on a second side of the PCB 250 opposite the first side. The impedance matching circuitry may be disposed on the first side. The second RF line structure may comprise a third conductive line disposed on the first layer of the plurality of layers of the PCB 250, a fourth conductive line disposed on the second layer of the plurality of layers of the PCB 250, a third conductive via penetrating between the first layer and the second layer and coupled to a fifth portion of the first conductive line and a sixth portion of the second conductive line., and a fourth conductive via penetrating between the first layer and the second layer and coupled to a seventh portion of the first conductive line and an eighth portion of the second conductive line.

For example, the electronic device 101 may comprise an 'L'-shaped conductive pad coupled to the conductive portion 203. The wireless communication circuitry 220 may be disposed on a first side of the PCB 250. The contact member may be disposed on a second side of the PCB 250 opposite the first side. The conductive pad may comprise a first side coupled to a protruding portion of the conductive portion 203 and a second side contacting the contact member.

For example, the conductive portion 203 may be used as an antenna radiator for transmitting signals in multiple frequency bands. The multiple frequency bands may include a frequency band of about 3 gigahertz (GHz) or above. Each conductive line among the conductive lines has a width of about 0.135 millimeter (mm) or more and less than about 0.165mm, and a thickness of about 0.018mm or more and less than about 0.022mm.

For example, the contact member may comprise a support portion having a supporting side, an elastic portion connected to the support portion, a connecting portion connected to the elastic portion and disposed so as to be spaced apart from the supporting side, a first bending portion connected to the connecting portion and having a curved shape, and a second bending portion extending from the first bending portion and having a curved shape. The first bending portion may be configured to contact a point of the support portion while pressure is applied to the contact member. The second bending portion may be configured to contact a point of the connecting portion or the first bending portion while pressure is applied to the contact member.

For example, the supporting side of the support portion may be disposed on one side of the PCB 250. The first bending portion is disposed so as to contact the conductive portion 203 or a component coupled to the conductive portion 203.

For example, the contact member may comprise a second elastic portion connected to the support portion and a third bending portion connected to the second elastic portion and having a curved shape. The third bending portion may be configured to contact the first bending portion while pressure is applied to the contact member.

For example, the electronic device 101 may comprise a radiator, a flexible printed circuit board (FPCB 250) connected to the radiator, the FPCB 250 comprising a line portion including a strip line and a feeding portion including a conductive pattern, and a conductive structure disposed on the conductive pattern in the feeding portion.

For example, the electronic device 101 may comprise first conductive plates disposed in a first set of layers among the plurality of layers of the PCB 250, second conductive plates disposed in a second set of layers among the plurality of layers of the PCB 250, a fifth vertical via for electrically connecting the first conductive plates, and a sixth vertical via for electrically connecting the second conductive plates. The first set of layers and the second set of layers may be arranged alternately. The first conductive plates are connected to the contact member. The second conductive plates may be connected to the RF line structure 231.

For example, the contact member may be disposed on one side of one of the first conductive plates. The RF line structure 231 may be electrically connected to a feeding point formed on one of the second conductive plates.

In embodiments of the present disclosure, an electronic device 101 is provided. The electronic device 101 may include: a conductive portion 203 used as an antenna radiator for multiple frequency bands; a printed circuit board (PCB) 250 including at least one insulating layer and a plurality of metal layers, wherein the PCB 250 includes an RF line structure 231 for transmitting an RF (radio frequency) signal to the conductive portion 203; wireless communication circuitry 220 disposed on a ground area where at least a portion of the plurality of metal layers of the PCB 250 overlaps the at least one insulating layer; impedance matching circuitry disposed on the PCB 250 and connected to the RF line structure 231; and a contact member disposed on the PCB 250 and electrically connecting the impedance matching circuitry and the conductive portion 203. The RF line structure 231 may be disposed in an area of the PCB 250 where only the RF line structure 231 among the plurality of metal layers overlaps with the at least one insulating layer between the ground area and the conductive portion 203. The RF line structure 231 may include a plurality of conductive lines disposed on the plurality of metal layers of the PCB 250; and a plurality of conductive vias for connecting each of the conductive lines.

For example, the RF line structure 231 may include a first conductive line disposed on a first layer of the plurality of metal layers of the PCB 250; a second conductive line disposed on a second layer of the plurality of metal layers of the PCB 250; a first conductive via penetrating between the first layer and the second layer and coupled to a first portion of the first conductive line and a second portion of the second conductive line; And a second conductive via penetrating between the first layer and the second layer and coupled to a third portion of the first conductive line and a fourth portion of the second conductive line may be included.

For example, each of the plurality of conductive lines of the RF line structure 231 may function as an inductor in a signal path between the wireless communication circuitry 220 and the contact member. The plurality of frequency bands may include a frequency band of about 3 gigahertz (GHz) or more.

For example, the contact member may include a support portion having a support surface, an elastic portion connected to the support portion, a connection portion connected to the elastic portion and disposed to be spaced apart from the support surface, a first bend portion connected to the connection portion and having a curved shape, and a second bend portion extending from the first bend portion and having a curved shape. The first bend portion may be configured to contact a point of the support portion while pressure is applied to the contact member. The second bending portion may be configured to contact a point of the connecting portion or the first bending portion while pressure is applied to the contact member.

For example, the electronic device 101 may include a hinge assembly; a first housing part rotatably connected to the hinge assembly; and a second housing part rotatably connected to the hinge assembly. The conductive portion 203 may be included in the first housing part. The PCB 250, the RF line structure 231, the impedance matching circuitry, and the contact member may be disposed in the first housing part.

In embodiments of the present disclosure, an electronic device 101 is provided. The electronic device 101 may comprise a conductive portion 203, wireless communication circuitry 220, a printed circuit board (PCB) 250 including a ground area 251 for the wireless communication circuitry and a fill-cut area 253 formed between the ground area 251 and the conductive portion 203, a radio frequency (RF) line structure 231 formed in the fill-cut area 253 of the PCB and electrically connected to the wireless communication circuitry 220, and a contact member 240 or 1140 disposed on the PCB 250 to electrically connect the RF line structure 231 and the conductive portion 203. The RF line structure 231 may include conductive lines 330 including a conductive line disposed on each layer of at least two of multiple layers of the PCB 250, a first conductive via 341 coupled to each of the conductive lines 330, and a second conductive via 342 coupled to each of the conductive lines 330.

For example, each of the conductive lines 330 may have a same shape. Each conductive line among the conductive lines 330 may comprise a first end portion adjacent to the wireless communication circuitry 220 among the wireless communication circuitry 220 and the conductive portion 203, and a second end portion adjacent to the conductive portion 203 among the wireless communication circuitry 220 and the conductive portion 203. For each conductive line among the conductive lines 330, the first end portion may be coupled to the first conductive via 341. For each conductive line among the conductive lines 330, the second end portion may be coupled to the second conductive via 342. Two adjacent conductive lines among the conductive lines 330 may be spaced apart from each other by a predefined interval in a direction in which the multiple layers of the PCB 250 are stacked. The predefined interval may be chosen such as to maintain electrical isolation between the adjacent conductive lines.

For example, each conductive line among the conductive lines 330 of the RF line structure 231 may be used as a signal path between the wireless communication circuitry and the contact member 240 or 1140. An RF signal from the wireless communication circuitry may be fed to the conductive portion 203 through each conductive line of the conductive lines 330 of the RF line structure 231 and the contact member 240 or 1140.

For example, the wireless communication circuitry may include a feeding circuit for providing an RF signal. An output port of the feeding circuit may be connected to the RF line structure 231. The ground area 251 may include a metal layer having a copper portion. The fill-cut area 253 may be formed so as not to include a copper portion other than the RF line structure 231 in the PCB 250 between the ground area 251 and the conductive portion 203.

For example, the electronic device 101 may comprise impedance matching circuitry 233 including at least one component connected to the RF line structure 231, and a second RF line structure connected to the impedance matching circuitry 233. The impedance matching circuitry 233 may be electrically connected to the contact member 240 or 1140 through the second RF line structure.

For example, the wireless communication circuitry may be disposed on a first side of the PCB 250. The contact member 240 or 1140 may be disposed on a second side of the PCB 250 opposite the first side. The at least one component may be disposed on the second side. The second RF line structure may include a conductive line disposed on the second side.

For example, the wireless communication circuitry may be disposed on a first side of the PCB 250. The contact member 240 or 1140 may be disposed on a second side of the PCB 250 opposite the first side. The at least one component may be disposed on the first side. The second RF line structure may comprise second conductive lines 350 formed across at least two or more layers among the multiple layers, a third conductive via 361 connected to the second conductive lines, and a fourth conductive via 362 connected to the second conductive lines 350.

For example, the electronic device 101 may comprise an 'L'-shaped conductive pad coupled to the conductive portion 203. The wireless communication circuitry may be disposed on a first side of the PCB 250. The contact member 240 or 1140 may be disposed on a second side of the PCB 250 opposite the first side. The conductive pad may comprise a first side coupled to a protruding portion of the conductive portion 203 and a second side contacting the contact member 240 or 1140.

For example, the conductive portion 203 may be used as an antenna radiator for transmitting signals in multiple frequency bands. The multiple frequency bands may include a frequency band of about 3 gigahertz (GHz) or above. Each conductive line among the conductive lines 330 may have a width of about 0.135 millimeter (mm) or more and less than about 0.165mm, and each conductive line among the conductive lines 330 may have a thickness of about 0.018mm or more and less than about 0.022mm.

For example, the contact member 240 or 1140 may comprise a support portion having a supporting side, an elastic portion connected to the support portion, a connecting portion connected to the elastic portion and disposed so as to be spaced apart from the supporting side, a first bending portion connected to the connecting portion and having a curved shape, and a second bending portion extending from the first bending portion and having a curved shape. The first bending portion may be configured to contact a point of the support portion while pressure is applied to the contact member 240 or 1140. The second bending portion may be configured to contact a point of the connecting portion or the first bending portion while pressure is applied to the contact member 240 or 1140.

For example, the supporting side of the support portion may be disposed on one side of the PCB 250. The first bending portion may be disposed so as to contact the conductive portion 203 or a component coupled to the conductive portion 203.

For example, the contact member 240 or 1140 may comprise a second elastic portion connected to the support portion and a third bending portion connected to the second elastic portion and having a curved shape. The third bending portion may be configured to contact the first bending portion while pressure is applied to the contact member 240 or 1140.

For example, the electronic device 101 may comprise a radiator, a flexible printed circuit board (FPCB) 1600 or 1700 connected to the radiator, the FPCB 1600 or 1700 comprising a line portion including a strip line and a feeding portion including a conductive pattern, and a conductive structure disposed on the conductive pattern in the feeding portion.

For example, the electronic device 101 may comprise first conductive plates comprising a conductive plate disposed in each layer of a first set of layers of the PCB 250 in the fill-cut area 253, second conductive plates comprising a conductive plate disposed in each layer of a second set of layers of the PCB 250 in the fill-cut area 253, a first vertical via for electrically connecting the first conductive plates, and a second vertical via for electrically connecting the second conductive plates. The first set of layers and the second set of layers may be arranged alternately. The first conductive plates may be connected to the contact member 240 or 1140. The second conductive plates may be connected to the RF line structure 231.

For example, the contact member 240 or 1140 may be disposed on one side of one of the first conductive plates. The RF line structure 231 may be electrically connected to a feeding point formed on one of the second conductive plates.

In embodiments of the present disclosure, an electronic device 101 is provided. The electronic device 101 may comprise a conductive portion 203 used as an antenna radiator for multiple frequency bands, wireless communication circuitry, a printed circuit board (PCB) 250 including a first area 251 having ground for the wireless communication circuitry and a second area 253 in which at least a portion of a metal layer is fill-cut between the first area 251 and the conductive portion 203 - the PCB 250 including a radio frequency (RF) line structure 231 formed in the second area 253 to transmit an RF signal to the conductive portion - impedance matching circuitry 233 disposed on the PCB 250 and connected to the RF line structure 231, and a contact member 240 or 1140 disposed on the PCB 250 to electrically connect the impedance matching circuitry 233 and the conductive portion 203. The RF line structure 231 may include conductive lines including conductive lines disposed in each layer of multiple layers of the PCB 250, and conductive vias to connect each of the conductive lines 330.

For example, each of the conductive lines 330 may have a same shape. Two adjacent conductive lines among the conductive lines 330 may be spaced apart from each other in a direction in which the multiple layers of the PCB 250 are stacked. The conductive vias may include a first conductive via 341 adjacent to the wireless communication circuitry among the wireless communication circuitry 220 and the conductive portion 203 and a second conductive via 342 adjacent to the conductive portion 203 among the wireless communication circuitry 220 and the conductive portion 203. The first conductive via 341 may be disposed vertically across the multiple layers of the PCB 250. The second conductive via 342 may be disposed vertically across the multiple layers of the PCB 250.

For example, each conductive line of the conductive lines of the RF line structure 231 may function as an inductor in a signal path between the wireless communication circuitry and the contact member 240 or 1140. The multiple frequency bands may include a frequency band of about 3 gigahertz (GHz) or above.

For example, the contact member 240 or 1140 may comprise a support portion having a supporting side, an elastic portion connected to the support portion, a connecting portion connected to the elastic portion and disposed so as to be spaced apart from the supporting side, a first bending portion connected to the connecting portion and having a curved shape, and a second bending portion extending from the first bending portion and having a curved shape. The first bending portion may be configured to contact a point of the support portion while pressure is applied to the contact member 240 or 1140. The second bending portion may be configured to contact a point of the connecting portion or the first bending portion while pressure is applied to the contact member 240 or 1140.

For example, the electronic device 101 may comprise a hinge assembly, a first housing part rotatably connected to the hinge assembly, and a second housing part rotatably connected to the hinge assembly. The conductive portion 203 may be included in the first housing part. The PCB 250, the RF line structure 231, the impedance matching circuitry 233, and the contact member 240 or 1140 may be disposed in the first housing part.

For one or more embodiments, at least one of the components described in one or more of the preceding drawings may be configured to perform one or more of the operations, techniques, processes, and/or methods described in the present disclosure. For example, a processor (e.g., a baseband processor) described in the present disclosure with respect to one or more of the preceding drawings may be configured to operate according to one or more of the examples described in the present disclosure. For another example, circuitry associated with a user equipment (UE), a base station, a network element, and the like, as described above with respect to one or more of the preceding drawings, may be configured to operate according to one or more of the examples described herein..

Any of the embodiments described above may be combined with any other embodiment (or combination of embodiments) unless explicitly stated otherwise. The foregoing description of one or more implementations provides examples and descriptions, but is not intended to be exhaustive or to limit the scope of the embodiments to the precise forms disclosed. Modifications and variations are possible in light of the above teachings or may be obtained from practicing various embodiments.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

The disclosure as described above proposes a multi-layer RF line structure within the fill-cut area of the PCB. By distributing conductive lines across at least two PCB layers and interconnecting them through conductive vias, the feeding line operates as multiple inductors in parallel. The design also may also incorporate a contact structure with multiple contact points, ensuring a more stable and efficient electrical connection between the RF line structure and the conductive antenna portion. The technical effect of this configuration is a reduction in overall inductance, since inductors in parallel diminish the composite impedance. This leads to improved impedance matching and reduced adverse effects of longer wiring lengths, thereby enhancing the performance of antennas in advanced electronic devices. The device according to the disclosure provides a more reliable feeding structure that supports modern form factors, such as foldable devices, while maintaining strong wireless communication capability.

Aspects of the invention are listed in the following:
1. An electronic device comprising a conductive portion; wireless communication circuitry; a printed circuit board (PCB) including a ground area for the wireless communication circuitry and a fill-cut area formed between the ground area and the conductive portion; a radio frequency (RF) line structure formed in the fill-cut area of the PCB and electrically connected to the wireless communication circuitry; and a contact member disposed on the PCB to electrically connect the RF line structure and the conductive portion, wherein the RF line structure includes: conductive lines including a conductive line disposed on each layer of at least two of multiple layers of the PCB, a first conductive via coupled to each of the conductive lines, and a second conductive via coupled to each of the conductive lines.
2. The electronic device of aspect 1, wherein the wireless communication circuitry includes a feeding circuit for providing an RF signal, wherein an output port of the feeding circuit is connected to the RF line structure, wherein the ground area includes a metal layer having a copper portion, and wherein the fill-cut area is formed so as not to include a copper portion other than the RF line structure in the PCB between the ground area and the conductive portion. In other words, the fill-cut area is substantially free of copper portions other than the RF line structure.
3. An electronic device comprising a conductive portion used as an antenna radiator for multiple frequency bands; wireless communication circuitry; a printed circuit board, PCB, including a first area having ground for the wireless communication circuitry and a second area in which at least a portion of a metal layer is fill-cut between the first area and the conductive portion, the PCB including a radio frequency, RF, line structure formed in the second area to transmit an RF signal to the conductive portion; impedance matching circuitry disposed on the PCB and connected to the RF line structure; and a contact member disposed on the PCB to electrically connect the impedance matching circuitry and the conductive portion, wherein the RF line structure includes: conductive lines including conductive lines disposed in each layer of multiple layers of the PCB, and conductive vias to connect each of the conductive lines.
4. The electronic device of aspect 3, wherein each of the conductive lines has a same shape, wherein two adjacent conductive lines among the conductive lines are spaced apart from each other by a predefined interval in a direction in which the multiple layers of the PCB are stacked, wherein the conductive vias include a first conductive via adjacent to the wireless communication circuitry among the wireless communication circuitry and the conductive portion and a second conductive via adjacent to the conductive portion among the wireless communication circuitry and the conductive portion, wherein the first conductive via is disposed vertically across the multiple layers of the PCB, and wherein the second conductive via is disposed vertically across the multiple layers of the PCB.
5. The electronic device of aspect 3 or 4, wherein each conductive line of the conductive lines of the RF line structure functions as an inductor in a signal path between the wireless communication circuitry and the contact member, and wherein the multiple frequency bands include a frequency band of about 3 gigahertz, GHz, or above.
6. The electronic device of any one of aspects 3 to 5, wherein the contact member comprises a support portion having a supporting side, an elastic portion connected to the support portion, a connecting portion connected to the elastic portion and disposed so as to be spaced apart from the supporting side, a first bending portion connected to the connecting portion and having a curved shape, and a second bending portion extending from the first bending portion and having a curved shape, wherein the first bending portion is configured to contact a point of the support portion while pressure is applied to the contact member, and wherein the second bending portion is configured to contact a point of the connecting portion or the first bending portion while pressure is applied to the contact member.
7. The electronic device of any one of aspects 3 to 6, further comprising: a hinge assembly, a first housing part rotatably connected to the hinge assembly, and a second housing part rotatably connected to the hinge assembly, wherein the conductive portion is included in the first housing part, and wherein the PCB, the RF line structure, the impedance matching circuitry, and the contact member are disposed in the first housing part.

## Claims

1. An electronic device comprising
a conductive portion forming at least a portion of a side of the electronic device;
wireless communication circuitry;
a printed circuit board (PCB) including a plurality of layers, on which the wireless communication circuitry is disposed;
a radio frequency (RF) line structure disposed in the PCB and electrically connected to the wireless communication circuitry; and
a contact member disposed on the PCB to electrically connect the RF line structure and the conductive portion,
wherein the RF line structure includes:
a first conductive line disposed on a first layer of the plurality of layers of the PCB,
a second conductive line disposed on a second layer of the plurality of layers of the PCB,
a first conductive via penetrating between the first layer and the second layer and coupled to a first portion of the first conductive line and a second portion of the second conductive line, and
a second conductive via penetrating between the first layer and the second layer and coupled to a third portion of the first conductive line and a fourth portion of the second conductive line.

2. The electronic device of claim 1,
wherein the first portion of the first conductive line comprises a first end portion adjacent to the wireless communication circuitry among the wireless communication circuitry and the conductive portion,
wherein the second portion of the second conductive line comprises a first end portion adjacent to the wireless communication circuitry among the wireless communication circuitry and the conductive portion,
wherein the third portion of the first conductive line comprises a third end portion adjacent to the conductive portion among the wireless communication circuitry and the conductive portion, and
wherein the fourth portion of the second conductive line comprises a third end portion adjacent to the conductive portion among the wireless communication circuitry and the conductive portion.

3. The electronic device of claim 1,
wherein the first conductive line and the second conductive line are used as a signal path between the wireless communication circuitry and the contact member, and
wherein an RF signal from the wireless communication circuitry is fed to the conductive portion through the first conductive line, the second conductive line are, and the contact member.

4. The electronic device of claim 1,
wherein the wireless communication circuitry includes a feeding circuit for providing an RF signal,
wherein an output port of the feeding circuit is connected to the RF line structure,
wherein the plurality of layers of the PCB include at least one insulating layer and a plurality of metal layers, and
wherein the wireless communication circuit is disposed in a ground area of the PCB where at least a portion of the plurality of metal layers overlaps the at least one insulating layer, and
wherein the RF line structure is disposed in an area of the PCB where only the RF line structure among the plurality of metal layers overlaps with the at least one insulating layer between the ground area and the conductive portion.

5. The electronic device of claim 1, further comprising:
impedance matching circuitry electrically connected to the RF line structure, and
a second RF line structure electrically connected to the impedance matching circuitry,
wherein the impedance matching circuitry is electrically connected to the contact member through the second RF line structure.

6. The electronic device of claim 5,
wherein the wireless communication circuitry is disposed on a first side of the PCB,
wherein the contact member is disposed on a second side of the PCB opposite the first side,
wherein the impedance matching circuitry is disposed on the second side, and
wherein the second RF line structure includes a third conductive line disposed on the second side.

7. The electronic device of claim 5,
wherein the wireless communication circuitry is disposed on a first side of the PCB,
wherein the contact member is disposed on a second side of the PCB opposite the first side,
wherein the impedance matching circuitry is disposed on the first side, and
wherein the second RF line structure comprises:
a third conductive line disposed on the first layer of the plurality of layers of the PCB,
a fourth conductive line disposed on the second layer of the plurality of layers of the PCB,
a third conductive via penetrating between the first layer and the second layer and coupled to a fifth portion of the first conductive line and a sixth portion of the second conductive line, and
a fourth conductive via penetrating between the first layer and the second layer and coupled to a seventh portion of the first conductive line and an eighth portion of the second conductive line.

8. The electronic device of claim 1, further comprising:
an 'L'-shaped conductive pad coupled to the conductive portion,
wherein the wireless communication circuitry is disposed on a first side of the PCB,
wherein the contact member is disposed on a second side of the PCB opposite the first side, and
wherein the conductive pad comprises a first side coupled to a protruding portion of the conductive portion and a second side contacting the contact member.

9. The electronic device of claim 1,
wherein the conductive portion is used as an antenna radiator for transmitting signals in multiple frequency bands,
wherein the multiple frequency bands include a frequency band of about 3 gigahertz (GHz) or above, and
wherein each conductive line among the conductive lines has a width of about 0.135 millimeter (mm) or more and less than about 0.165mm, and a thickness of about 0.018mm or more and less than about 0.022mm.

10. The electronic device of claim 1,
wherein the contact member comprises a support portion having a supporting side, an elastic portion connected to the support portion, a connecting portion connected to the elastic portion and disposed so as to be spaced apart from the supporting side, a first bending portion connected to the connecting portion and having a curved shape, and a second bending portion extending from the first bending portion and having a curved shape,
wherein the first bending portion is configured to contact a point of the support portion while pressure is applied to the contact member, and
wherein the second bending portion is configured to contact a point of the connecting portion or the first bending portion while pressure is applied to the contact member.

11. The electronic device of claim 10,
wherein the supporting side of the support portion is disposed on one side of the PCB, and
wherein the first bending portion is disposed so as to contact the conductive portion or a component coupled to the conductive portion.

12. The electronic device of claim 11,
wherein the contact member further comprises a second elastic portion connected to the support portion and a third bending portion connected to the second elastic portion and having a curved shape, and
wherein the third bending portion is configured to contact the first bending portion while pressure is applied to the contact member.

13. The electronic device of claim 1, further comprising:
a radiator,
a flexible printed circuit board (FPCB) connected to the radiator, the FPCB comprising a line portion including a strip line and a feeding portion including a conductive pattern, and
a conductive structure disposed on the conductive pattern in the feeding portion.

14. The electronic device of claim 1, further comprising:
first conductive plates disposed in a first set of layers among the plurality of layers of the PCB,
second conductive plates disposed in a second set of layers among the plurality of layers of the PCB,
a fifth vertical via for electrically connecting the first conductive plates, and
a sixth vertical via for electrically connecting the second conductive plates,
wherein the first set of layers and the second set of layers are arranged alternately,
wherein the first conductive plates are connected to the contact member, and
wherein the second conductive plates are connected to the RF line structure.

15. The electronic device of claim 14,
wherein the contact member is disposed on one side of one of the first conductive plates, and
wherein the RF line structure is electrically connected to a feeding point formed on one of the second conductive plates.
